(19) Europäisches Patentamt
European Patent Office
Office européen des brevets

(11) EP 1 748 317 B1

(12) **EUROPEAN PATENT SPECIFICATION**

(45) Date of publication and mention of the grant of the patent:
**16.09.2009 Bulletin 2009/38**

(51) Int Cl.:
***G03F 7/031*** *(2006.01)* ***G03F 7/033*** *(2006.01)*
***G03F 7/035*** *(2006.01)* ***G03F 7/30*** *(2006.01)*

(21) Application number: **06015456.4**

(22) Date of filing: **25.07.2006**

(54) **Method for preparation of lithographic printing plate and lithographic printing plate precursor**

Verfahren zur Herstellung einer Lithografiedruckplatte und Lithografiedruckplattenvorläufer

Procédé de préparation d'une plaque d'impression lithographique et précurseur de plaque d'impression lithographique

(84) Designated Contracting States:
**AT BE BG CH CY CZ DE DK EE ES FI FR GB GR HU IE IS IT LI LT LU LV MC NL PL PT RO SE SI SK TR**

(30) Priority: **25.07.2005 JP 2005214539**
**27.04.2006 JP 2006123823**

(43) Date of publication of application:
**31.01.2007 Bulletin 2007/05**

(60) Divisional application:
**09163998.9**

(73) Proprietor: **FUJIFILM Corporation**
**Minato-ku**
**Tokyo (JP)**

(72) Inventor: **Inno, Toshifumi**
**Yoshida-cho**
**Haibara-gun**
**Shizuoka (JP)**

(74) Representative: **HOFFMANN EITLE**
**Patent- und Rechtsanwälte**
**Arabellastrasse 4**
**81925 München (DE)**

(56) References cited:
**EP-A- 1 705 522**
**EP-A2- 1 356 929**
**EP-A2- 1 630 618**
**JP-A- 8 240 916**
**JP-A- 2003 315 986**
**US-A1- 2003 129 523**
**US-A1- 2004 131 974**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 748 317 B1

## Description

FIELD OF THE INVENTION

The present invention relates to a method for preparation of a lithographic printing plate and a lithographic printing plate precursor for use in the method.

BACKGROUND OF THE INVENTION

In general, a lithographic printing plate has a surface composed of an oleophilic image area and a hydrophilic non-image area. Lithographic printing is a printing method comprising supplying alternately dampening water and oily ink on the surface of lithographic printing plate, making the hydrophilic non-image area a dampening water-receptive area (ink unreceptive area) and depositing the oily ink only to the oleophilic image area by utilizing the nature of the dampening water and oily ink to repel with each other, and then transferring the ink to a printing material, for example, paper.

In order to produce the lithographic printing plate, a lithographic printing plate precursor (PS plate) comprising a hydrophilic support having provided thereon an oleophilic photosensitive layer (image-recording layer) has heretofore been broadly used. Ordinarily, a lithographic printing plate is obtained by conducting plate making by a method of exposing the lithographic printing plate precursor through an original, for example, a lith film, and then treating the exposed lithographic printing plate precursor to remove the image-recording layer in the unnecessary non-image area by dissolving with a an alkaline developer or an organic solvent thereby revealing a surface of the hydrophilic support to form the non-image area while leaving the image-recording layer in the image area.

In the hitherto known plate-making process of lithographic printing plate precursor, after the exposure, the step of removing the unnecessary image-recording layer by dissolving, for example, with a developer is required. However, it is one of the subjects to simplify such an additional wet treatment described above. As one means for the simplification, it has been desired to conduct the development with a nearly neutral aqueous solution or simply with water.

On the other hand, digitalized technique of electronically processing, accumulating and outputting image information using a computer has been popularized in recent years, and various new image outputting systems responding to the digitalized technique have been put into practical use. Correspondingly, attention has been drawn to a computer-to-plate technique of carrying the digitalized image information on highly converging radiation, for example, laser light and conducting scanning exposure of a lithographic printing plate precursor with the light thereby directly preparing a lithographic printing plate without using a lith film. Thus, it is one of the important technical subjects to obtain a lithographic printing plate precursor adaptable to the technique described above.

Based on the background described above, adaptation of plate making operation to both simplification and digitalization has been demanded strongly more and more than ever before.

In response to such a demand, for instance, it is described in JP-A 2002-365789 (the term "JP-A" as used herein means an "unexamined published Japanese patent application") that by incorporating a compound having an ethylene oxide chain into an image-forming layer of a lithographic printing plate precursor comprising a hydrophilic support and the image-forming layer containing a hydrophobic precursor, a hydrophilic resin and a light to heat converting agent, the lithographic printing plate precursor enables printing after conducting exposure and wet development processing using as a developer, water or an appropriate aqueous solution, besides on-machine development.

Also, a processing method of lithographic printing plate precursor is described in U.S. Patent Publication No. 2004/0013968 which comprises preparing a lithographic printing plate precursor comprising (i) a hydrophilic support and (ii) an oleophilic heat-sensitive layer which contains a radical-polymerizable ethylenically unsaturated monomer, a radical polymerization initiator and an infrared absorbing dye, is hardened with infrared laser exposure and is developable with an aqueous developer containing water of 60% by weight or more and having pH of 2.0 to 10.0, exposing imagewise with an infrared laser, and removing the unhardened region of the heat-sensitive layer with the aqueous developer.

EP-A-1 630 618, which is prior art by virtue of Article 54(3) EPC, discloses a method for producing a lithographic printing plate comprising imagewise exposing a lithographic printing plate precursor comprising a support, an image-recording layer on the support and a protective layer on the image-recording layer, and rubbing the surface of the exposed plate in an automatic processor in the presence of a developer having a pH of 2-10. The image-recording layer may contain a chain-transfer agent, examples of which include a compound represented by the following formula:

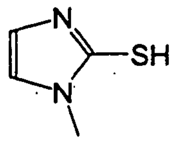

SUMMARY OF THE INVENTION

In order to maintain developing property to the aqueous developer having pH of 2.0 to 10.0, however, it is necessary for the photosensitive layer to be hydrophilic or highly water-permeable and thus, but the photosensitive layer hardened with exposure is deficient in water-resistance and film strength. In order to solve the problem, a technique, which increases discrimination of the water resistance between the unexposed area and the exposed area in a reaction system of high sensitivity, that is, high hardening efficiency and does not form fog by handling under a safelight, has been required. The invention responds to the problem. Specifically, an object of the invention is to provide a plate-making method where a lithographic printing plate precursor which has high sensitivity and is excellent in safelight aptitude is developed with an aqueous developer having pH of 2.0 to 10.0, and a lithographic printing plate precursor for use in the method.

The inventor has found that the above-described object can be achieved by using a laser of 350 to 450 nm for image exposure and using a hexaarylbiimidazole compound in a photosensitive layer as an initiator which is highly sensitive and do not have absorption in a visible range. Specifically, the present invention includes the following items.

1. A method for preparation of a lithographic printing plate comprising exposing a lithographic printing plate precursor comprising a hydrophilic support, a photosensitive layer containing (A) a sensitizing dye having an absorption maximum in a wavelength range of 350 to 450 nm, (B) a hexaarylbiimidazole compound, (C) a polymerizable compound, (D) a hydrophobic binder polymer and (E) a chain transfer agent and a protective layer in this order with a laser beam of 350 to 450 nm, and rubbing a surface of the exposed lithographic printing plate precursor with a rubbing member in the presence of a developer having pH of 2 to 10 in an automatic processor equipped with the rubbing member to remove the protective layer and an unexposed area of the photosensitive layer,
wherein the chain transfer agent (E) is a thiol compound represented by the following formula (I):

(I) 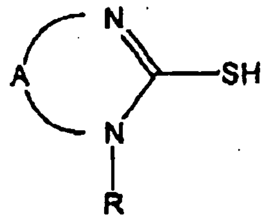

wherein R represents an alkyl group which may have a substituent or an aryl group which may have a substituent; and A represents an atomic group necessary for forming a 5-membered or 6-membered hetero ring containing a carbon atom together with the N=C-N linkage, and A may have a substituent, with the proviso that when A is -HC=CH-, R is not a methyl group.
2. A method as described in 1, wherein the hydrophobic binder polymer (D) is at least one of a (meth)acrylic copolymer having a cross-linkable group in a side-chain and a polyurethane resin having a cross-linkable group in a side-chain.
3. The method for preparation of a lithographic printing plate as described in 1. above, wherein a part or all of components of the photosensitive layer is encapsulated in microcapsule.
4. The method for preparation of a lithographic printing plate as described in 1. above, wherein the rubbing member comprises at least two rotating brush rollers.
5. The method for preparation of a lithographic printing plate as described in 1. above, wherein the pH of the developer is from 3 to 8.
6. The method for preparation of a lithographic printing plate as described in 1. above, wherein the exposed lithographic printing plate precursor is subjected to a heat treatment between the exposure and the development.
7. A lithographic printing plate precursor as described in 1, wherein the hydrophobic binder polymer (D) has an acid value of 0.3 meq/g or less, and the protective layer and the unexposed area of the photosensitive layer are capable of being removed by exposing the lithographic printing plate precursor with a laser beam of 350 to 450 nm and

rubbing the surface of the exposed lithographic printing plate precursor with a rubbing member in the presence of a developer having pH of 2 to 10 in an automatic processor equipped with the rubbing member.

8. A method as described in any one of 1. to 6., wherein the chain transfer agent (E) is selected from any compound shown on pages 48 to 52.

According to the present invention, a plate-making method where a lithographic printing plate precursor which has high sensitivity and is excellent in safelight aptitude is developed with an aqueous developer having pH of 2.0 to 10.0, and a lithographic printing plate precursor for use in the method can be provided.

BRIEF DESCRIPTION OF THE DRAWINGS

Fig. 1 shows a structure of an automatic development processor.

Description of reference numerals and signs:

1: Rotating brush roller
2: Backing roller
3: Transport roller
4: Transport guide plate
5: Spray pipe
6: Pipe line
7: Filter
8: Plate supply table
9: Plate discharge table
10: Developer tank
11: Circulating pump
12: Plate

DETAILED DESCRIPTION OF THE INVENTION

[Lithographic printing plate precursor]

First, the lithographic printing plate precursor for use in the invention is described in detail below.

<Photosensitive layer>

The photosensitive layer of the lithographic printing plate precursor according to the invention contains (A) a sensitizing dye having an absorption maximum in a wavelength range of 350 to 450 nm, (B) a hexaarylbiimidazole compound, (C) a polymerizable compound, (D) a hydrophobic binder polymer and (E) a chain transfer agent represented by formula (I). The photosensitive layer according to the invention may contain other components, if desired. The constituting components of the photosensitive layer are described in more detail below.

(A) Sensitizing dye

The photosensitive layer according to the invention can contain a sensitizing dye responding to a wavelength of an exposure light source.

Sensitizing dyes having an absorption maximum in a wavelength range of 300 to 450 nm are described at the beginning. Examples of the sensitizing dye include merocyanine dyes represented by formula (V) shown below, benzopyranes represented by formula (VI) shown below, coumarins, aromatic ketones represented by formula (VII) shown below, and anthracenes represented by formula (VIII) shown below.

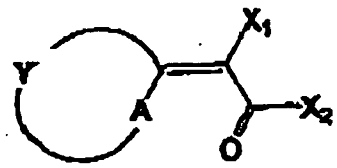

(V)

In formula (V), A represents a sulfur atom or $NR_6$, $R_6$ represents a monovalent non-metallic atomic group, Y represents a non-metallic atomic group necessary for forming a basic nucleus of the dye together with adjacent A and the adjacent carbon atom, and $X_1$ and $X_2$ each independently represents a monovalent non-metallic atomic group or $X_1$ and $X_2$ may be combined with each other to form an acidic nucleus of the dye.

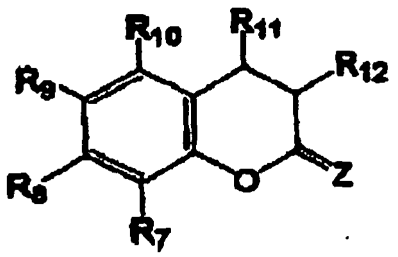

(VI)

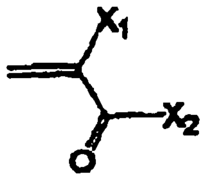

(I')

In formula (VI), =Z represents a carbonyl group, a thiocarbonyl group, an imino group or an alkylydene group represented by the partial structural formula (I') described above, $X_1$ and $X_2$ have the same meanings as defined in formula (V), and $R_7$ to $R_{12}$ each independently represents a monovalent non-metallic atomic group.

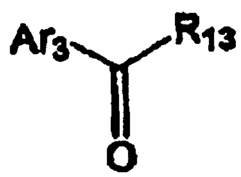

(VII)

In formula (VII), $Ar_3$ represents an aromatic group which may have a substituent or a heteroaromatic group which may have a substituent, and $R_{13}$ represents a monovalent non-metallic atomic group. $R_{13}$ more preferably represents an aromatic group or a heteroaromatic group. $Ar_3$ and $R_{13}$ may be combined with each other to form a ring.

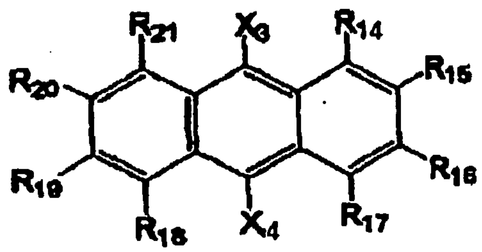

(VIII)

In formula (VIII), $X_3$, $X_4$ and $R_{14}$ to $R_{21}$ each independently represents a monovalent non-metallic atomic group. More preferably, $X_3$ and $X_4$ each independently represents an electron-donating group having a negative Hammett substituent constant.

In formulae (V) to (VIII), preferred examples of the monovalent non-metallic atomic group represented by $X_1$ to $X_4$ and $R_6$ to $R_{21}$ include a hydrogen atom, an alkyl group (for example, a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl

group, an isohexyl group, a 2-ethylhexyl group, a 2-methylhexyl group, a cyclohexyl group, a cyclopentyl group, a 2-norbornyl group, a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an $\alpha$-methylbenzyl group, a 1-methyl-l-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group or a 3-butynyl group), an aryl group (for example, a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxyphenylearbonyl group, a phenoxycarbonylphenyl group, an N-phenylcarbamoylphenyl group, a phenyl group, a cyanophenyl group, a sulfophenyl group, a sulfonatophenyl group, a phosphonophenyl group or a phosphonatophenyl group), a heteroaryl group (for example, thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indoyl, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane or phenoxazine), an alkenyl group (for example, a vinyl group, a 1-propenyl group, a 1-butenyl group, a cinnamyl group or a 2-chloro-1-ethenyl group), an alkynyl group (for example, an ethynyl group, a 1-propynyl group, a 1-butynyl group or a trimethylsilylethynyl group), a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-diaikylamino group, an N-arylamino group, an N,N-diarylamino group, an N-alkyl-N-arylamino group, an acyloxy group, a carbamoyloxy group, an N-alkcylcarbamoyloxy group, an N-arylcarbamoyloxy group, an N,N-dialkylcarbamoyloxy group, an N,N-diarylcarbamoyloxy group, an N-alkyl-N-arylcarbamoyioxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arytureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxy group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group ($-SO_3H$) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group ($-PO_3H_2$) and its conjugated base group (hereinafter referred to as a "phosphonato group"), a dialkylphosphono group ($-PO_3(alkyl)_2$), a diarylphosphono group ($-PO_3(aryl)_2$), an alkylarylphosphono group ($-PO_3(alkyl)(aryl)$), a monoalkylphosphono group ($-PO_3H(alkyl)$) and its conjugated base group (hereinafter referred to as an "alkylphosphonato group"), a monoarylphosphono group ($-PO_3H(aryl)$) and its conjugated base group (hereinafter referred to as an "arylphosphonato group"), a phosphonooxy group ($-OPO_3H_2$) and its conjugated base group (hereinafter referred to as a "phosphonatooxy group"), a dialkylphosphonooxy group ($-OPO_3(alkyl)_2$), a diarylphosphonooxy group ($-OPO_3(aryl)_2$), an alkylarylphosphonooxy group ($-OPO_3(alkyl)(aryl)$), a monoalkylphosphonooxy group ($-OPO_3H(alkyl)$) and its conjugated base group (hereinafter referred to as an "alkylphosphonatooxy group"), a monoarylphosphonooxy group ($-OPO_3H(aryl)$) and its conjugated base group (hereinafter referred to as an "arylphosphonatooxy group"), a cyano group,

and a nitro group. Of the substituents, a hydroxy group, an alkyl group, an aryl group, a halogen atom, an alkoxy group and an acyl group are particularly preferred.

The basic nucleus of the dye formed by Y together with the adjacent A and the adjacent carbon atom in formula (V) includes, for example, a 5-membered, 6-membered or 7-membered, nitrogen-containing or sulfur-containing heterocyclic ring, and is preferably a 5-membered or 6-membered heterocyclic ring.

As the nitrogen-containing heterocyclic ring, those which are known to constitute basic nuclei in merocyanine dyes described in L.G. Brooker et al, J. Am. Chem. Soc., Vol. 73, pp. 5326 to 5358 (1951) and references cited therein can be preferably used. Specific examples thereof include thiazoles (for example, thiazole, 4-methylthiazole, 4-phenylthiazole, 5-methylthiazole, 5-phenylthiazole, 4,5-dimethylthiazole, 4,5-diphenylthiazole, 4,5-di(p-methoxyphenylthiazole) or 4-(2-thienyl)thiazole); benzothiazoles (for example, benzothiazole, 4-chlorobenzothiazole, 5-chlorobenzothiazole, 6-chlorobenzothiazole, 7-chlorobenzothiazole, 4-methylbenzothiazole, 5-methylbenzothiazole, 6-methylbenzothiazole, 5-bromobenzothiazole, 4-phenylbenzothiazole, 5-phenylbenzothiazole, 4-methoxybenzothiazole, 5-methoxybenzothiazale, 6-methoxybenzothiazole, 5-iodobenzothiazole, 6-iodobenzothiazole, 4-ethoxybenzothiazole, 5-ethoxybenzothiazole, tetrahydrobenzothiazole, 5,6-dirnethoxybenzothiazole, 5,6-dioxymethylenebenzothiazole, 5-hydroxybenzothiazole, 6-hydroxybenzothiazole, 6-dimethylaminabenzothiazole or 5-ethoxycarbonylbenzothiazole), naphthothiazoles (for example, naphtho[1,2]thiazole, naphtho[2,1]thiazole, 5-methoxynaphtho[2,1]thiazale, 5-ethoxynaphtho[2,1]thiazole, 8-methoxynaphtho[1,2]thiazole or 7-methoxynaphtho[1,2]thiazole); thianaphtheno-7',6',4,5-thiazoles (for example, 4'-methoxythianaphtheno-7',6',4,5-thiazole); oxazoles (for example, 4-methyloxazole, 5-methyloxazole, 4-phenyloxazole, 4,5-diphenyloxazole, 4-ethyloxazole, 4,5-dimethylaxazole or 5-phenyloxazale); benzoxazoles (for example, benzoxazole, 5-chlorobenzoxazole, 5-methylbenzoxazole, 5-phenylbenzoxazole, 6-methylbenzoxazole, 5,6-dimethylbenzoxazole, 4,6-dimethylbenzoxazole, 6-methoxybenzoxazole, 5-methoxybenzoxazole, 4-ethoxybenzoxazale, 5-chlorobenzoxazole, 6-methoxybenzoxazole, 5-hydroxybenzoxazole or 6-hydroxybenzoxazole); naphthoxazoles (for example, naphth[1,2]oxazole or naphth[2,1]oxazole); selenazoles (for example, 4-methylselenazole or 4-phenylselenazole); benzoselenazoles (for example, benzoselenazole, 5-chlorobenzoselenazole, 5-methoxybenzoselenazole, 5-hydroxybenzoselenazole or tetrahydrobenzoselenazole); naphthoselenazoles (for example, naphtho[1,2]selenazole or naphtho[2,1]selenazole); thiazolines (for example, thiazoline or 4-methylthiazoline); 2-quinolines (for example, quinoline, 3-methylquinoline, 5-methylquinoline, 7-methylquinoline, 8-methylquinoline, 6-chloroquinoline, 8-chloroquinoline, 6-methoxyquinoline, 6-ethoxyquinoline, 6-hydroxyquinoline or 8-hydroxyquinoline); 4-quinolines (for example, quinoline, 6-methoxyquinoline, 7-methylquinoline or 8-methylquinoline); 1-isoquinolines (for example, isoquinoline or 3,4-dihydroisoquinoline); 3-isoquinolines (for example, isoquinoline); benzimidazoles (for example, 1,3-diethylbenzimidazole or 1-ethyl-3-phenylbenzimidazole); 3,3-dialkylindolenines (for example, 3,3-dimethylindolenine, 3,3,5-trimethylindolenine or 3,3,7-trimethylindolcnine); 2-pyridines (for example, pyridine or 5-methylpyridine); and 4-pyridines (for example, pyridine).

Examples of the sulfur-containing heterocyclic ring include dithiol partial structures in dyes described in JP-A-3-296759.

Specific examples thereof include benzodithiols (for example, benzodithiol, 5-tert-butylbenzodithiol or 5-methylbenzodithiol); naphthodithiols (for example, naphtho[1,2]dithiol or naphtho[2,1]dithiol); and dithiols (for example, 4,5-dimethyldithiol, 4-phenyldithiol, 4-methoxycarbonyldithiol, 4,5-dimethoxycarbonyldithiol, 4,5-ditrifluoromethyldithiol, 4,5-dicyanodithiol, 4-methoxycarbonylmethyldithiol or 4-carboxymethyldithiol).

In the description with respect to the heterocyclic ring above, for convenience and by convention, the names of heterocyclic mother skeletons are used. In the case of constituting the basic nucleus partial structure in the sensitizing dye, the heterocyclic ring is introduced in the form of a substituent of alkylyaene type where a degree of unsaturation is decreased one step. For example, a benzothiazole skeleton is introduced as a 3-substituted-2(3H)-benzothiazolilydene group.

Of the sensitizing dyes having an absorption maximum in a wavelength range of 360 to 450 nm, dyes represented by formula (IX) shown below are more preferred in view of high sensitivity.

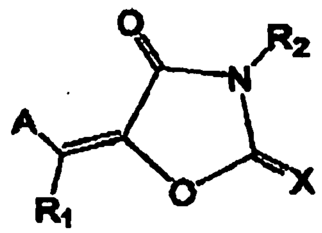

(IX)

In formula (IX), A represents an aromatic ring which may have a substituent or a hetero ring which may have a substituent, X represents an oxygen atom, a sulfur atom or N-($R_3$), and $R_1$, $R_2$ and $R_3$ each independently represents a hydrogen atom or a monovalent non-metallic atomic group, or A and $R_1$ or $R_2$ and $R_3$ may be combined with each

other to form an aliphatic or aromatic ring.

The formula (IX) will be described in more detail below. $R_1$, $R_2$ and $R_3$ each independently represents a hydrogen atom or a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic group, a substituted or unsubstituted alkoxy group, a substituted or unsubstituted alkylthio group, a hydroxy group or a halogen atom.

Preferred examples of $R_1$, $R_2$ and $R_3$ will be specifically described below. Preferred examples of the alkyl group include a straight chain, branched or cyclic alkyl group having from 1 to 20 carbon atoms. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbornyl group. Among them, a straight chain alkyl group having from 1 to 12 carbon atoms, a branched alkyl group having from 3 to 12 carbon atoms and a cyclic alkyl group having from 5 to 10 carbon atoms are more preferable.

As the substituent for the substituted alkyl group, a monovalent non-metallic atomic group exclusive of a hydrogen atom is used. Preferred examples thereof include a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N, N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group ($-SO_3H$) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group ($-PO_3H_2$) and its conjugated base group (hereinafter referred to as a "phosphonato group"), a dialkylphosphono group ($-PO_3(alkyl)_2$), a diarylphosphono group ($-PO_3(aryl)_2$), an alkylarylphosphono group ($-PO_3(alkyl)(aryl)$), a monoalkylphosphono group ($-PO_3H(alkyl)$) and its conjugated base group (hereinafter referred to as an "alkylphosphonato group"), a monoarylphosphono group ($-PO_3H(aryl)$) and its conjugated base group (hereinafter referred to as an "arylphosphonato group"), a phosphonooxy group ($-OPO_3H_2$) and its conjugated base group (hereinafter referred to as a "phosphonatooxy group"), a dialkylphosphonooxy group ($-OPO_3(alkyl)_2$), a diarylphosphonooxy group ($-OPO_3(aryl)_2$), an alkylarylphosphonooxy group ($-OPO_3(alkyl)(aryl)$), a monoalkylphosphonooxy group ($-OPO_3H(alkyl)$) and its conjugated base group (hereinafter referred to as an "alkylphosphonatooxy group"), a monoarylphosphonooxy group ($-OPO_3H(aryl)$) and its conjugated base group (hereinafter referred to as an "arylphosphonatooxy group"), a cyano group, a nitro group, an aryl group, a heteroaryl group, an alkenyl group and an alkynyl group.

In the substituents, specific examples of the alkyl group include those described for the alkyl group above. Specific examples of the aryl group include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxyphenylcarbonyl group, a phenoxycarbonylpheny, group, an N-phenylcarbamoylphenyl group, a phenyl group, a cyanophenyl group, a sulfophenyl group, a sulfonatophenyl group, a phosphonophenyl group and a phosphonatophenyl group.

Preferred examples of the aromatic heterocyclic group represented by any one of $R_1$, $R_2$ and $R_3$ include a monocyclic or polycyclic aromatic ring containing at least one of a nitrogen atom, an oxygen atom and a sulfur atom, Examples of especially preferred aromatic heterocyclic group include thiophene, thiathrene, furan, pyran, isobenzofuran, chromene, xanthene, phenoxazine, pyrrole, pyrazole, isothiazole, isoxazole, pyrazine, pyrimidine, pyridazine, indolizine,

isoindolizine, indoyl, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane and phenoxazine. These groups may be benzo-fused or may have a substituent.

Also, preferred examples of the alkenyl group represented by any one of $R_1$, $R_2$ and $R_3$ include a vinyl group, a 1-propenyl group, a 1-butenyl group, a cinnamyl group and a 2-chloro-1-ethenyl group. Examples of the alkynyl group include an ethynyl group, a 1-propynyl group, a 1-butynyl group and a trimethylsilylethynyl group. Examples of $G_1$ in the acyl group ($G_1$CO-) include a hydrogen atom and the above-described alkyl group and aryl group. Of the substituents, a halogen atom (for example, -F, -Br, -Cl or -I), an alkoxy group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N,N-dialkylsulfamoyl group, an N-arylsulfamoyl group, an N-alkyl-N-arylsulfamoyl group, a phosphono group, a phosphonato group, a dialkylphosphono group, a diarylphosphono group, a monoalkylphosphono group, an alkylphosphonato group, a monoarylphosphono group, an arylphosphonato group, a phosphonooxy group, a phosphonatooxy group, an aryl group and an alkenyl group are more preferable.

On the other hand, as an alkylene group in the substituted alkyl group, a divalent organic residue resulting from elimination of any one of hydrogen atoms on the above-described alkyl group having from 1 to 20 carbon atoms can be enumerated. Examples of preferred alkylene group include a straight chain alkylene group having from 1 to 12 carbon atoms, a branched alkylene group having from 3 to 12 carbon atoms and a cyclic alkylene group having from 5 to 10 carbon atoms.

Specific examples of the preferred substituted alkyl group represented by any one of $R_1$, $R_2$ and $R_3$, which is obtained by combining the above-described substituent with an alkylene group, include a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an $\alpha$-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group and a 3-butynyl group.

Preferred examples of the aryl group represented by any one of $R_1$, $R_2$ and $R_3$ include a fused ring formed from one to three benzene rings and a fused ring formed from a benzene ring and a 5-membered unsaturated ring. Specific examples thereof include a phenyl group, a naphthyl group, an anthryl group, a phenanthryl group, an indenyl group, an acenaphthenyl group and a fluorenyl group. Among them, a phenyl group and a naphthyl group are more preferable.

Specific examples of the preferred substituted aryl group represented by any one of $R_1$, $R_2$ and $R_3$ include aryl groups having a monovalent non-metallic atomic group exclusive of a hydrogen atom as a substituent on the ring-forming carbon atom of the above-described aryl group. Preferred examples of the substituent include the above-described alkyl groups and substituted alkyl groups, and the substituents described for the above-described substituted alkyl group. Specific examples of the preferred substituted aryl group include a biphenyl group, a tolyl group, a xylyl group, a mesityl group, a cumenyl group, a chlorophenyl group, a bromophenyl group, a fluorophenyl group, a chloroznethylphanyl group, a trifluoromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyloxyphenyl group, an acetyiarninophenyl group, an N-methylbenzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N, N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allylphenyl group, a 1-propenylmethylphenyl group, a 2-butenytphenyt group, a 2-methylallylphanyl group, a 2-methylpropenylphenyl group, a 2-propenylphenyl group, a 2-butynylphenyl group and a 3-butynylphenyl group.

Next, A in formula (IX) will be described below. A represents an aromatic ring which may have a substituent or hetero ring which may have a substituent. Specific examples of the aromatic ring which may have a substituent or hetero ring which may have a substituent include those described for any one of $R_1$, $R_2$ and $R_3$ in formula (IX).

The sensitizing dye represented by formula (IX) according to the invention is obtained by a condensation reaction of the above-described acidic nucleus or an active methyl group-containing acidic nucleus with a substituted or unsubstituted, aromatic ring or hetero ring and can be synthesized with reference to JP-B-59-28329.

Preferable specific examples (D1) to (D75) of the compound represented by formula (IX) are set forth below. Also, when isomers with respect to a double bond connecting an acidic nucleus and a basic nucleus are present, the invention should not be construed as being limited only to any one of the isomers.

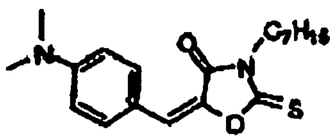

(D1)

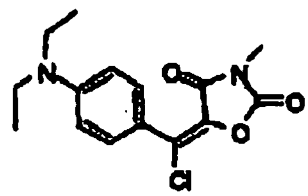

(D2)

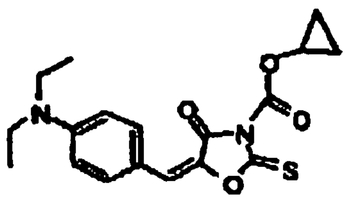

(D3)

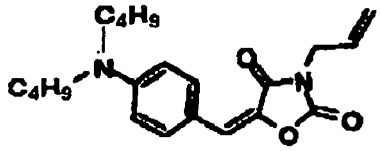

(D4)

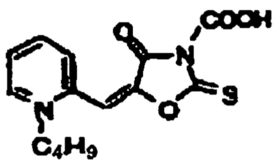

(D5)

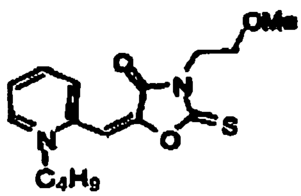

(D6)

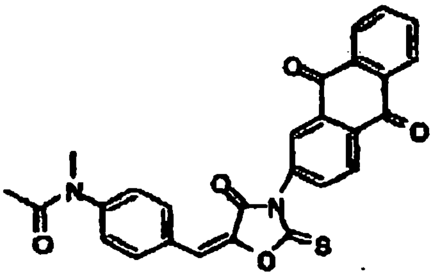
(D7)

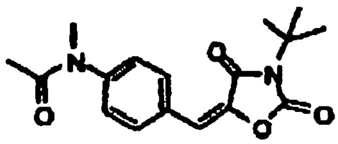
(D8)

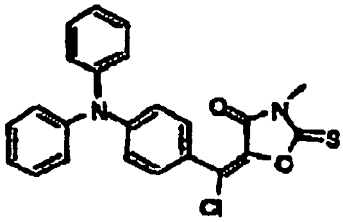
(D9)

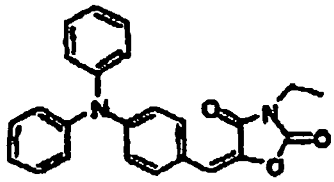
(D10)

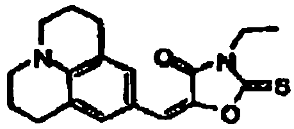
(D11)

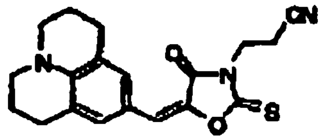
(D12)

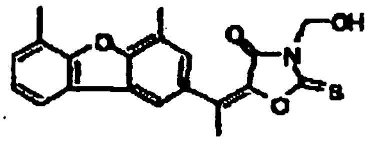
(D13)

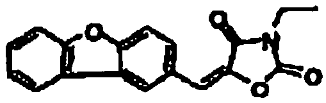
(D14)

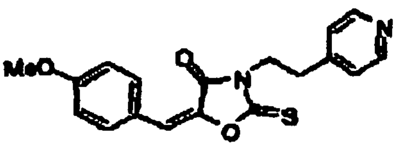
(D15)

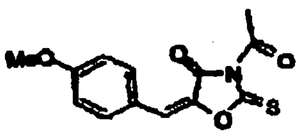
(D16)

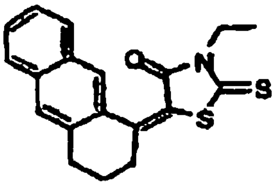

(D17)

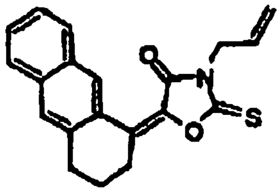

(D18)

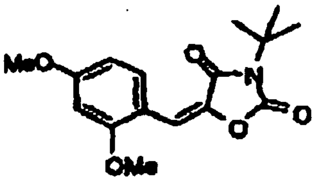

(D19)

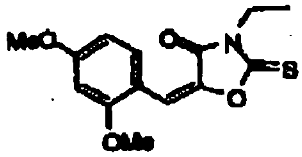

(D20)

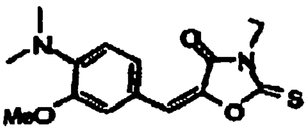

(D21)

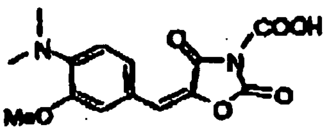

(D22)

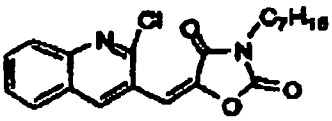

(D23)

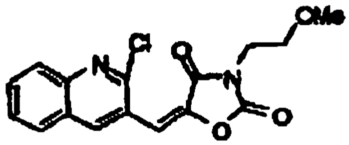

(D24)

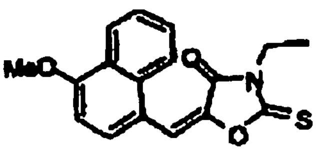

(D25)

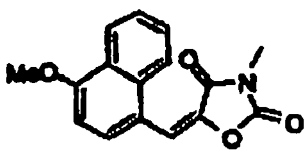

(D26)

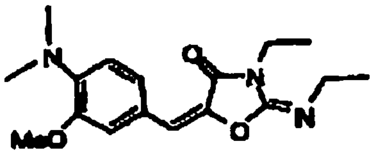

(D27)

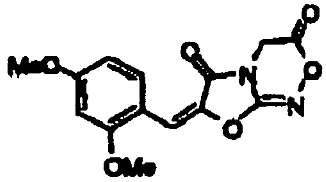

(D28)

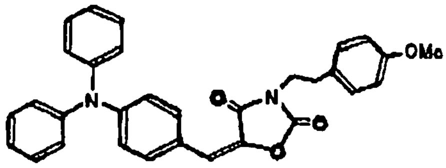

(D29)

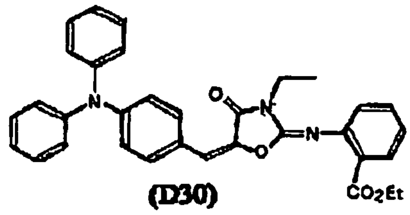

(D30)

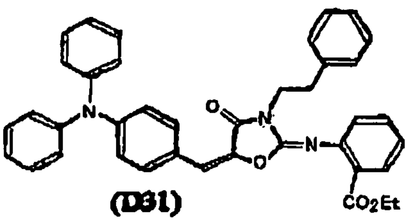

(D31)

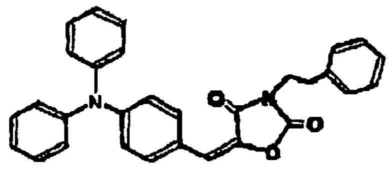

(D32)

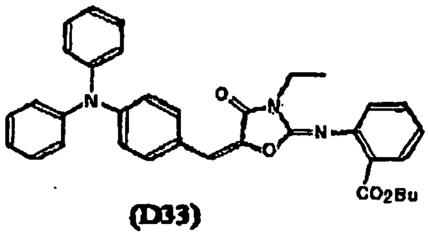

(D33)

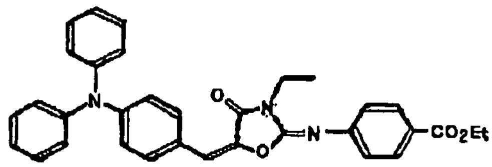

(D34)

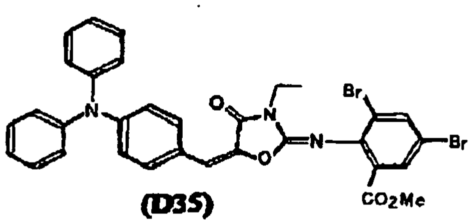

(D35)

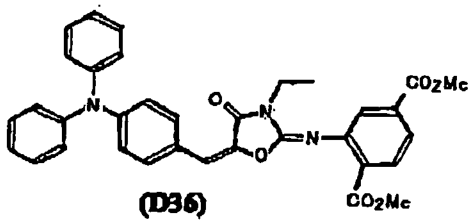

(D36)

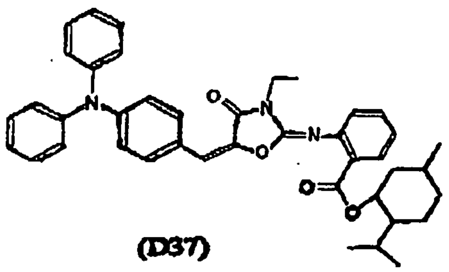

(D37)

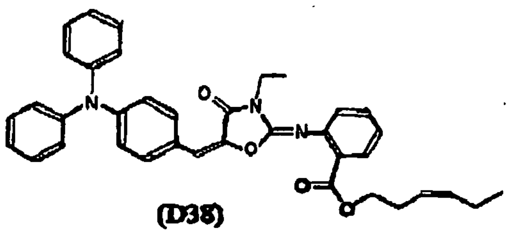

(D38)

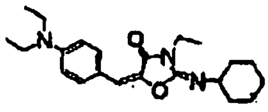
(D39)

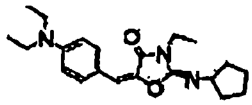
(D40)

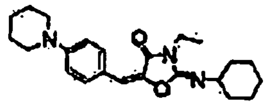
(D41)

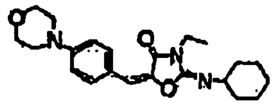
(D42)

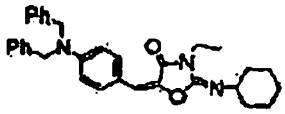
(D43)

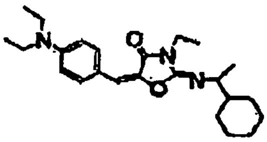
(D44)

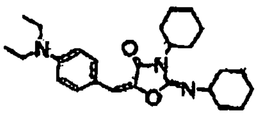
(D45)

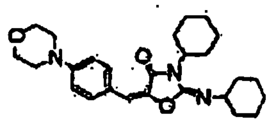
(D46)

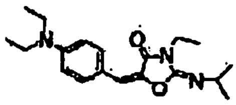
(D47)

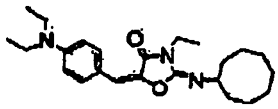
(D48)

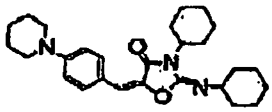
(D49)

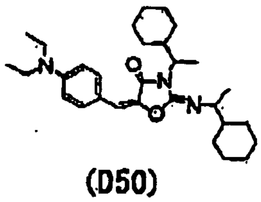
(D50)

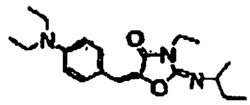
(D51)

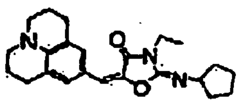
(D52)

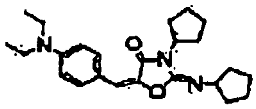
(D53)

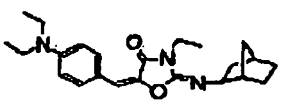
(D54)

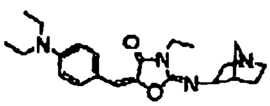
(D55)

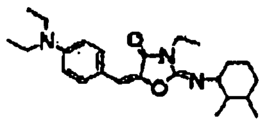
(D56)

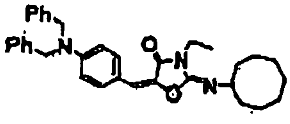
(D57)

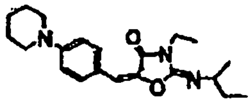
(D58)

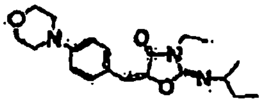
(D59)

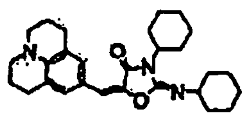
(D60)

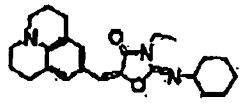
(D61)

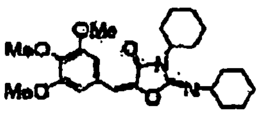
(D62)

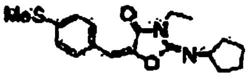
(D63)

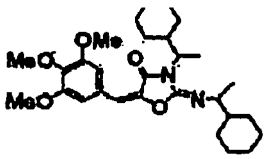
(D64)

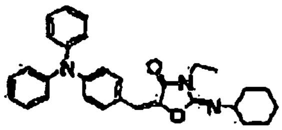
(D65)

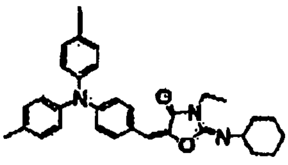
(D66)

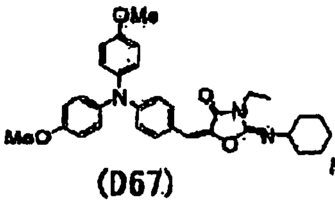
(D67)

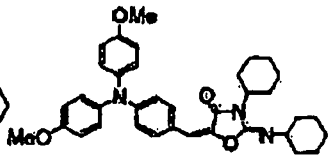
(D68)

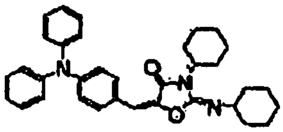
(D69)

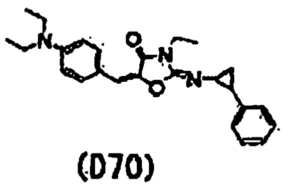
(D70)

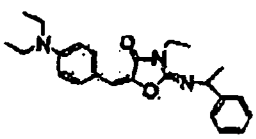
(D71)

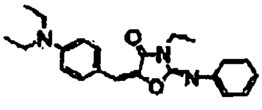
(D72)

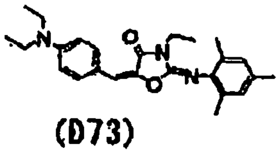
(D73)

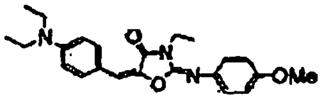

(D74)

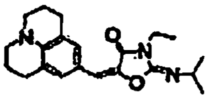

(D75)

Details of the method of using the sensitizing dye, for example, selection of the structure, individual or combination use or an amount added, can be appropriately determined in accordance with the characteristic design of the final lithographic printing plate precursor.

For instance, when two or more sensitizing dyes are used in combination, the compatibility thereof with the photosensitive layer can be increased. For the selection of sensitizing dye, the molar absorption coefficient thereof at the emission wavelength of the light source used is an important factor in addition to the photosensitivity. Use of the dye having a large molar absorption coefficient is profitable, because the amount of dye added can be made relatively small. Also, in case of using in a lithographic printing plate precursor, the use of such a dye is advantageous in view of physical properties of the photosensitive layer. Since the photosensitivity and resolution of the photosensitive layer and the physical properties of the exposed area of the photosensitive layer are greatly influenced by the absorbance of sensitizing dye at the wavelength of light source, the amount of the sensitizing dye added is appropriately determined by taking account of these factors.

However, for the purpose of hardening a layer having a large thickness, for example, of 5 μm or more, low absorbance is sometimes rather effective for increasing the hardening degree. In the case of using in a lithographic printing plate precursor where the photosensitive layer has a relatively small thickness, the amount of the sensitizing dye added is preferably selected such that the photosensitive layer has an absorbance from 0.1 to 1.5, preferably from 0.25 to 1. Ordinarily, the amount of the sensitizing dye added is preferably from 0.05 to 30 parts by weight, more preferably from 0.1 to 20 parts by weight, and most preferably from 0.2 to 10 parts by weight, per 100 parts by weight of the total solid content of the photosensitive layer.

(B) Polymerization initiator

Hexaarylbiimidazole compound is used as a polymerization initiator in the invention.

The hexaarylbiimidazole polymerization initiator includes, for example, lophine dimers described in JP-B-45-37377 and JP-B-44-86516, specifically,
2,2'-bis(o-chlorophenyl)-4,4',5,5'-tetraphenylbiimidazole,
2,2'-bis(o-bromophenyl)-4,4',5,5'-tetraphenylbiimidazole,
2,2'-bis(o,p-dichlorophenyl)-4,4',5,5'-tetraphenylbiimidazole,
2,2'-bis(o-chlorophenyl)-4,4',5,5'-tetra(m-methoxyphenyl)biimidazole,
2,2'-bis(o,o'-dichlorophenyl)-4,4',5,5'-tetraphenylbiimidazole,
2,2'-bis(o-nitrophenyl)-4,4',5,5'-tetraphenylbiimidazole,
2,2'-bis(o-methylphenyl)-4,4',5,5'-tetraphenylbiimidazole and
2,2'-bis(o-trifluoromethylphenyl)-4,4',5,5'-tetraphenylbiimidazole.

As the polymerization initiator according to the invention, it is possible to use a trihalomethyl compound, an onium salt compound or a titanocene compound shown below in combination with the hexaarylbiimidazole compound.

The trihalomethyl compound preferably includes trihalomethyl-s-triazines, and specifically s-triazine derivatives having a trihalogen-substituted methyl group described in JP-A-58-29803, for example, 2,4,6-tris(trichloromethyl)-s-triazine,
2-methoxy-4,6-bis(trichloromethyl)-s-triazine,
2-amino-4,6-bis(trichloromethyl)-s-triazine and
2-(p-methoxystyryl)-4,6-bis(trichloromethyl)-s-triazine.

The onium salt includes, for example, onium salts represented by the following formula (X):

(X)

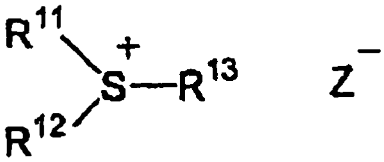

In formula (X), $R^{11}$, $R^{12}$ and $R^{13}$, which may be the same or different, each represents a hydrocarbon group having 20 or less carbon atoms which may have a substituent. Preferred examples of the substituent include a halogen atom, a nitro group, an alkyl group having 12 or less carbon atoms, an alkoxy group having 12 or less carbon atoms and an aryloxy group having 12 or less carbon atoms. Z- represents a counter ion selected from the group consisting of a halogen ion, a perchlorate ion, a tetrafluoroborate ion, a hexafluorophosphate ion, a carboxylate ion and a sulfonate ion, and is preferably a perchlorate ion, a hexafluorophosphate ion, a carboxylate ion or an arylsulfonate ion.

The titanocene compound can be used by appropriately selecting, for example, from known compounds as described in JP-A-59-152396 and JP-A-61-151197.
Specific examples thereof include dicyclopentadienyl-Ti-dichloride,
dicyclopentadienyl-Ti-bisphenyl,
dicyclopentadienyl-Ti-bis-2,3,4,5,6-pentafluorophen-1-yl,
dicyclopentadienyl-Ti-bis-2,3,5,6-tetrafluorophen-1-yl,
dicyclopentadienyl-Ti-bis-2,4,6-trifluorophen-1-yl,
dicyclopentadienyl-Ti-bis-2,6-difluorophen-1-yl,
dicyclopentadienyl-Ti-bis-2,4-difluorophen-1-yl,
dimethylcyclopentadienyl-Ti-bis-2,3,4,5,6-pentafluorophen-1-yl,
dirnethylcyclopentadienyl-Ti-bis-2,3,5,6-tetrafluorophen-1-yl,
dimethylcyclopentadienyl-Ti-big-2,4-difluorophen-1-yl and
bis(cyclopentadienyl)-bis-(2,6-difluoro-3-(pyr-1-lyl)phenyl) titanium.

The polymerization initiators are preferably used individually or as a mixture of two or more thereof in the invention.

An amount of the polymerization initiator used in the invention is preferably from 0.01 to 20% by weight, more preferably from 0.1 to 15% by weight, and still more preferably from 1.0 to 10% by weight, based on the total solid content of the photosensitive layer.

The amount of the hexaarylbiimidazole compound is preferably 50% by weight or more, more preferably 75% by weight or more, based on the total amount of the polymerization initiator.

(C) Polymerizable compound

The polymerizable compound for use in the photosensitive layer according to the invention is an addition-polymerizable compound having at least one ethylenically unsaturated double bond, and it is selected from compounds having at least one, preferably two or more, terminal ethylenically unsaturated double bonds. Such compounds are widely known in the art and they can be used in the invention without any particular limitation. The compound has a chemical form, for example, a monomer, a prepolymer, specifically, a dimer, a trimer or an oligomer, or a copolymer thereof, or a mixture thereof Examples of the monomer include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with an aliphatic polyhydric alcohol compound and amides of an unsaturated carboxylic acid with an aliphatic polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

Specific examples of the monomer, which is an ester of an aliphatic polyhydric alcohol compound with an unsaturated carboxylic acid, include acrylic acid esters, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentacrythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, isocyanuric acid ethylene oxide (EO) modified triacrylate or polyester acrylate oligomer; methacrylic acid esters, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane or bis[p-(methacryloxyethoxy)phenyl]dimethylmethane; itaconic acid esters, for example, ethylene glycol diitaconate, propylene glycol diitaconate, 1,3-butanediol diitaconate, 1,4-butanediol diitaconate, tetramethylene glycol diitaconate, pentaerythritol diitaconate or sorbitol tetraitaconate; crotonic acid esters, for example, ethylene glycol dicrotonate, tetramethylene glycol dicrotonate, pentaerythritol dicrotonate or sorbitol tetracrotonate; isocrotonic acid esters, for example, ethylene glycol diisocrotonate, pentaerythritol diisocrotonate or sorbitol tetraisocrotonate; and maleic acid esters, for example, ethylene glycol dimaleate, triethylene glycol dimaleate, pentaerythritol dimaleate and sorbitol tetramaleate.

Other examples of the ester, which can be preferably used, include aliphatic alcohol esters described in JP-B-51-47334 and JP-A-57-196231, esters having an aromatic skeleton described in JP-A-59-5240, JP-A-59-5241 and JP-A-2-226149, and esters containing an amino group described in JP-A-1-165613.

The above-described ester monomers can also be used as a mixture.

Specific examples of the monomer, which is an amide of an aliphatic polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide. Other preferred examples of the amide monomer include amides having a cyclohexylene structure described in JP-B-54-21726.

Urethane type addition-polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708.

$$CH_2=C(R_4)COOCH_2CH(R_5)OH \qquad (A)$$

wherein $R_4$ and $R_5$ each independently represents H or $CH_3$.

Also, urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418 are preferably used. Further, a photosensitive composition having remarkably excellent photo-speed can be obtained by using an addition polymerizable compound having an amino structure or a sulfide structure in its molecule, described in JP-A-63-277653, JP-A-63-260909 and JP-A-1-105238.

Other examples include polyfunctional acrylates and methacrylates, for example, polyester acrylates and epoxy acrylates obtained by reacting an epoxy resin with (meth)acrylic acid, described in JP-A-48-64183, JP-B-49-43191 and JP-B-52-30490. Specific unsaturated compounds described in JP-B-46-43946, JP-B-1-40337 and JP-B-1-40336, and vinylphosphonic acid type compounds described in JP-A-2-25493 can also be exemplified. In some cases, structure containing a perfluoroalkyl group described in JP-A-61-22048 can be preferably used. Moreover, photocurable monomers or oligomers described in Nippon Secchaku Kyokaishi (Journal of Japan Adhesion Society), Vol. 20, No. 7, pages 300 to 308 (1984) can also be used.

Details of the method of using the polymerizable compound, for example, selection of the structure, individual or combination use or an amount added, can be appropriately determined in accordance with the characteristic design of the final lithographic printing plate precursor. For instance, the compound is selected from the following standpoints.

In view of the sensitivity, a structure having a large content of unsaturated group per molecule is preferred and in many cases, a difunctional or more functional compound is preferred. Also, in order to increase the strength of the image area, that is, hardened layer, a trifunctional or more functional compound is preferred. A combination use of compounds different in the functional number or in the kind of polymerizable group (for example, an acrylic acid ester, a methacrylic acid ester, a styrene compound or a vinyl ether compound) is an effective method for controlling both the sensitivity and the strength.

The selection and use method of the polymerizable compound are also important factors for the compatibility and dispersibility with other components (for example, a binder polymer, a polymerization initiator or a coloring agent) in the photosensitive layer. For instance, the compatibility may be improved in some cases by using the compound of low purity or using two or more kinds of the compounds in combination. A specific structure may be selected for the purpose of improving an adhesion property to a support, a protective layer or the like described hereinafter.

The polymerizable compound is used preferably in a range from 5 to 80% by weight, more preferably in a range from 25 to 75% by weight, based on the total solid content of the photosensitive layer. The polymerizable compounds may be used individually or in combination of two or more thereof. In the method of using the polymerizable compound, the structure, blend and amount added can be appropriately selected by taking account of the degree of polymerization inhibition due to oxygen, resolution, fogging property, change in refractive index, surface tackiness and the like. Further, depending on the case, a layer construction, for example, an undercoat layer or an overcoat layer, and a coating method,

may also be considered.

(D) Hydrophobic binder polymer

The hydrophobic binder polymer which can be used in the photosensitive layer according to the invention is preferably a water-insoluble polymer. Further, the hydrophobic binder polymer capable of being used in the invention preferably does not substantially contain an acid group, for example, a carboxy group, a sulfonic acid group or a phosphoric acid group. An acid value (acid content per g of polymer, indicated by the chemical equivalent number) of the binder polymer is preferably 0.3 meq/g or less, more preferably 0.1 meq/g or less.

Specifically, the hydrophobic binder polymer usable in the invention is preferably insoluble in water or an aqueous solution having a pH of 10 or more. The solubility (polymer concentration at the saturation dissolution) of the hydrophobic binder polymer in water or an aqueous solution having a pH of 10 or more is preferably 0.5% by weight or less, more preferably 0.1% by weight or less. By using such a hydrophobic binder polymer, the film strength, water resistance and inking property of the photosensitive layer are enhanced and improvement in the printing durability can be achieved. The temperature for measuring the above-described solubility is temperature at plate-making development and it is 25°C here.

As for the hydrophobic binder polymer, conventionally known hydrophobic binder polymers preferably having the solubility in the above-described range can be used without limitation as long as the performance of the lithographic printing plate of the invention is not impaired, and a linear organic polymer having film-forming property is preferred.

Preferred examples of such a hydrophobic binder polymer include a polymer selected from an acrylic resin, a polyvinyl acetal resin, a polyurethane resin, a polyamide resin, an epoxy resin, a methacrylic resin, a styrene-based resin and a polyester resin. Among these, an acrylic resin is preferred, and a (meth)acrylic acid ester copolymer is more preferred. More specifically, a copolymer of a (meth)acrylic acid alkyl or aralkyl ester with a (meth)acrylic acid ester containing a $-CH_2CH_2O-$ or $-CH_2CH_2NH-$ unit in R of the ester residue (-COOR) of the (meth)acrylic acid ester is particularly preferred. The alkyl group in the (meth)acrylic acid alkyl ester is preferably an alkyl group having from 1 to 5 carbon atoms, more preferably a methyl group. Preferred examples of the (meth)acrylic acid aralkyl ester include benzyl (meth)acrylate.

The hydrophobic binder polymer can be imparted with a crosslinking property in order to increase the film strength of the image area.

In order to impart the crosslinking property to the binder polymer, a crosslinkable functional group, for example, an ethylenically unsaturated bond is introduced into a main chain or side chain of the polymer. The crosslinkable functional group may be introduced by copolymerization or a polymer reaction.

The term "crosslinkable group" as used herein means a group capable of crosslinking the polymer binder in the process of a radical polymerization reaction which is caused in the photosensitive layer, when the lithographic printing plate precursor is exposed to light. The crosslinkable group is not particularly restricted as long as it has such a function and includes, for example, an ethylenically unsaturated bonding group, an amino group or an epoxy group as a functional group capable of conducting an addition polymerization reaction. Also, a functional group capable of forming a radical upon irradiation with light may be used and such a crosslinkable group includes, for example, a thiol group, a halogen atom and an onium salt structure.

Among them, the ethylenically unsaturated bonding group is preferable, and functional groups represented by formulae (1) to (3) shown below are particularly preferable.

Formula (1):

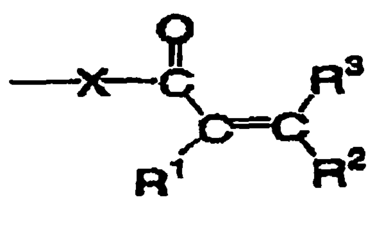

In formula (1), $R^1$ to $R^3$ each independently represents a hydrogen atom or a monovalent organic group. $R^1$ preferably includes, for example, a hydrogen atom or an alkyl group which may have a substituent. Among them, a hydrogen atom or a methyl group is preferable because of high radical reactivity. $R^2$ and $R^3$ each independently preferably includes, for example, a hydrogen atom, a halogen atom, an amino group, a carboxy group, an alkoxycarbonyl group, a sulfo group, a nitro group, a cyano group, an alkyl group which may have a substituent, an aryl group which may have

a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxy group, an alkoxycarbonyl group, an alkyl group which may have a substituent or an aryl group which may have a substituent is preferable because of high radical reactivity.

X represents an oxygen atom, a sulfur atom or -N($R^{12}$)-, and $R^{12}$ represents a hydrogen atom or a monovalent organic group. The monovalent organic group represented by $R^{12}$ includes, for example, an alkyl group which may have a substituent. Among them, a hydrogen atom, a methyl group, an ethyl group or an isopropyl group is preferable because of high radical reactivity.

Examples of the substituent introduced include an alkyl group, an alkenyl group, an alkynyl group, an aryl group, an alkoxy group, an aryloxy group, a halogen atom, an amino group, an alkylamino group, an arylamino group, a carboxy group, an alkoxycarbonyl group, a sulfo group, a nitro group, a cyano group, an amido group, an alkylsulfonyl group and an arylsulfonyl group.

Formula (2):

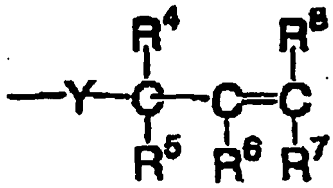

In formula (2), $R^4$ to $R^8$ each independently represents a hydrogen atom or a monovalent organic group, $R^4$ to $R^8$ each independently preferably includes, for example, a hydrogen atom, a halogen atom, an amino group, a dialkylamino group, a carboxy group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxy group, an alkoxycarbonyl group, an alkyl group which may have a substituent or an aryl group which may have a substituent is preferable.

Examples of the substituent introduced include those described in Formula (1). Y represents an oxygen atom, a sulfur atom or -N($R^{12}$)-, and $R^{12}$ has the same meaning as $R^{12}$ defined in Formula (1). Preferred examples for $R^{12}$ are also same as those described in Formula (1).

Formula (3):

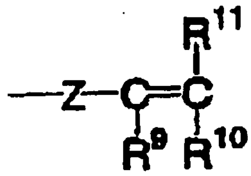

In formula (3), $R^9$ preferably represents a hydrogen atom or an alkyl group which may have a substituent. Among them, a hydrogen atom or a methyl group is preferable because of high radical reactivity. $R^{10}$ and $R^{11}$ each independently represents, for example, a hydrogen atom, a halogen atom, an amino group, a dialkylamino group, a carboxy group, an alkoxycarbonyl group, a sulfo group, a nitro group, a cyano group, an alkyl group which may have a substituent, an aryl group Which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxy group, an alkoxycarbonyl group, an alkyl group which may have a substituent or an aryl group which may have a substituent is preferable because of high radical reactivity.

Examples of the substituent introduced include those described in Formula (1). Z represents an oxygen atom,

a sulfur atom, -N($R^{13}$)- or a phenylene group which may have a substituent. $R^{13}$ includes an alkyl group which may have a substituent or the like. Among them, a methyl group, an ethyl group or an isopropyl group is preferable because of high radical reactivity.

Among the polymers, a (meth)acrylic acid copolymer and a polyurethane each having a crosslinkable group in the side chain thereof are more preferable.

In the hydrophobic binder polymer having a crosslinking property, for example, a free radical (a polymerization initiating radical or a radical grown in the process of polymerization of a polymerizable compound) is added to the crosslinkable functional group to cause an addition-polymerization between polymers directly or through a polymerization chain of the polymerizable compound, as a result, crosslinking is formed between polymer molecules to effect curing. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between polymer molecules to effect curing.

The content of the crosslinkable group (content of radical-polymerizable unsaturated double bond determined by iodine titration) in the hydrophobic binder polymer is preferably from 0.1 to 10.0 mmol, more preferably from 1.0 to 7.0 mmol, and most preferably from 2.0 to 5.5 mmol, per g of the hydrophobic binder polymer.

In view of improvement in the developing property with an aqueous solution, the binder polymer is preferably hydrophilic. On the other hand, in view of increasing the printing durability, it is important that the binder polymer has good compatibility with the polymerizable compound contained in the photosensitive layer, that is, the binder polymer is preferably oleophilic, From these standpoints, it is also effective in the invention to copolymerize a hydrophilic group-containing component and an oleophilic group-containing component in the hydrophobic binder polymer in order to improve the developing property and the printing durability. Examples of the hydrophilic group-containing component which can be preferably used include those having a hydrophilic group, for example, a hydroxy group, a carboxylate group, a hydroxyethyl group, an ethyleneoxy group, a hydroxypropyl group, a polyoxyethyl group, a polyoxypropyl group, an amino group, an aminoethyl group, an aminopropyl group, an ammonium group, an amido group and a carboxymethyl group.

The hydrophobic binder polymer preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The hydrophobic binder polymer may be any of a random polymer, a block polymer, a graft polymer and the like, and it is preferably a random polymer.

The hydrophobic binder polymers may be used individually or in combination of two or more thereof.

The content of the hydrophobic binder polymer is from 5 to 90% by weight, preferably from 10 to 70% by weight, more preferably from 10 to 60% by weight, based on the total solid content of the photosensitive layer. In the above-described range, good strength of the image area and good image-forming property can be obtained.

(E) Chain transfer agent

The photosensitive layer according to the invention contains a chain transfer agent represented by formula (I). The chain transfer agent contributes to improvements in the sensitivity and preservation stability. Such a compound donates hydrogen to a radical species of low activity to generate a radical, or is oxidized and then deprotonated to generate a radical.

By using the thiol compound represented by formula (I) shown below as the chain transfer agent, a problem of the odor and decrease in sensitivity due to evaporation of the compound from the photosensitive layer or diffusion thereof into other layers are avoided and a lithographic printing plate precursor which is excellent in preservation stability and exhibits high sensitivity and good printing durability is obtained.

Formula (I):

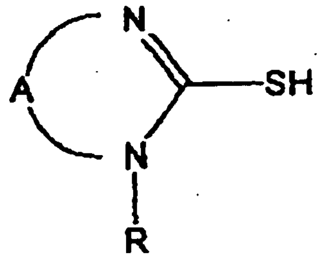

In formula (I), R represents an alkyl group which may have a substituent or an aryl group which may have a substituent; and A represents an atomic group necessary for forming a 5-membered or 6-membered hetero ring containing a carbon atom together with the N=C-N linkage, and A may have a substituent, with the proviso that when A is -HC=CH-, R is not a methyl group.

Compounds represented by formulae (IA) and (IB) shown below are more preferably used.

( IA )

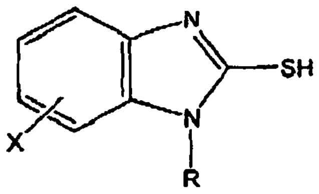

( IB )

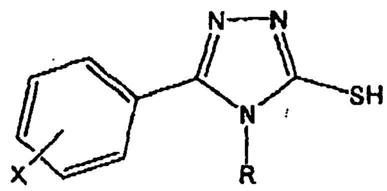

In formulae (IA) and (IB), R represents an alkyl group which may have a substituent or an aryl group which may have a substituent; and X represents a halogen atom, an alkoxy group which may have a substituent, an alkyl group which may have a substituent or an aryl group which may have a substituent.

Preferred examples of the compound represented by formula (I) are set forth below, but the invention should not be construed as being limited thereto.

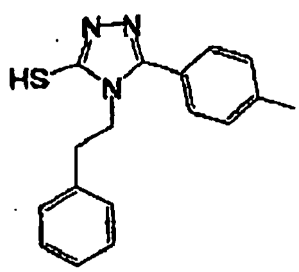

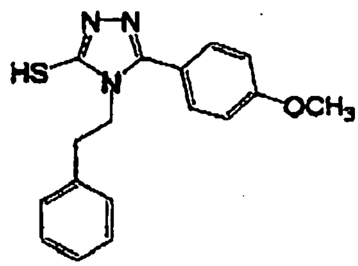

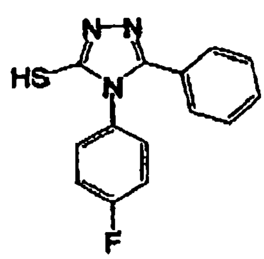

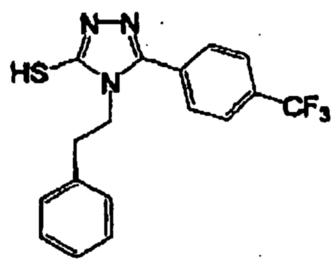

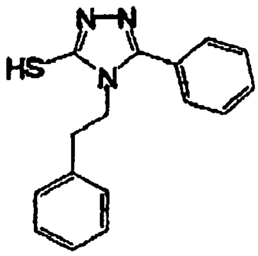

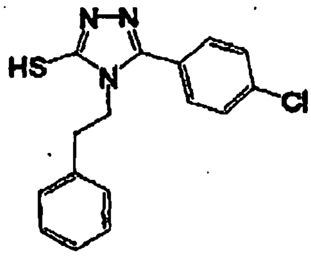

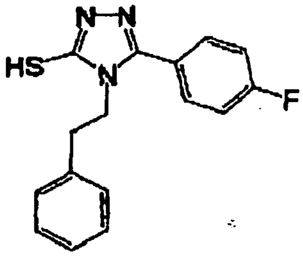

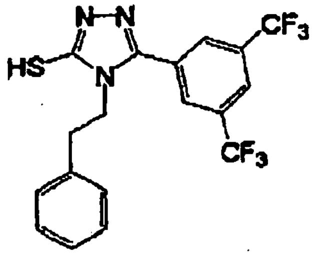

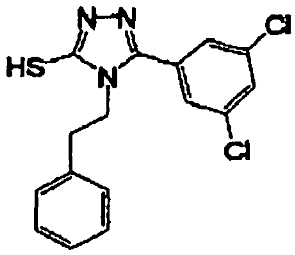

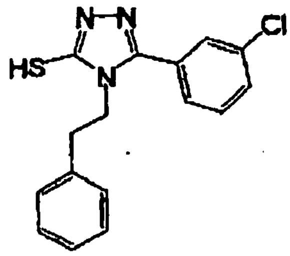

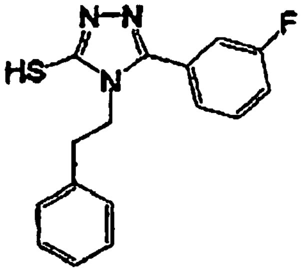

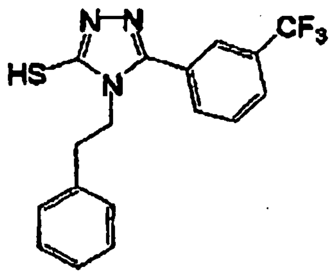

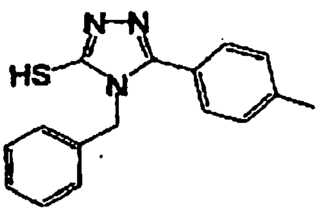

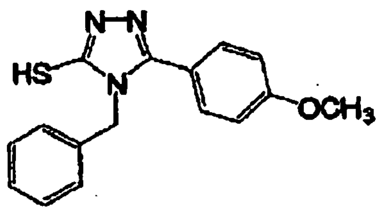

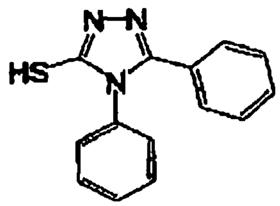
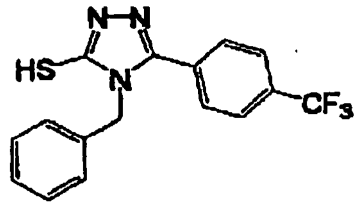

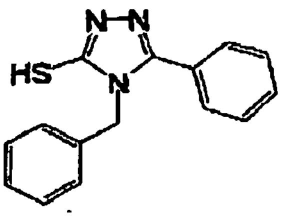
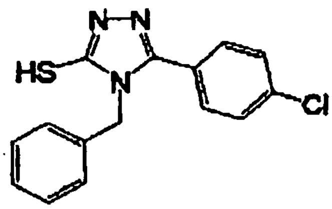

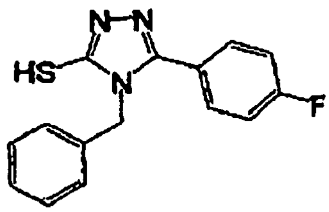
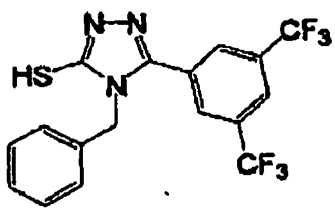

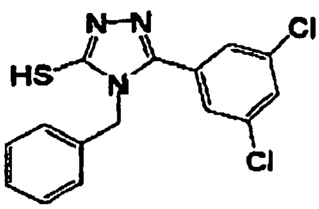
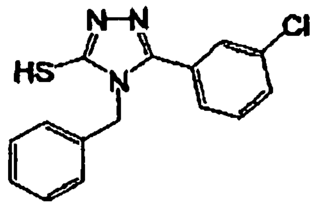

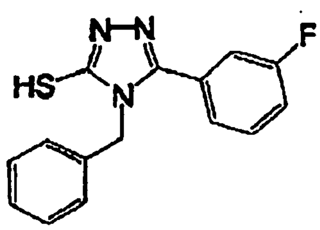
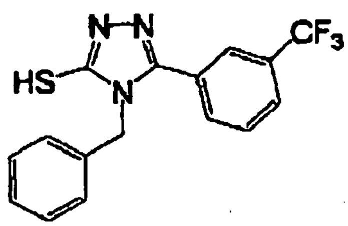

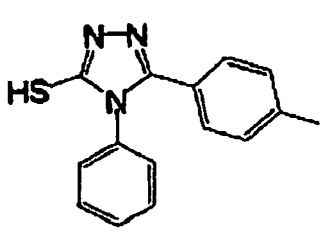
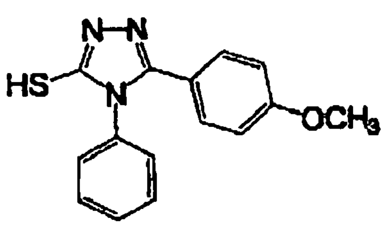

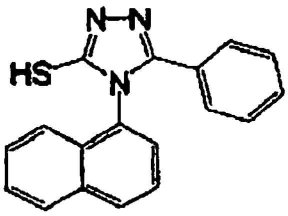

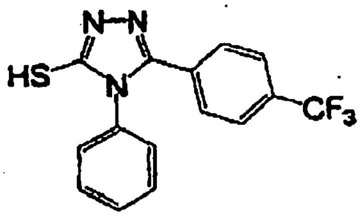

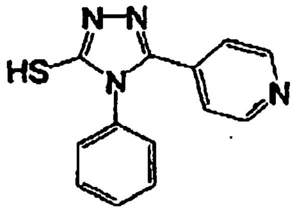

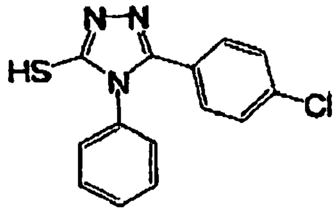

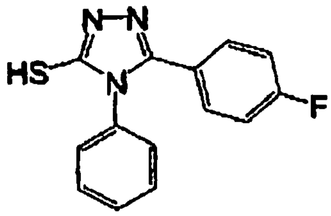

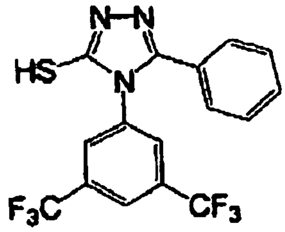

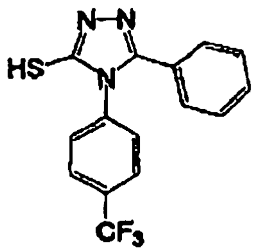

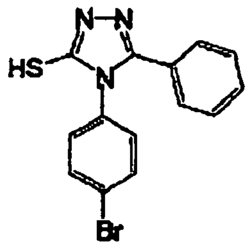

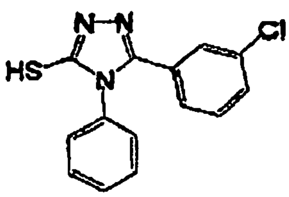

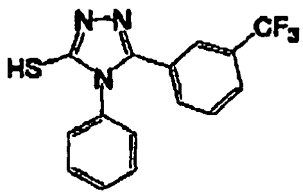

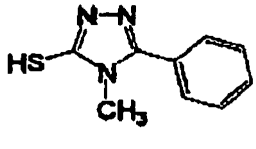

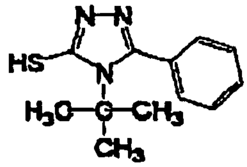

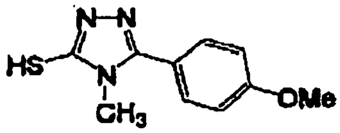
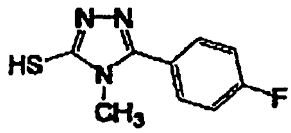

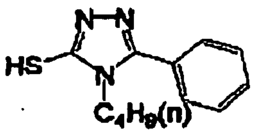
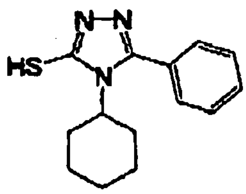

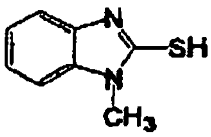
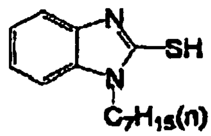

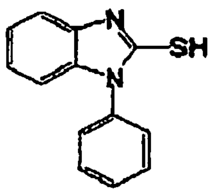
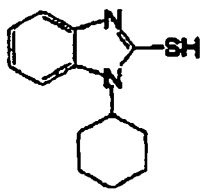

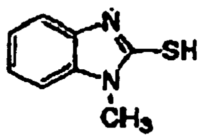
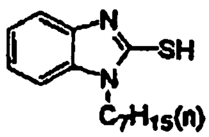

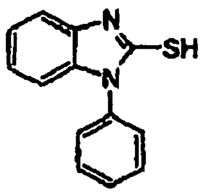
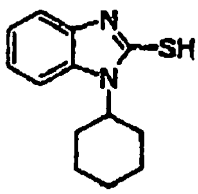

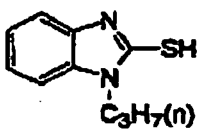
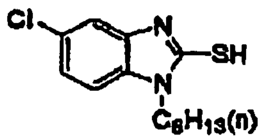

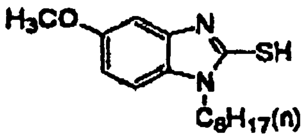
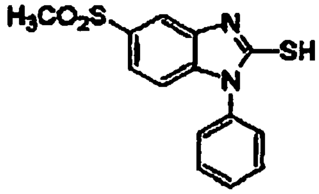

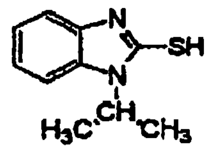
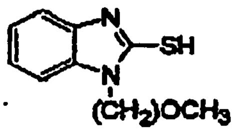

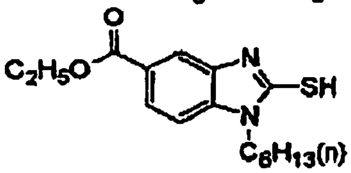
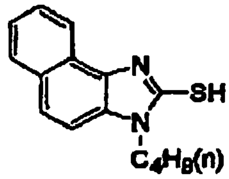

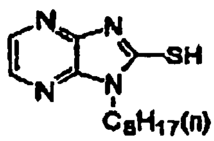
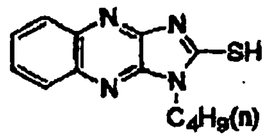

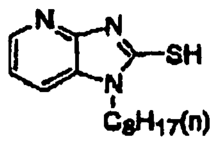
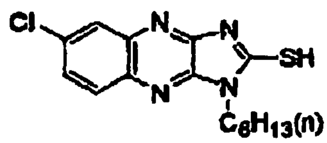

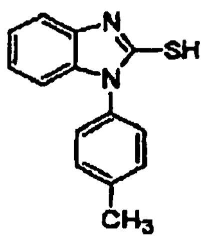
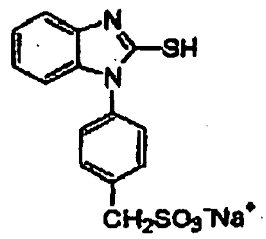

An amount of the chain transfer agent used is preferably from 0.01 to 20% by weight, more preferably from 0.1 to 15% by weight, still more preferably from 1.0 to 10% by weight, based on the total solid content of the photosensitive layer.

<Microcapsule>

In the invention, in order to incorporate the above-described constituting components of the photosensitive layer and other constituting components described hereinafter into the photosensitive layer, a part of the constituting components is encapsulated into microcapsules and added to the photosensitive layer as described, for example, in JP-A-2001-277740 and JP-A-2001-277742. In such a case, each constituting component may be present inside or outside the microcapsule in an appropriate ratio.

As a method of microencapsulating the constituting components of the photosensitive layer, known methods can be used. Methods for the production of microcapsules include, for example, a method of utilizing coacervation described in U.S. Patents 2,800,457 and 2,800,458, a method of using interfacial polymerization described in U.S. Patent 3,287,154, JP-B-38-19574 and JP-B-42-446, a method of using deposition of polymer described in U.S. Patents 3,418,250 and 3,660,304, a method of using an isocyanate polyol wall material described in U.S. Patent 3,796,669, a

method of using an isocyanate wall material described in U.S. Patent 3,914,511, a method of using a urea-formaldehyde-type or urea-formaldehyde-resorcinol-type wall-forming material described in U.S. Patens 4,001,140, 4,087,376 and 4,089,802, a method of using a wall material, for example, a melamine-formaldchyde resin or hydroxycellulose described in U.S. Patent 4,025,445, an in-situ method by polymerization of monomer described in JP-B-36-9163 and JP-B-51-9079, a spray drying method described in British Patent 930,422 and U.S. Patent 3,111,407, and an electrolytic dispersion cooling method described in British Patents 952,807 and 967,074, but the invention should not be construed as being limited thereto.

A preferred microcapsule wall used in the invention has three-dimensional crosslinking and has a solvent-swellable property. From this point of view, a preferred wall material of the microcapsule includes polyurea, polyurethane, polyester, polycarbonate, polyamide and a mixture thereof, and particularly polyurea and polyurethane are preferred. Further, a compound having a crosslinkable functional group, for example, an ethylenically unsaturated bond, capable of being introduced into the hydrophobic binder polymer described above may be introduced into the microcapsule wall.

An average particle size of the microcapsule is preferably from 0.01 to 3.0 μm, more preferably from 0.05 to 2.0 μm, and particularly preferably from 0.10 to 1.0 μm. In the above-described range, preferable resolution and good preservation stability can be achieved.

<Other constituting components of photosensitive layer>

Into the photosensitive layer according to the invention, various additives can further be incorporated, if desired. Such additives are described in detail below.

<Surfactant>

In the invention, it is preferred to use a surfactant in the photosensitive layer in order to progress the developing property and to improve the state of surface coated. The surfactant includes, for example, a nonionic surfactant, an anionic surfactant, a cationic surfactant, an amphoteric surfactant and a fluorine-based surfactant. The surfactants may be used individually or in combination of two or more thereof

The nonionic surfactant used in the invention is not particular restricted, and nonionic surfactants hitherto known can be used. Examples of the nonionic surfactant include polyoxyethylene alkyl ethers, polyoxyethylene alkyl phenyl ethers, polyoxyethylene polystyryl phenyl ethers, polyoxyethylene polyoxypropylene alkyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerol fatty acid partial esters, polyoxyethylenated castor oils, polyoxyethylene glycerol fatty acid partial esters, fatty acid diethanolamides, N,N-bis-2-hydroxyalkylamines, polyoxyethylene alkylamines, triethanolamine fatty acid esters, trialylamine oxides, polyethylene glycols, and copolymers of polyethylene glycol and polypropylene glycol.

The anionic surfactant used in the invention is not particularly restricted and anionic surfactants hitherto known can be used. Examples of the anionic surfactant include fatty acid salts, abietic acid salts, hydroxyalkanesulfonic acid salts, alkanesulfonic acid salts, dialkylsulfosuccinic ester salts, straight-chain alkylbenzenesulfonic acid salts, branched alkylbenzenesulfonic acid salts, alkylnaphthalenesulfonic acid salts, alkylphenoxypolyoxy ethylene propylsulfonic acid salts, polyoxyethylene alkylsulfophenyl ether salts, N-methyl-N-oleyltaurine sodium salt, N-alkylsulfosuccinic monoamide disodium salts, petroleum sulfonic acid salts, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styrylphenyl ether sulfate ester salts, alkyl phosphate ester salts, polyoxyethylene alkyl ether phosphate ester salts, polyoxyethylene alkyl phenyl ether phosphate ester salts, partial saponification products of styrene/maleic anhydride copolymer, partial saponification products of olefin/maleic anhydride copolymer and naphthalene sulfonate formalin condensates.

The cationic surfactant used in the invention is not particularly restricted and cationic surfactants hitherto known can be used. Examples of the cationic surfactant include alkylamine salts, quaternary ammonium salts, polyoxyethylene alkyl amine salts and polyethylene polyamine derivatives.

The amphoteric surfactant used in the invention is not particularly restricted and amphoteric surfactants hitherto known can be used. Examples of the amphoteric surfactant include carboxybetaines, aminocarboxylic acids, sulfobetaines, aminosulfuric esters and imidazolines.

In the surfactants described above, the term "polyoxyethylene" can be replaced with "polyoxyalkylene", for example, polyoxymethylene, polyoxypropylene or polyoxybutylene, and such surfactants can also be used in the invention.

Further, a preferred surfactant includes a fluorine-based surfactant containing a perfluoroalkyl group in its molecule. Examples of the fluorine-based surfactant include an anionic type, for example, perfluoroalkyl carboxylates,

perfluoroalkyl sulfonates or perfluoroalkylphosphates; an amphoteric type, for example, perfluoroalkyl betaines; a cationic type, for example, perfluoroalkyl trimethyl ammonium salts; and a nonionic type, for example, perfluoroalkyl amine oxides, perfluoroalkyl ethylene oxide adducts, oligomers having a perfluoroalkyl group and a hydrophilic group, oligomers having a perfluoroalkyl group and an oleophilic group, oligomers having a perfluoroalkyl group, a hydrophilic group and an oleophilic group or urethanes having a perfluoroalkyl group and an oleophilic group. Further, fluorine-based surfactants described in JP-A-62-170950, JP-A-62-226143 and JP-A-60-168144 are also preferably exemplified.

The surfactants may be used individually or in combination of two or more thereof

A content of the surfactant is preferably from 0.001 to 10% by weight, more preferably from 0.01 to 7% by weight, based on the total solid content of the photosensitive layer.

<Hydrophilic polymer>

In the invention, a hydrophilic polymer may be incorporated into the photosensitive layer in order to improve the developing property and dispersion stability of microcapsule.

Preferable examples of the hydrophilic polymer include those having a hydrophilic group, for example, a hydroxy group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfonic acid group and a phosphoric acid group.

Specific examples thereof include gum arabic, casein, gelatin, a starch derivative, carboxymethyl cellulose or a sodium salt thereof, cellulose acetate, sodium alginate, a vinyl acetate-maleic acid copolymer, a styrene-maleic acid copolymer, polyacrylic acid or a salt thereof, polymethacrylic acid or a salt thereof, a homopolymer or copolymer of hydroxyethyl methacrylate, a homopolymer or copolymer of hydroxyethyl acrylate, a homopolymer or copolymer of hydroxypropyl methacrylate, a homopolymer or copolymer of hydroxypropyl acrylate, a homopolymer or copolymer of hydroxybutyl methacrylate, a homopolymer or copolymer of hydroxybutyl acrylate, polyethylene glycol, a hydroxypropylene polymer, polyvinyl alcohol, a hydrolyzed polyvinyl acetate having a hydrolysis degree of 60% by mole or more, preferably 80% by mole or more, polyvinyl formal, polyvinyl butyral, polyvinylpyrrolidone, a homopolymer or polymer of acrylamide, a homopolymer or copolymer of methacrylamide, a homopolymer or copolymer of N-methylolacrylamide, polyvinylpyrrolidone, an alcohol-soluble nylon, and a polyether of 2,2-bis-(4-hydroxyphenyl)propane with epichlorohydrin.

The hydrophilic polymer preferably has a weight average molecular weight of 5,000 or more, more preferably from 10,000 to 300,000. The hydrophilic polymer may be any of a random polymer, a block polymer, a graft polymer or the like.

The content of the hydrophilic polymer in the photosensitive layer is preferably 20% by weight or less, more preferably 10% by weight or less, based on the total solid content of the photosensitive layer.

<Coloring agent>

In the invention, a dye having large absorption in the visible light region can be used as a coloring agent for the image. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (all produced by Orient Chemical Industry Co., Ltd.), Victoria Pure Blue, Crystal Violet (CI42555), Methyl Violet (CI42535), Ethyl Violet, Rhodamine B (CI45170B), Malachite Green (CI42000), Methylene Blue (CI52015), and dyes described in JP-A-62-293247. Also, a pigment, for example, phthalocyanine-based pigment, azo-based pigment, carbon black and titanium oxide can be preferably used.

It is preferable to add the coloring agent, because the image area and the non-image area after the image formation can be easily distinguished. The amount of the coloring agent added is preferably from 0.01 to 10% by weight based on the total solid content of the photosensitive layer.

<Print-out agent>

In the photosensitive layer according to the invention, a compound capable of undergoing discoloration by the effect of an acid or a radical can be added in order to form a print-out image. As such a compound, for example, various dyes, e.g., diphenylmethane-based, triphenylmethane-based, thiazine-based, oxazine-based, xanthene-based, anthraquinone-based, iminoquinone-based, azo-based and azornethine-based dyes are effectively used.

Specific examples thereof include dyes, for example, Brilliant Green, Ethyl Violet, Methyl Green, Crystal Violet, Basic Fuchsine, Methyl Violet 2B, Quinaldine Red, Rose Bengale, Metanil Yellow, Thymolsulfophthalein, Xylenol Blue, Methyl Orange, Paramethyl Red, Congo Red, Benzopurpurine 4B, $\alpha$-Naphthyl Red, Nile Blue 2B, Nile Blue A, Methyl Violet, Malachite Green, Parafuchsine, Victoria Pure Blue BOH (produced by Hodogaya Chemical Co., Ltd.), Oil Blue #603 (produced by Orient Chemical Industry Co., Ltd.), Oil Pink #312 (produced by Orient Chemical Industry Co., Ltd.), Oil Red 5B (produced by Orient Chemical Industry Co., Ltd.), Oil Scarlet #308 (produced by Orient Chemical Industry

Co., Ltd.), Oil Red OG (produced by Orient Chemical Industry Co., Ltd.), Oil Red RR (produced by Orient Chemical Industry Co., Ltd.), Oil Green #502 (produced by Orient Chemical Industry Co., Ltd.), Spiron Red BEH Special (produced by Hodogaya Chemical Co., Ltd.), m-Cresol Purple, Cresol Red, Rhodamine B, Rhodamine 6G, Sulforhodamine B, Auramine, 4-p-diethylaminophenyliminonaphthoquinone, 2-carboxyanilino-4-p-diethylaminophenyliminonaphthoquinone, 2-carboxystearylamino-4-p-N,N-bis(hydroxyethyl)aminophenyliminonaphthoquinone, 1-phenyl-3-methyl-4-p-diethylaminophenylimino-5-pyrazolone and 1-β-naphthyl-4-p-diethylaminophenylimino-5-pyrazolone, and leuco dyes, for example, p,p',p''-hexamethyltriaminotriphenyl methane (leuco Crystal Violet) and Pergascript Blue SRB (produced by Ciba Geigy).

Other preferable examples include leuco dyes known as a material for heat-sensitive paper or pressure-sensitive paper. Specific examples thereof include Crystal Violet Lactone, Malachite Green Lactone, Benzoyl Leuco Methylene Blue,
2-(N-phenyl-N-methylamino)-6-(N-p-tolyl-N-ethyl)aminofluorane,
2-anilino-3-methyl-6-(N-ethyl-p-toluidino)fluorane, 3,6-dimethoxyfluorane,
3-(N,N-diethylamino)-5-methyl-7-(N,N-dibenzylamino)fluorane,
3-(N-cyclohexyl-N-methylamino)-6-methyl-7-anilinofluorane,
3-(N,N-diethylamino)-6-methyl-7-anilinofluorane,
3-(N,N-diethylamino)-6-methyl-7-xylidinofluorane,
3-(N,N-diethylamino)-6-methyl-7-chlorofluorane,
3-(N,N-diethylamino)-6-methoxy-7-aminofluorane,
3-(N,N-diethylamino)-7-(4-chloroanilino)fluorane,
3-(N,N-diethylamino)-7-chlorofluorane, 3-(N,N-diethylamino)-7-benzylaminofluorane,
3-(N,N-diethylamino)-7,8-benzofluorane,
3-(N,N-dibutylamino)-6-methyl-7-anilinofluorane,
3-(N,N-dibutylamino)-6-methyl-7-xylidinofluorane,
3-piperidino-6-methyl-7-anilinofluorane, 3-pyrrolidino-6-methyl-7-anilinofluorane,
3,3-bis(1-ethyl-2-methylindol-3-yl)phthalide,
3,3-bis(1-n-butyl-2-methylindol-3-yl)phthalide,
3,3-bis(p-dimethylaminophenyl)-6-dimethylaminophthalide,
3-(4-diethylamino-2-ethoxypbenyl)-3-(1-etbyl-2-methylindol-3-yl)-4-phthalide and
3-(4-diethylaminophenyl)-3-(1-ethyl-2-methylindol-3-yl)phthalide.

The dye capable of undergoing discoloration by the effect of an acid or a radical is preferably added in an amount of 0.01 to 1.5% by weight based on the total solid content of the photosensitive layer.

<Polymerization inhibitor>

In the photosensitive layer according to the invention, a small amount of a thermal polymerization inhibitor is preferably added in order to prevent the radical polymerizable compound from undergoing undesirable thermal polymerization during the preparation or preservation of the photosensitive layer.

Preferable examples of the thermal polymerization inhibitor include hydroquinone, p-methoxyphenol, di-tert-butyl-p-cresol, pyrogallol, tert-butyl catechol, benzoquinone, 4,4'-thiobis(3-methyl-6-tert-butylphenol),
2,2'-methylenebis(4-methyl-6-tert-butylphenol) and
N-nitroso-N-phenylhydroxylamine aluminum salt.

The amount of the thermal polymerization inhibitor added is preferably from about 0.01 to about 5% by weight based on the total solid content of the photosensitive layer.

<Higher fatty acid derivative>

In the photosensitive layer according to the invention, for example, a higher fatty acid derivative, e.g., behenic acid or behenic acid amide may be added and localized on the surface of the photosensitive layer during the process of drying after coating in order to avoid polymerization inhibition due to oxygen. The amount of the higher fatty acid derivative added is preferably from about 0.1 to about 10% by weight based on the total solid content of the photosensitive layer.

<Plasticizer>

The photosensitive layer according to the invention may contain a plasticizer. Preferable examples of the plasticizer include a phthalic acid ester, for example, dimethyl phthalate, diethyl phthalate, dibutyl phthalate, diisobutyl phthalate, diocyl phthalate, octyl capryl phthalate, dicyclohexyl phthalate, ditridecyl phthalate, butyl benzyl phthalate,

diisodecyl phthalate or diallyl phthalate; a glycol ester, for example, dimethyl glycol phthalate, ethyl phthalylethyl glycolate, methyl phrthalylethyl glycolate, butyl phthalylbutyl glycolate or triethylene glycol dicaprylic acid ester; a phosphoric acid ester, for example, tricresyl phosphate or triphenyl phosphate; an aliphatic dibasic acid ester, for example, diisobutyl adipate, dioctyl adipate, dimethyl sebacate, dibutyl sebacate, dioctyl azelate or dibutyl maleate; polyglycidyl methacrylate, triethyl citrate, glycerin triacetyl ester and butyl laurate. The content of the plasticizer is preferably about 30% by weight or less based on the total solid content of the photosensitive layer.

<Fine inorganic particle>

The photosensitive layer according to the invention may contain fine inorganic particle in order to increase strength of the hardened layer in the image area. The fine inorganic particle preferably includes, for example, silica, alumina, magnesium oxide, titanium oxide, magnesium carbonate, calcium alginate and a mixture thereof. Even if the fine inorganic particle has no light to heat converting property, it can be used, for example, for strengthening the film or enhancing interface adhesion due to surface roughening. The fine inorganic particle preferably has an average particle size from 5 nm to 10 μm and more preferably from 0.5 to 3μm. In the above-described range, it is stably dispersed in the photosensitive layer, sufficiently maintains the film strength of the photosensitive layer and can form the non-image area excellent in hydrophilicity and preventing from stain at the printing.

The fine inorganic particle described above is easily available as a commercial product, for example, colloidal silica dispersion.

The content of the fine inorganic particle is preferably 20% by weight or less and more preferably 10% by weight or less based on the total solid content of the photosensitive layer.

<Hydrophilic low molecular weight compound>

The photosensitive layer according to the invention may contain a hydrophilic low molecular weight compound in order to improve the developing property. The hydrophilic low molecular weight compound includes a water-soluble organic compound, for example, a glycol compound, e.g., ethylene glycol, diethylene glycol, triethylene glycol, propylene glycol, dipropylene glycol or tripropylene glycol, or an ether or ester derivative thereof, a polyhydroxy compound, e.g., glycerine or pentaerythritol, an organic amine, e.g., triethanol amine, diethanol amine or monoethanol amine, or a salt thereof, an organic sulfonic acid, e.g., toluene sulfonic acid or benzene sulfonic acid, or a salt thereof, an organic phosphonic acid, e.g., phenyl phosphonic acid, or a salt thereof, an organic carboxylic acid, e.g., tartaric acid, oxalic acid, citric acid, maleic acid, lactic acid, gluconic acid or an amino acid, or a salt thereof, and an organic quaternary ammonium salt, e.g., tetraethyl ammonium hydrochloride.

The photosensitive layer according to the invention may contain, for example, a co-sensitizer, in addition to the above-described constituting components.

<Formation of photosensitive layer>

The photosensitive layer according to the invention is formed by dispersing or dissolving each of the necessary constituting components described above to prepare a coating solution and coating the solution. The solvent used include, for example, ethylene dichloride, cyclohexanone, methyl ethyl ketone, methanol, ethanol, propanol, ethylene glycol monomethyl ether, 1-methoxy-2-propanol, 2-methxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone, toluene and water, but the invention should not be construed as being limited thereto. The solvents may be used individually or as a mixture. The solid concentration of the coating solution is preferably from 1 to 50% by weight.

The photosensitive layer according to the invention may also be formed by preparing plural coating solutions by dispersing or dissolving the same or different components described above into the same or different solvents and conducting repeatedly plural coating and drying.

The coating amount (solid content) of the photosensitive layer on the support after the coating and drying may be varied depending on the use, but ordinarily, it is preferably from 0.3 to 3.0 g/$m^2$. In the above-described range, the preferable sensitivity and good film property of the photosensitive layer can be obtained.

Various methods can be used for the coating. Examples of the method include bar coater coating, spin coating, spray coating, curtain coating, dip coating, air knife coating, blade coating and roll coating.

<Protective layer>

In the lithographic printing plate precursor according to the invention, a protective layer (oxygen blocking layer)

is provided on the photosensitive layer in order to prevent diffusion and penetration of oxygen which inhibits the polymerization reaction at the time of exposure. The protective layer for use in the invention preferably has oxygen permeability (A) at 25°C under one atmosphere of 1.0 ≤ (A) ≤ 20 (ml/m$^2$·day). When the oxygen permeability (A) is extremely lower than 1.0 (ml/m$^2$·day), problems may occur in that an undesirable polymerization reaction arises during the production or preservation before image exposure and in that undesirable fog or spread of image line occurs at the image exposure. On the contrary, when the oxygen permeability (A) greatly exceeds 20 (ml/m$^2$·day), decrease in sensitivity may be incurred. The oxygen permeability (A) is more preferably in a range of 1.5 ≤ (A) ≤ 12 (ml/m$^2$·day), and still more preferably in a range of 2.0 ≤ (A) ≤ 10.0 (ml/m$^2$·day). Besides the above described oxygen permeability, as for the characteristics required of the protective layer, it is desired that the protective layer does not substantially hinder the transmission of light for the exposure, is excellent in adhesion to the photosensitive layer, and can be easily removed during a development step after the exposure. Contrivances on the protective layer have been heretofore made and described in detail in U.S. Patent 3,458,311 and JP-B-55-49729.

As the material of the protective layer, a water-soluble polymer compound relatively excellent in crystallizability is preferably used. Specifically, a water-soluble polymer, for example, polyvinyl alcohol, vinyl alcohol/vinyl phthalate copolymer, vinyl acetate/vinyl alcohol/vinyl phthalate copolymer, vinyl acetate/crotonic acid copolymer, polyvinyl pyrrolidone, acidic cellulose, gelatin, gum arabic, polyacrylic acid or polyacrylamide is enumerated. The water-soluble polymer compounds may be used individually or as a mixture. Of the compounds, when polyvinyl alcohol is used as a main component, the best results can be obtained in fundamental characteristics, for example, oxygen-shielding property and removability of the protective layer by development.

Polyvinyl alcohol for use in the protective layer may be partially substituted with ester, ether or acetal as long as it contains unsubstituted vinyl alcohol units for achieving the necessary oxygen-shielding property and water solubility. Also, a part of polyvinyl alcohol may have other copolymer component. As specific examples of polyvinyl alcohol, those having a hydrolyzing rate of 71 to 100% and a polymerization repeating unit number of 300 to 2,400 are exemplified. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 (manufactured by Kuraray Co., Ltd.). They can be used individually or as a mixture. According to a preferred embodiment, the content of polyvinyl alcohol in the protective layer is from 20 to 95% by weight, more preferably from 30 to 90% by weight.

Also, known modified polyvinyl alcohol can be preferably used. For instance, polyvinyl alcohols of various polymerization degrees having at random a various kind of hydrophilic modified cites, for example, an anion-modified cite modified with an anion, e.g., a carboxy group or a sulfo group, a cation-modified cite modified with a cation, e.g., an amino group or an ammonium group, a silanol-modified cite or a thiol-modified cite, and polyvinyl alcohols of various polymerization degrees having at the terminal of the polymer a various kind of modified cites, for example, the above-described anion-modified cite, cation modified cite, silanol-modified cite or thiol-modified cite, an alkoxy-modified cite, a sulfide-modified cite, an ester modified cite of vinyl alcohol with a various kind of organic acids, an ester modified cite of the above-described anion-modified cite with an alcohol or an epoxy-modified cite are exemplified.

As a component used as a mixture with polyvinyl alcohol, polyvinyl pyrrolidone or a modified product thereof is preferable from the viewpoint of the oxygen blocking property and removability by development. The content thereof is ordinarily from 3.5 to 80% by weight, preferably from 10 to 60% by weight, more preferably from 15 to 30% by weight, in the protective layer.

The components of the protective layer (selection of PVA and use of additives) and the coating amount are determined taking into consideration fogging property, adhesion and scratch resistance besides the oxygen blocking property and removability by development. In general, the higher the hydrolyzing rate of the PVA used (the higher the unsubstituted vinyl alcohol unit content in the protective layer) and the larger the layer thickness, the higher is the oxygen blocking property, thus it is advantageous in the point of sensitivity. The molecular weight of the (co)polymer, for example, polyvinyl alcohol (PVA) is ordinarily from 2,000 to 10,000,000, and preferably from 20,000 to 3,000,000.

As other components of the protective layer, glycerin, dipropylene glycol or the like can be added in an amount corresponding to several % by weight of the (co)polymer to provide flexibility. Further, an anionic surfactant, for example, sodium alkylsulfate or sodium alkylsulfonate; an amphoteric surfactant, for example, alkylaminocarboxylate and alkylaminodicarboxylate; or a nonionic surfactant, for example, polyoxyethylene alkyl phenyl ether can be added in an amount corresponding to several % by weight of the (co)polytner.

The adhesion of the protective layer to the photosensitive layer and scratch resistance are also extremely important in view of handling of the printing plate precursor. Specifically, when a hydrophilic layer comprising a water-soluble polymer is laminated on a oleophilic photosensitive layer, layer peeling due to insufficient adhesion is liable to occur, and the peeled portion causes such a defect as failure in hardening of the photosensitive layer due to polymerization inhibition by oxygen. Various proposals have been made for improving the adhesion between the photosensitive layer and the protective layer. For example, it is described in U.S. Patent Application Nos. 292,501 and 44,563 that a sufficient adhesion property can be obtained by mixing from 20 to 60% by weight of an acryl-based emulsion or a water-insoluble

vinyl pyrrolidone/vinyl acetate copolymer with a hydrophilic polymer mainly comprising polyvinyl alcohol and laminating the resulting mixture on the photosensitive layer. Any of these known techniques can be applied to the protective layer according to the invention. Coating methods of the protective layer are described in detail, for example, in U.S. Patent 3,458,311 and JP-B-55-49729.

Further, it is also preferred to incorporate an inorganic stratiform compound into the protective layer of the lithographic printing plate precursor according to the invention for the purpose of improving the oxygen blocking property and property for protecting the surface of photosensitive layer.

The inorganic stratiform compound used here is a particle having a thin tabular shape and includes, for instance, mica, for example, natural mica represented by the following formula: A (B, C)$_{2-5}$ D$_4$ O$_{10}$ (OH, F, O)$_2$, (wherein A represents any one of K, Na and Ca, B and C each represents any one of Fe (II), Fe(III), Mn, Al, Mg and V, and D represents Si or Al) or synthetic mica; talc represented by the following formula: $3MgO\text{-}4SiO \cdot H_2O$; teniolite; montmorillonite; saponite; hectolite; and zirconium phosphate.

Of the micas, examples of the natural mica include muscovite, paragonite, phlogopite, biotite and lepidolite. Examples of the synthetic mica include non-swellable mica, for example, fluorphlogopite $KMg_3(AlSi_3O_{10})F_2$ or potassium tetrasilic mica $KMg_{2.5}(Si_4O_{10})F_2$, and swellable mica, for example, Na tetrasililic mica $NaMg_{2.5}(Si_4O_{10})F_2$, Na or Li teniolite (Na, Li)$Mg_2Li(Si_4O_{10})F_2$, or montmorillonite based Na or Li hectolite (Na, Li)$_{1/8}$$Mg_{2/5}Li_{1/8}(Si_4O_{10})F_2$. Synthetic smectite is also useful.

Of the inorganic stratiform compounds, fluorine based swellable mica, which is a synthetic inorganic stratiform compound, is particularly useful in the invention. Specifically, the swellable synthetic mica and an swellable clay mineral, for example, montmorillonite, saponite, hectolite or bentonite have a stratiform structure comprising a unit crystal lattice layer having thickness of approximately 10 to 15 angstroms, and metallic atom substitution in the lattices thereof is remarkably large in comparison with other clay minerals. As a result, the lattice layer results in lack of positive charge and to compensate it, a cation, for example, $Na^+$, $Ca^{2+}$ or $Mg^{2+}$, is adsorbed between the lattice layers. The cation existing between the lattice layers is referred to as an exchangeable cation and is exchangeable with various cations. In particular, in the case where the cation between the lattice layers is Li+ or $Na^+$, because of a small ionic radius, a bond between the stratiform crystal lattices is week, and the inorganic stratiform compound greatly swells upon contact with water. When share is applied under such condition, the stratiform crystal lattices are easily cleaved to form a stable sol in water. The bentnite and swellable synthetic mica have strongly such tendency and are useful in the invention. Particularly, the swellable synthetic mica is preferably used.

With respect to the shape of the inorganic stratiform compound used in the invention, the thinner the thickness or the larger the plain size as long as smoothness of coated surface and transmission of actinic radiation are not damaged, the better from the standpoint of control of diffusion, Therefore, an aspect ratio of the inorganic stratiform compound is ordinarily 20 or more, preferably 100 or more, and particularly preferably 200 or more. The aspect ratio is a ratio of thickness to major axis of particle and can be determined, for example, from a projection drawing of particle by a microphotography, The larger the aspect ratio, the greater the effect obtained.

As for the particle size of the inorganic stratiform compound used in the invention, an average major axis is ordinarily from 0.3 to 20 $\mu$m, preferably from 0.5 to 10 $\mu$m, and particularly preferably from 1 to 5 $\mu$m. An average thickness of the particle is ordinarily 0.1 $\mu$m or less, preferably 0.05 $\mu$m or less, and particularly preferably 0.01 $\mu$m or less. For example, in the swellable synthetic mica that is the representative compound of the inorganic stratiform compounds, thickness is approximately from 1 to 50 nm and plain size is approximately from 1 to 20 $\mu$m.

When such an inorganic stratiform compound particle having a large aspect ratio is incorporated into the protective layer, strength of coated layer increases and penetration of oxygen or moisture can be effectively inhibited so that the protective layer can be prevented from deterioration due to deformation, and even when the lithographic printing plate precursor is preserved for a long period of time under a high humidity condition, it is prevented from decrease in the image-forming property thereof due to the change of humidity and exhibits excellent preservation stability.

The content of the inorganic stratiform compound in the protective layer is preferably from 5/1 to 1/00 in terms of weight ratio to the amount of binder used in the protective layer. When a plurality of inorganic stratiform compounds is used in combination, it is also preferred that the total amount of the inorganic stratiform compounds fulfills the above-described weight ratio.

An example of common dispersing method for the inorganic stratiform compound used in the protective layer is described below. Specifically, from 5 to 10 parts by weight of a swellable stratiform compound that is exemplified as a preferred inorganic stratiform compound is added to 100 parts by weight of water to adapt the compound to water and to be swollen, followed by dispersing using a dispersing machine. The dispersing machine used include, for example, a variety of mills conducting dispersion by directly applying mechanical power, a high-speed agitation type dispersing machine providing a large shear force and a dispersion machine providing ultrasonic energy of high intensity. Specific examples thereof include a ball mill, a sand a grinder mill, a visco mill, a colloid mill, a homogenizer, a dissolver, a polytron, a homomixer, a homoblender, a keddy mill, a jet agitor, a capillary type emulsifying device, a liquid siren, an electromagnetic strain type ultrasonic generator and an emulsifying device having Polman whistle. A dispersion containing

from 5 to 10% by weight of the inorganic stratiform compound thus prepared is highly viscous or gelled and exhibits extremely good preservation stability. In the formation of a coating solution for protective layer using the dispersion, it is preferred that the dispersion is diluted with water, sufficiently stirred and then mixed with a binder solution.

To the coating solution for protective layer can be added known additives, for example, a surfactant for improving coating property or a water-soluble plasticizer for improving physical property of coated layer in addition to the inorganic stratiform compound. Examples of the water-soluble plasticizer include propionamide, cyclohexanediol, glycerin or sorbitol. Also, a water-soluble (meth)acrylic polymer can be added. Further, to the coating solution may be added known additives for increasing adhesion to the photosensitive layer or for improving time-lapse stability of the coating solution.

The coating solution for protective layer thus-prepared is coated on the photosensitive layer provided on the support and then dried to form a protective layer. The coating solvent may be appropriately selected in view of the binder used, and when a water-soluble polymer is used, distilled water or purified water is preferably used as the solvent. A coating method of the protective layer is not particularly limited, and known methods, for example, methods described in U.S. Patent 3,458,311 and JP-B-55-49729 can be applied. Specific examples of the coating method for the protective layer include a blade coating method, an air knife coating method, a gravure coating method, a roll coating method, a spray coating method, a dip coating method and a bar coating method.

A coating amount of the protective layer is preferably in a range from 0.05 to 10 g/$m^2$ in terms of the coating amount after drying. When the protective layer contains the inorganic stratiform compound, it is more preferably in a range from 0.1 to 0.5 g/$m^2$, and when the protective layer does not contain the inorganic stratiform compound, it is more preferably in a range from 0.5 to 5 g/$m^2$.

[Support]

The support for use in the lithographic printing plate precursor according to the invention is not particularly restricted as long as it is a dimensionally stable plate-like hydrophilic support. The support includes, for example, paper, paper laminated with plastic (for example, polyethylene, polypropylene or polystyrene), a metal plate (for example, aluminum, zinc or copper plate), a plastic film (for example, cellulose diacetate, cellulose triacetate, cellulose propionate, cellulose butyrate, cellulose acetatebutyrate, cellulose nitrate, polyethylene terephthalate, polyethylene, polystyrene, polypropylene, polycarbonate or polyvinyl acetal film) and paper or a plastic film laminated or deposited with the metal described above. Preferable examples of the support include a polyester film and an aluminum plate. Among them, the aluminum plate is preferred since it has good dimensional stability and is relatively inexpensive.

The aluminum plate includes a pure aluminum plate, an alloy plate comprising aluminum as a main component and containing a trace amount of hetero elements and a thin film of aluminum or aluminum alloy laminated with plastic. The hetero element contained in the aluminum alloy includes, for example, silicon, iron, manganese, copper, magnesium, chromium, zinc, bismuth, nickel and titanium. The content of the hetero element in the aluminum alloy is preferably 10% by weight or less. Although a pure aluminum plate is preferred in the invention, since completely pure aluminum is difficult to be produced in view of the refining technique, the aluminum plate may slightly contain the hetero element. The composition is not specified for the aluminum plate and those materials known and used conventionally can be appropriately utilized.

The thickness of the support is preferably from 0.1 to 0.6 mm, more preferably from 0.15 to 0.4 mm, and still more preferably from 0.2 to 0.3 mm.

Prior to the use of aluminum plate, a surface treatment, for example, roughening treatment or anodizing treatment is preferably performed. The surface treatment facilitates improvement in the hydrophilic property and ensures adhesion between the photosensitive layer and the support. In advance of the roughening treatment of the aluminum plate, a degreasing treatment, for example, with a surfactant, an organic solvent or an aqueous alkaline solution is conducted for removing rolling oil on the surface thereof, if desired.

The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively).

As the method of the mechanical roughening treatment, a known method, for example, a ball grinding method, a brush grinding method, a blast grinding method or a buff grinding method can be used.

The electrochemical roughening treatment method includes, for example, a method of conducting it by passing alternating current or direct current in an electrolyte containing an acid, for example, hydrochloric acid or nitric acid. Also, a method of using a mixed acid described in JP-A-54-63902 can be used.

The aluminum plate after the roughening treatment is then subjected, if desired, to an alkali etching treatment using an aqueous solution, for example, of potassium hydroxide or sodium hydroxide and further subjected to a neutralizing treatment, and then subjected to an anodizing treatment in order to enhance the abrasion resistance, if desired.

As the electrolyte used for the anodizing treatment of the aluminum plate, various electrolytes capable of forming

porous oxide film can be used. Ordinarily, sulfuric acid, hydrochloric acid, oxalic acid, chromic acid or a mixed acid thereof is used. The concentration of the electrolyte can be appropriately determined depending on the kind of the electrolyte.

Since the conditions of the anodizing treatment are varied depending on the electrolyte used, they cannot be defined generally. However, it is ordinarily preferred that electrolyte concentration in the solution is from 1 to 80% by weight, liquid temperature is from 5 to 70°C, current density is from 5 to 60 A/dm$^2$, voltage is from 1 to 100 V, and electrolysis time is from 10 seconds to 5 minutes. The amount of the anodized film formed is preferably from 1.0 to 5.0 g/m$^2$ and more preferably from 1.5 to 4.0 g/m$^2$. In the above-described range, good printing durability and favorable scratch resistance in the non-image area of lithographic printing plate can be achieved.

The aluminum plate subjected to the surface treatment and having the anodized film is used as it is as the support in the invention. However, in order to more improve adhesion to a layer provided thereon, hydrophilicity, resistance to stain, heat insulating property or the like, other treatment, for example, a treatment for enlarging micropores or a sealing treatment of micropores of the anodized film described in JP-A-2001-253181 and JP-A-2001-322365, or a surface hydrophilizing treatment by immersing in an aqueous solution containing a hydrophilic compound, may be appropriately conducted. Needless to say, the enlarging treatment and sealing treatment are not limited to those described in the above-described patents and any conventionally known method may be employed.

As the sealing treatment, as well as a sealing treatment with steam, a sealing treatment with an aqueous solution containing an inorganic fluorine compound, for example, fluorozirconic acid alone or sodium fluoride, a sealing treatment with steam having added thereto lithium chloride or a sealing treatment with hot water may be employed.

Among them, the sealing treatment with an aqueous solution containing an inorganic fluorine compound, the sealing treatment with water vapor and a sealing treatment with hot water are preferred.

The hydrophilizing treatment includes an alkali metal silicate method described in U.S. Patents 2,714,066, 3,181,461, 3,280,734 and 3,902,734. In the method, the support is subjected to immersion treatment or electrolytic treatment in an aqueous solution, for example, of sodium silicate. In addition, the hydrophilizing treatment includes, for example, a method of treating with potassium fluorozirconate described in JP-B-36-22063 and a method of treating with polyvinylphosphonic acid described in U.S. Patents 3,276,868, 4,153,461, and 4,689,272.

In the case of using a support having a surface of insufficient hydrophilicity, for example, a polyester film, in the invention, it is desirable to coat a hydrophilic layer thereon to make the surface sufficiently hydrophilic. Examples of the hydrophilic layer preferably includes a hydrophilic layer formed by coating a coating solution containing a colloid of oxide or hydroxide of at least one element selected from beryllium, magnesium, aluminum, silicon, titanium, boron, germanium, tin, zirconium, iron, vanadium, antimony and a transition metal described in JP-A-2001-199175, a hydrophilic layer containing an organic hydrophilic matrix obtained by crosslinking or pseudo-crosslinking of an organic hydrophilic polymer described in JP-A-2002-79772, a hydrophilic layer containing an inorganic hydrophilic matrix obtained by sol-gel conversion comprising hydrolysis and condensation reaction of polyalkoxysilane and titanate, zirconate or aluminate and a hydrophilic layer comprising an inorganic thin layer having a surface containing metal oxide. Among them, the hydrophilic layer formed by coating a coating solution containing a colloid of oxide or hydroxide of silicon is preferred.

Further, in the case of using, for example, a polyester film as the support in the invention, it is preferred to provide an antistatic layer on the hydrophilic layer side, opposite side to the hydrophilic layer or both sides. When the antistatic layer is provided between the support and the hydrophilic layer, it also contributes to improve the adhesion of the hydrophilic layer to the support. As the antistatic layer, a polymer layer having fine particles of metal oxide or a matting agent dispersed therein described in JP-A-2002-79772 can be used.

The support preferably has a center line average roughness of 0.10 to 1.2 μm. In the above-described range, good adhesion to the photosensitive layer, good printing durability, and good stain resistance can be achieved.

The color density of the support is preferably from 0.15 to 0.65 in terms of the reflection density value. In the above-described range, good image-forming property by preventing halation at the image exposure and good aptitude for plate inspection after development can be achieved.

[Undercoat layer]

In the lithographic printing plate precursor according to the invention, an undercoat layer comprising a compound having a polymerizable group is preferably provided on the support. When the undercoat layer is used, the photosensitive layer is provided on the undercoat layer. The undercoat layer has the effects of strengthening adhesion between the support and the photosensitive layer in the exposed area and facilitating separation of the photosensitive layer from the support in the unexposed area, thereby improving the developing property.

Specific preferable examples of the undercoat layer include a silane coupling agent having an addition-polymerizable ethylenic double bond reactive group described in JP-A-10-282679, and a phosphorus compound having an ethylenic double bond reactive group described in JP-A-2-304441. A particularly preferred compound is a compound having both a polymerizable group, for example, a methacryl group or an allyl group and a support-adsorbing group, for

example, a sulfonic acid group, a phosphoric acid group or a phosphoric acid ester group. Also, a compound having a hydrophilicity-imparting group, for example, an ethylene oxide group, in addition to the polymerizable group and the support-adsorbing group, can be preferably used.

A coating amount (solid content) of the undercoat layer is preferably from 0.1 to 100 mg/$m^2$, more preferably from 1 to 30 mg/$m^2$.

[Backcoat layer]

After applying the surface treatment to the support or forming the undercoat layer on the support, a backcoat layer can be provided on the back surface of the support, if desired.

The back coat layer preferably includes, for example, a coating layer comprising an organic polymer compound described in JP-A-5-45885, and a coating layer comprising a metal oxide obtained by hydrolysis and polycondensation of an organic metal compound or an inorganic metal compound described in JP-A-6-34174. Among them, use of an alkoxy compound of silicon, for example, $Si(OCH_3)_4$, $Si(OC_2H_5)_4$, $Si(OC_3H_7)_4$ or $Si(OC_4H_9)_4$ is preferred since the starting material is inexpensive and easily available.

[Plate-making method]

The lithographic printing plate precursor according to the invention is exposed imagewise by a light source of 350 to 450 nm, and then rubbed a surface of the exposed lithographic printing plate precursor with a rubbing member in the presence of a developer having pH of 2 to 10 in an automatic processor to remove the protective layer and the unexposed area of the photosensitive layer together, whereby an image can be formed on the surface of support.

Specifically, after removing the protective layer and the unexposed area of the photosensitive layer together, the resulting printing plate is immediately mounted on a printing machine to conduct printing.

The processing by the automatic processor in such a manner is advantageous in view of being free from the measures to development scum resulting from the protective layer and photosensitive layer encountered in case of on-machine development.

The developer for use in the invention is an aqueous solution having pH of 2 to 10. For instance, the developer is preferably water alone or an aqueous solution containing water as a main component (containing 60% by weight or more of water). Particularly, an aqueous solution having the same composition as conventionally known dampening water, an aqueous solution containing a surfactant (for example, an anionic, nonionic or cationic surfactant) and an aqueous solution containing a water-soluble polymer compound are preferable. An aqueous solution containing both a surfactant and a water-soluble polymer compound is especially preferable. The pH of the developer is preferably from 3 to 8, and more preferably from 4 to 7.

In the case of using an acidic to neutral developer, the developer preferably includes either an organic acid or an inorganic acid. By incorporating the organic acid or inorganic acid into the developer, the developing property can be improved at the plate-making and the occurrence of stain in the non-image area of a printing plate obtained by the plate-making can be prevented.

The anionic surfactant for use in the developer according to the invention includes, for example, fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkylphenoxypolyoxy ethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, dialkylsulfosuccinic acid salts, alkyl sulfate ester salts and alkylnaphthalenesulfonic acid salts are particularly preferably used.

The cationic surfactant for use in the developer according to the invention is not particularly limited and conventionally known cationic surfactants can be used. Examples of the cationic surfactant include alkylamine salts, quaternary ammonium salts, polyoxyethylene alkyl amine salts and polyethylene polyamine derivatives.

The nonionic surfactant for use in the developer according to the invention includes, for example, polyethylene glycol type higher alcohol ethylene oxide addacts, alkylphenol ethylene oxide addacts, fatty acid ethylene oxide addacts, polyhydric alcohol fatty acid ester ethylene oxide addacts, higher alkylamine ethylene oxide addacts, fatty acid amide ethylene oxide addacts, ethylene oxide addacts of fat, polypropylene glycol ethylene oxide addacts, dimethylsiloxane-ethylene oxide block copolymers, dimethylsiloxane-(propylenc oxide-ethylene oxide) block copolymers, fatty acid esters

of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines.

The nonionic surfactants may be used individually or as a mixture of two or more thereof. In the invention, ethylene oxide addacts of sorbitol and/or sorbitan fatty acid esters, polypropylene glycol ethylene oxide addacts, dimethylsitoxane-ethylene oxide block copolymers, dimethylsiloxane-(propylene oxide-ethylene oxide) block copolymers and fatty acid esters of polyhydric alcohols are more preferred.

Further, from the standpoint of stable solubility in water or opacity, with respect to the nonionic surfactant used in the developer according to the invention, the HLB (hydrophile-lipophile balance) value thereof is preferably 6 or more, and more preferably 8 or more. Moreover, an amount of the nonionic surfactant contained in the developer is preferably from 0.01 to 10% by weight, and more preferably from 0.01 to 5% by weight.

Furthermore, an oxyethylene adduct of acetylene glycol type or acetylene alcohol type or a surfactant, for example, a fluorine-based surfactant or a silicon-based surfactant can also be used.

Of the surfactants used in the developer according to the invention, the nonionic surfactant is particularly preferred in view of foam depressing property.

The water-soluble polymer compound for use in the developer according to the invention includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer and a styrene/maleic anhydride copolymer.

As the soybean polysaccharide, those known can be used. For example, as a commercial product, Soyafive (trade name, produced by Fuji Oil Co., Ltd.) is available and various grade products can be used. The soybean polysaccharide preferably used has viscosity in a range from 10 to 100 mPa/sec in a 10% by weight aqueous solution thereof.

As the modified starch, those known can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more of the water-soluble polymer compounds may be used in combination. The content of the water-soluble polymer compound is preferably from 0.1 to 20% by weight, and more preferably from 0.5 to 10% by weight in the developer.

The developer for use in the invention may contain an organic solvent. The organic solvent that can be contained in the developer include, for example, an aliphatic hydrocarbon (e.g., hexane, heptane, Isopar E, Isopar H, Isopar G (produced by Esso Chemical Co., Ltd.), gasoline or kerosene), an aromatic hydrocarbon (e.g., toluene or xylene), a halogenated hydrocarbon (methylene dichloride, ethylene dichloride, trichlene or nomochlorobenzene) and a polar solvent.

Examples of the polar solvent include an alcohol (e.g., methanol, ethanol, propanol, isopropanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, dipropylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine or N-phenyldiethanolamine).

Further, when the organic solvent is insoluble in water, it may be employed by being solubilized in water using a surfactant or the like. In the case where the developer contains the organic solvent, the concentration of the organic solvent is desirably less than 40% by weight in view of safety and inflammability.

Into the developer for use in the invention, an antiseptic agent, a chelating agent, a defoaming agent, an organic acid, an inorganic acid, an inorganic salt or the like can be incorporated in addition to the above components.

As the antiseptic agent, for example, phenol or a derivative thereof, formalin, an imidazole derivative, sodium dehydroacetate, a 4-isothiazolin-3-one derivative, benzisotiazolin-3-one, a benzotriazole derivative, an amidine guanidine derivative, a quaternary ammonium salt, a pyridine derivative, a quinoline derivative, a guanidine derivative, diazine, a triazole derivative, axazole, an oxazine derivative and a nitro bromo alcohol, e.g., 2-bromo-2-nitropropane-1,3-diol, 1,1-dibromo-1-nitro-2-ethanol or 1,1-dibromo-1-nitro-2-propanol are preferably used.

As the chelating agent, for example, ethylenediaminetetraacetic acid, potassium salt thereof sodium salt thereof; diethylenetriaminepentaacetic acid, potassium salt thereof, sodium salt thereof; triethylenetetraminehexaacetic acid, potassium salt thereof, sodium salt thereof; hydroxyethylethylenediaminetriacetic acid, potassium salt thereof, sodium salt thereof; nitrilotriacetic acid, sodium salt thereof; organic phosphonic acids, for example, 1-hydroxyethane-1,1-diphosphonic acid, potassium salt thereof, sodium salt thereof; aminotri(methylenephosphonic acid), potassium salt thereof, sodium salt thereof; and phophonoalkanetricarboxylic acids are illustrated. A salt of an organic amine is also effectively used in place of the sodium salt or potassium salt in the chelating agents.

As the defoaming agent, for example, a conventional silicone-based self-emulsifying type or emulsifying type defoaming agent, and a nonionic surfactant having HLB of 5 or less are used. The silicone defoaming agent is preferably used. Any of emulsifying dispersing type and solubilizing type can be used.

As the organic acid, for example, citric acid, acetic acid, oxalic acid, malonic acid, salicylic acid, caprylic acid, tartaric acid, malic acid, lactic acid, levulinic acid, p-toluencsulfonic acid, xylenesulfonic acid, phytic acid and an organic phosphonic acid are illustrated. The organic acid can also be used in the form of an alkali metal salt or an ammonium salt.

As the inorganic acid and inorganic salt, for example, phosphoric acid, methaphosphoric acid, ammonium primary phosphate, ammonium secondary phosphate, sodium primary phosphate, sodium secondary phosphate, potassium primary phosphate, potassium secondary phosphate, sodium tripolyphosphate, potassium pyrophosphate, sodium hexamethaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate and nickel sulfate are illustrated.

The developer described above can be used as a developer and a development replenisher for an exposed negative-working lithographic printing plate precursor, and it is preferably applied to an automatic processor described hereinafter. In the case of conducting the development processing using an automatic processor, the developer becomes fatigued in accordance with the processing amount, and hence the processing ability may be restored using a replenisher or a fresh developer. Such a replenishment system can be preferably applied to the plate-making method of the lithographic printing plate precursor according to the invention.

The development processing using the aqueous solution having pH of 2 to 10 according to the invention is performed by an automatic processor equipped with a supplying means for the developer and a rubbing member. As the automatic processor, there are illustrated an automatic processor in which a lithographic printing plate precursor after image-recording is subjected to rubbing treatment while it is transporting as described in JP-A-2-220061 and JP-A-60-59351, and an automatic processor in which a lithographic printing plate precursor after image-recording placed on a cylinder is subjected to rubbing treatment while rotating the cylinder as described in U.S. Patents 5,148,746 and 5,568,768 and British Patent 2,297,719. Among them, the automatic processor using a rotating brush roll as the rubbing member is particularly preferred.

The rotating brush roller which can be preferably used in the invention can be appropriately selected by taking account, for example, of scratch resistance of the image area and nerve strength of the support of the lithographic printing plate precursor. As for the rotating brush roller, a known rotating brush roller produced by implanting a brush material in a plastic or metal roller can be used. For example, a rotating brush roller described in JP-A-58-159533 and JP-A-3-100554, or a brush roller described in Jp-U-B-62-167253 (the term "JP-UM-B" as used herein means an "examined Japanese utility model publication"), in which a metal or plastic groove-type member having implanted therein in rows a brush material is closely radially wound around a plastic or metal roller acting as a core, can be used.

As the brush material, a plastic fiber (for example, a polyester-based synthetic fiber, e.g., polyethylene terephthalate or polybutylene terephthalate; a polyamide-based synthetic fiber, e.g., nylon 6.6 or nylon 6.10); a polyacrylic synthetic fiber, e.g., polyacrylonitrile or polyalkyl (meth)acrylate; and a polyolefin-based synthetic fiber, e.g., polypropylene or polystyrene) can be used. For instance, a brush material having a fiber bristle diameter of 20 to 400 μm and a bristle length of 5 to 30 mm can be preferably used.

The outer diameter of the rotating brush roller is preferably from 30 to 200 mm, and the peripheral velocity at the tip of the brush rubbing the plate surface is preferably from 0.1 to 5 m/sec.

Further, it is preferred to use a plurality, that is, two or more of the rotating brush rollers.

The rotary direction of the rotating brush roller for use in the invention may be the same direction or the opposite direction with respect to the transporting direction of the lithographic printing plate precursor of the invention, but when two or more rotating brush rollers are used as in an automatic processor shown in Fig. 1, it is preferred that at least one rotating brush roller rotates in the same direction and at least one rotating brush roller rotates in the opposite direction with respect to the transporting direction. By such arrangement, the photosensitive layer in the non-image area can be more steadily removed. Further, a technique of rocking the rotating brush roller in the rotation axis direction of the brush roller is also effective.

The developer can be used at an appropriate temperature, and the developer temperature is preferably from 10 to 50°C.

In the invention, the lithographic printing plate after the rubbing treatment may be subsequently subjected to water washing, drying treatment and oil-desensitization treatment, if desired. In the oil-desensitization treatment, a known oil-desensitizing solution can be used.

Further, in a plate-making process of the lithographic printing plate precursor to prepare a lithographic printing plate according to the invention, the entire surface of the lithographic printing plate precursor may be heated, if desired,

before or during the exposure or between the exposure and the development. By the heating, the image-forming reaction in the photosensitive layer is accelerated and advantages, for example, improvement in the sensitivity and printing durability and stabilization of the sensitivity are achieved. For the purpose of increasing the image strength and printing durability, it is also effective to perform entire after-heating or entire exposure of the image after the development. Ordinarily, the heating before the development is preferably performed under a mild condition of 150°C or lower. When the temperature is too high, a problem may arise in that undesirable fog occurs in the non-image area. On the other hand, the heating after the development can be performed using a very strong condition. Ordinarily, the heat treatment is carried out in a temperature range of 200 to 500°C. When the temperature is too low, a sufficient effect of strengthening the image may not be obtained, whereas when it is excessively high, problems of deterioration of the support and thermal decomposition of the image area may occur.

The plate-making process is described in more detail below,

In the invention, although the development processing can be carried out just after the exposure step, the heat treatment step may intervene between the exposure step and the development step as described above. The heat treatment is effective for increasing the printing durability and improving uniformity of the image hardness degree in the entire surface of printing plate precursor. The conditions of the heat treatment can be appropriately determined in a range for providing such effects. Examples of the heating means include a conventional convection oven, an IR irradiation apparatus, an IR laser, a microwave apparatus or a Wisconsin oven. For instance, the heat treatment can be conducted by maintaining the printing plate precursor at a plate surface temperature ranging from 70 to 150°C for a period of one second to 5 minutes, preferably at 80 to 140°C for 5 seconds to one minute, more preferably at 90 to 130°C for 10 to 30 seconds. In the above-described range, the effects described above are efficiently achieved and an adverse affect, for example, change in shape of the printing plate precursor due to the heat can be preferably avoided.

According to the invention, the development processing step is conducted after the exposure step, preferably after the exposure step and the heat treatment step to prepare a lithographic printing plate. It is preferable that a plate setter used in the exposure step, a heat treatment means used in the heat treatment step and a development apparatus used in the development processing step are connected with each other and the lithographic printing plate precursor is subjected to automatically continuous processing. Specifically, a plate-making line wherein the plate setter and the development apparatus are connected with each other by transport means, for example, a conveyer is illustrated. Also, the heat treatment means may be placed between the plate setter and the development apparatus or the heat treatment means and the development apparatus may constitute a unit apparatus.

In case where the lithographic printing plate precursor used is apt to be influenced by surrounding light under a working environment, it is preferable that the plate-making line is blinded by a filter, a cover or the like.

After the image formation as described above, the entire surface of lithographic printing plate may be exposed with active ray, for example, ultraviolet light to accelerate hardening of the image area. As a light source for the entire surface exposure, for example, a carbon arc lamp, a mercury lamp, a gallium lamp, a metal halide lamp, a xenon lamp, a tungsten lamp or various laser beams are exemplified. In order to obtain sufficient printing durability, the amount of the entire surface exposure is preferably 10 $mJ/cm^2$ or more, more preferably 100 $mJ/cm^2$ or more.

Heating may be performed at the same time with the entire surface exposure. By performing the heating, further improvement in the printing durability is recognized. Examples of the heating means include a conventional convection oven, an IR. irradiation apparatus, an IR laser, a microwave apparatus or a Wisconsin oven. The plate surface temperature at the heating is preferably from 30 to 150°C, more preferably from 35 to 130°C, and still more preferably from 40 to 120°C.

In advance of the above-described development processing, the lithographic printing plate precursor is imagewise exposed through a transparent original having a line image, a halftone dot image or the like, or imagewise exposed, for example, by scanning of laser beam based on digital data.

The desirable wavelength of the light source is from 350 to 450 nm, and specifically, an InGaN semiconductor laser is preferably used. The exposure mechanism may be any of an internal drum system, an external drum system and a flat bed system.

Other examples of the exposure light source which can be used in the invention include an ultra-high pressure mercury lamp, a high pressure mercury lamp, a medium pressure mercury lamp, a low pressure mercury lamp, a chemical lamp, a carbon arc lamp, a xenon lamp, a metal halide lamp, various visible or ultraviolet laser lamps, a fluorescent lamp, a tungsten lamp and sunlight.

As for the available laser light source of 350 to 450 nm, the followings can be used.

A gas laser, for example, Ar ion laser (364 nm, 351 nm, 10 mW to 1 W), Kr ion laser (356 nm, 351 nm, 10 mW to 1 W) and He-Cd laser (441 nm, 325 nm, 1 mW to 100 mW); a solid laser, for example, a combination of Nd:YAG ($YVO_4$) with SHG crystalsxtwice (355 nm, 5 mW to 1 W) and a combination of Cr;LiSAF with SHG crystal (430 nm, 10 mW); a semiconductor laser system, for example, a $KNBOb_3$ ring resonator (430 nm, 30 mW), a combination of a waveguide-type wavelength conversion element with an AlGaAs or InGaAs semiconductor (380 nm to 450 nm, 5 mW to 100 mW), a combination of a waveguide-type wavelength conversion element with an AlGaInP or AlGaAs semiconductor (300 nm to 350 nm, 5 mW to 100 mW), and AlGaInN (350 nm to 450 nm, 5 mW to 30 mW); a pulse laser, for

example, $N_2$ laser (337 nm, pulse 0.1 to 10 mJ) and XeF (351 nm, pulse 10 to 250 mJ) can be used. Among the light sources, the AlGaInN semiconductor laser (commercially available InGaN semiconductor laser, 400 to 410 nm, 5 to 30 mW) is particularly preferable in view of the wavelength characteristics and cost.

As for the exposure apparatus for the lithographic printing plate precursor of scanning exposure system, the exposure mechanism includes an internal drum system, an external drum system and a flat bed system. As the light source, among the light sources described above, those capable of conducting continuous oscillation can be preferably utilized. In practice, the following exposure apparatuses are particularly preferred in view of the relationship between the sensitivity of photosensitive material and the time for plate-making.

A single beam to triple beam exposure apparatus of internal drum system, using one or more gas or solid laser light sources to provide a semiconductor laser having a total output of 20 mW or more.

A multi-beam (from 1 to 10 beams) exposure apparatus of flat bed system, using one or more semiconductor, gas or solid lasers to provide a total output of 20 mW or more.

A multi-beam (from 1 to 9 beams) exposure apparatus of external drum system, using one or more semiconductor, gas or solid lasers to provide a total output of 20 mW or more.

A multi-beam (10 or more beams) exposure apparatus of external drum system, using one or more semiconductor or solid lasers to provide a total output of 20 mW or more.

In the laser direct drawing-type lithographic printing plate precursor, the following equation (eq 1) is ordinarily established among the sensitivity X ($J/cm^2$) of photosensitive material, the exposure area S ($cm^2$) of photosensitive material, the power q (W) of one laser light source, the number n of lasers and the total exposure time t (s):

$$X \cdot S = n \cdot q \cdot t \qquad \text{(eq 1)}$$

i) In the case of the internal drum (single beam) system

The following equation (eq 2) is ordinarily established among the laser revolution number f (radian/s), the sub-scanning length Lx (cm) of photosensitive material, the resolution Z (dot/cm) and the total exposure time t (s):

$$f \cdot Z \cdot t = Lx \qquad \text{(eq 2)}$$

ii) In the case of the external drum (multi-beam) system

The following equation (eq 3) is ordinarily established among the drum revolution number F (radian/s), the sub-scanning length Lx (cm) of photosensitive material, the resolution Z (dot/cm), the total exposure time t (s) and the number (n) of beams:

$$F \cdot Z \cdot n \cdot t = Lx \qquad \text{(eq 3)}$$

iii) In the case of the flat bed (multi-beam) system

The following equation (eq 4) is ordinarily established among the revolution number H (radian/s) of polygon mirror, the sub-scanning length Lx (cm) of photosensitive material, the resolution Z (dot/cm), the total exposure time t (s) and the number (n) of beams:

$$H \cdot Z \cdot n \cdot t = Lx \qquad \text{(eq 4)}$$

When the resolution (2,560 dpi) required for a practical printing plate, the plate size (A1/B1, sub-scanning length; 42 inch), the exposure condition of about 20 sheets/hour and the photosensitive characteristics (photosensitive wavelength, sensitivity: about 0.1 $mJ/cm^2$) of the lithographic printing plate precursor according to the invention are substituted for the above equations, it can be understood that the lithographic printing plate precursor according to the invention is preferably combined with a multi-beam exposure system using a laser having a total output of 20 mW or more, and on taking account of operability, cost and the like, most preferably combined an external drum system semiconductor laser multi-beam (10 or more beams) exposure apparatus.

EXAMPLES

The present invention will be described in more detail with reference to the following examples, but the invention should not be construed as being limited thereto.

[Preparation of Support 1]

An aluminum plate (material: 1050) having a thickness of 0.3 mm was subjected to a degrease treatment with an aqueous 10% by weight sodium aluminate solution at 50°C for 30 seconds to remove rolling oil on the surface thereof. Thereafter, the aluminum plate surface was grained using three nylon brushes implanted with bundled bristles having a diameter of 0.3 mm and an aqueous suspension (specific gravity: 1.1 g/cm$^3$) of pumice having a median diameter of 25 μm, and then thoroughly washed with water. The plate was etched by dipping it in an aqueous 25% by weight sodium hydroxide solution at 45°C for 9 seconds and after washing with water, dipped in an aqueous 20% by weight nitric acid solution at 60°C for 20 seconds, followed by washing with water. The etching amount of the grained surface was about 3 g/m$^2$.

Subsequently, the aluminum plate was subjected to a continuous electrochemical surface roughening treatment using alternate current voltage of 60 Hz. The electrolytic solution used was an aqueous 1% by weight nitric acid solution (containing 0.5% by weight of aluminum ion) at a liquid temperature of 50°C. The electrochemical surface roughening treatment was performed using a rectangular wave alternate current having a trapezoidal waveform such that the time TP necessary for the current value to reach the peak from zero was 0.8 msec and the duty ratio was 1:1, and disposing a carbon electrode as the counter electrode. The auxiliary anode used was ferrite. The current density was 30 A/dm$^2$ in terms of the peak value of current, and 5% of the current flowing from the power source was divided to the auxiliary anode. The quantity of electricity at the nitric acid electrolysis was 175 C/dm$^2$ when the aluminum plate was serving as the anode. Then, the aluminum plate was washed with water by spraying.

Thereafter, the aluminum plate was subjected to an electrochemical surface roughening treatment in the same manner as in the nitric acid electrolysis above using, as the electrolytic solution, an aqueous 0.5% by weight hydrochloric acid solution (containing 0.5% by weight of aluminum ion) at a liquid temperature of 50°C under the conditions that the quantity of electricity was 50 C/dm$^2$ when the aluminum plate was serving as the anode, and then washed with water by spraying. The plate was then treated in an aqueous 15% by weight sulfuric acid solution (containing 0.5% by weight of aluminum ion) as the electrolytic solution at a current density of 15 A/dm$^2$ to provide a direct current anodic oxide film of 2.5 g/m$^2$, thereafter washed with water and dried.

The center line average roughness Ra (JIS B0601) of the thus-treated aluminum plate was measured using a stylus having a diameter of 2 μm and found to be 0.51 μm.

Further, Undercoat Solution (1) shown below was coated to have a dry coating amount of 10 mg/m$^2$ and dried in an oven at 80°C for 10 seconds to prepare a support having an undercoat layer.

<Undercoat Solution (1)>

| | |
|---|---|
| Undercoat Compound (1) shown below | 0.017 g |
| Methanol | 9.00 g |
| Water | 1.00 g |

Undercoat Compound (1):

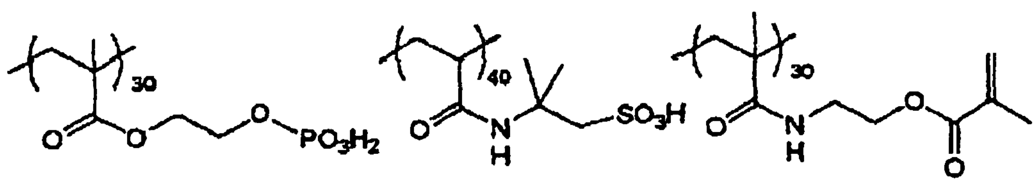

[Preparation of Lithographic Printing Plate Precursor (1)]

On the support having an undercoat layer prepared above, Coating Solution (1) for Photosensitive Layer having the composition shown below was coated using a bar and dried in an oven at 70°C for 60 seconds to form a photosensitive layer having a dry coating amount of 1.1 g/m$^2$. On the photosensitive layer, Coating Solution (1) for Protective Layer having the composition shown below was coated using a bar to have a dry coating amount of 0.75 g/m$^2$ and dried at 125°C for 70 seconds to prepare Lithographic Printing Plate Precursor (1).

<Coating Solution (1) for Photosensitive Layer>

| | |
|---|---|
| Binder Polymer (1) shown below | 0.54 g |
| Polymerizable compound: Isocyanuric acid EO-modified triacrylate (Aronics M-315, produced by Toa Gosei Co., Ltd.) | 0.40 g |
| Polymerizable compound: Ethoxylated trimethylolpropane triacrylate (SR9035, produced by Nippon Kayaku Co., Ltd.; EO addition molar number: 15; molecular weight: 1,000) | 0.08 g |
| Sensitizing Dye (I) shown below | 0.06 g |
| Polymerization Initiator (I) shown below | 0.18 g |
| Chain Transfer Agent (I) shown below | 0.07 g |
| Dispersion of ε-Phthalocyanine pigment: (pigment: 15 parts by weight; dispersing agent (Binder Polymer (1)): 10 parts by weight; solvent (cyclohexanone/methoxypropyl acetate/1-methoxy-2-propanol = 15 parts by weight/20 parts by weight/ 40 parts by weight)) | 0.40 g |
| Thermal polymerization inhibitor N-nitrosaphenylhydroxylamine aluminum salt | 0.01 g |
| Water-Soluble Fluorine-Based Surfactant (1) shown below | 0.001 g |
| Polyoxyethylene-polyoxypropylene condensate (Pluronic L44, produced by ADEKA Corp.) | 0.04 g |
| Tetraethylamine hydrochloride | 0.01 g |
| 1-Methoxy-2-propanol | 3.5 g |
| Methyl ethyl ketone | 8.0 g |

Binder Polymer (1):

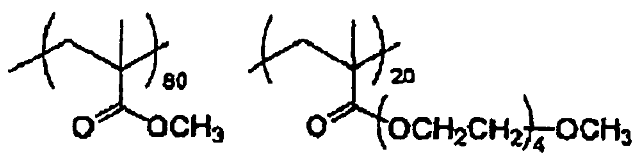

Sensitizing Dye (1):

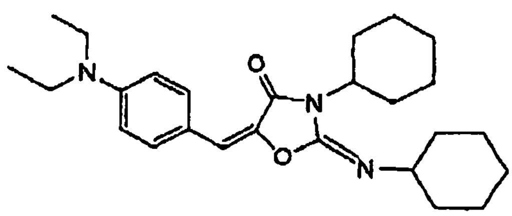

Polymerization Initiator (1)

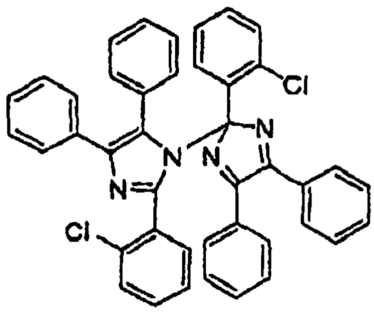

Chain Transfer Agent (1):

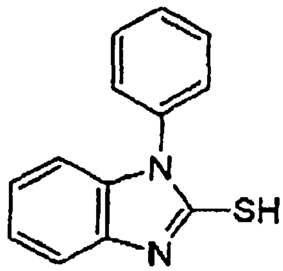

Fluorine-Based Surfactant (1):

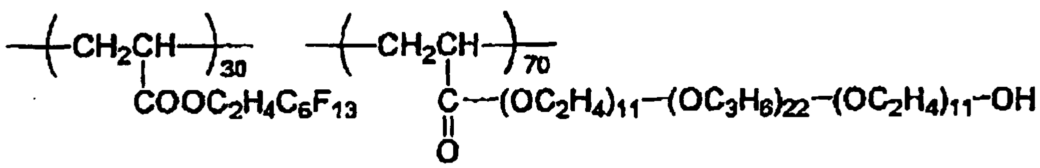

<Coating Solution (1) for Protective Layer>

| | |
|---|---|
| Polyvinyl alcohol (saponification degree: 98% by mole; polymerization degree: 500) | 40 g |
| Polyvinyl pyrrolidone (molecular weight: 50,000) | 5 g |
| Vinyl pyrrolidone/vinyl acetate (1/1) copolymer (molecular weight: 70,000) | 0.5 g |
| Surfactant (Emalex 710, produced by Nihon-Emulsion Co., Ltd.) | 0.5 g |
| Water | 950 g |

The oxygen transmission rate of the protective layer was measured in the manner described below and it was found to be 3.8 ml/($m^2$·day·atom).

(Measurement of Oxygen Transmission Rate)

On a surface of base paper for photographic printing paper having a thickness of 200 μm both surfaces of

which had been coated with polyethylene having a thickness of 20 μm was coated the protective layer in the same manner as described in the coating of protective layer on the photosensitive layer, followed by drying to prepare a sample for measurement. The oxygen transmission rate of the base paper for photographic printing paper previously measured was about 700 ml/($m^2$·day·atom) under the measurement conditions described below and it was a sufficiently negligible value for the measurement of the oxygen transmission rate of the protective layer.

Using the sample thus-prepared, the oxygen transmission rate [ml/(m2·day·atom)] was measured by OX-TRAN2/20 produced by Mocon Inc. according to the vapor permeation rate testing method described in JIS K7126B and ASTM D3985 under the conditions of 25°C and 60% RH.

[Preparation of Lithographic Printing Plate Precursor (2)]

Lithographic Printing Plate Precursor (2) was prepared in the same manner as in the preparation of Lithographic Printing Plate Precursor (1) except for changing Coating Solution (1) for Photosensitive Layer to Coating Solution (2) for Photosensitive Layer having the composition shown below.

| | |
|---|---|
| <Coating Solution (2) for Photosensitive Layer> | |
| Polymerization Initiator (1) shown above | 0.2 g |
| Sensitizing Dye (1) shown above | 0.1 g |
| Binder Polymer (1) shown above (average molecular weight: 80,000) | 3.0 g |
| Polymerizable compound: | 6.2 g |
| Isocyanuric acid EO-modified diacrylate (Aronics M-215, produced by Toa Gosei Co., Ltd.) | |
| Leuco Crystal Violet | 0.2 g |
| Fluorine-based Surfactant (1) shown above | 0.1 g |
| Dispersion of Microcapsule (1) shown below | 25.0 g |
| Methyl ethyl ketone | 35.0 g |
| 1-Methoxy-2-propanol | 35.0 g |

(Preparation of Dispersion of Microcapsule (1))

As an oil phase component, 10 g of adduct of trimethylolpropane and xylene diisocyanate (Takenate D-110N, produced by Mitsui Takeda Chemicals, Inc.), 4.15 g of isocyanuric acid EO-modified diacrylate (Aronics M-215, produced by Toa Gosei Co., Ltd.) and 0.1 g of Pionin A-4IC (produced by Takemoto Oil & Fat Co., Ltd.) were dissolved in 17 g of ethyl acetate. As an aqueous phase component, 40 g of an aqueous 4% by weight PVA-205 solution was prepared. The oil phase component and the aqueous phase component were mixed and emulsified using a homogenizer at 12,000 rpm for 10 minutes. The resulting emulsion was added to 25 g of distilled water and the mixture was stirred at room temperature for 30 minutes and then stirred at 40°C for 3 hours. The thus-obtained microcapsule solution was diluted with distilled water to have a solid content concentration of 20 % by weight to prepare Dispersion of Microcapsule (1). The average particle diameter of the microcapsule was 0.25 μm.

[Preparation of Lithographic Printing Plate Precursor (3)]

Lithographic Printing Plate Precursor (3) was prepared in the same manner as in the preparation of Lithographic Printing Plate Precursor (1) except for changing Sensitizing Dye (1) in Coating Solution (1) for Photosensitive Layer to Sensitizing Dye (2) shown below.

[Preparation of Lithographic Printing Plate Precursor (4)]

Lithographic Printing Plate Precursor (4) was prepared in the same manner as in the preparation of Lithographic Printing Plate Precursor (1) except for changing Sensitizing Dye (1) in Coating Solution (1) for Photosensitive Layer to Sensitizing Dye (3) shown below.

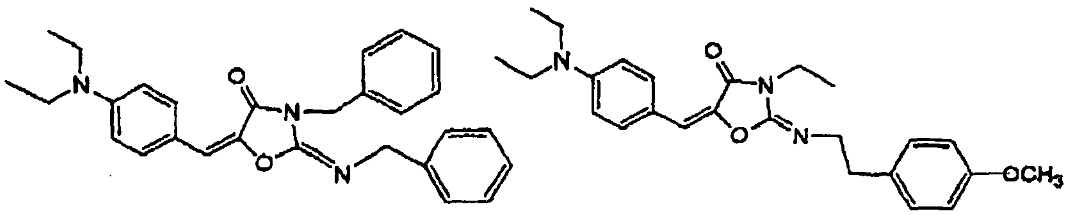

Sensitizing Dye (2) Sensitizing Dye (3)

[Preparation of Lithographic Printing Plate Precursor (5)]

Lithographic Printing Plate Precursor (5) was prepared in the same manner as in the preparation of Lithographic Printing Plate Precursor (1) except for changing Polymerizable Compound (1): Aronics M-315 in Coating Solution (1) for Photosensitive Layer to PLEX6661-O (7,7,9-trimethyl-4,13-dioxo-3,14-dioxa-5,12-diazahexadecane-1,16-diyldimethacrylate, produced by Rahm GmbH & Co. KG).

[Preparation of Lithographic Printing Plate Precursor (6)]

Lithographic Printing Plate Precursor (6) was prepared in the same manner as in the preparation of Lithographic Printing Plate Precursor (1) except for changing Binder polymer (1) in Coating Solution (1) for Photosensitive Layer to Binder polymer (2) shown below.

[Preparation of Lithographic Printing Plate Precursor (7)]

Lithographic Printing Plate Precursor (7) was prepared in the same manner as in the preparation of Lithographic Printing Plate Precursor (1) except for changing Binder polymer (1) in Coating Solution (1) for Photosensitive Layer to Binder polymer (3) shown below.

[Preparation of Lithographic Printing Plate Precursor (8)]

Lithographic Printing Plate Precursor (8) was prepared in the same manner as in the preparation of Lithographic Printing Plate Precursor (1) except for changing Binder polymer (1) in Coating Solution (1) for Photosensitive Layer to Binder polymer (4) shown below.

Binder polymer (2):

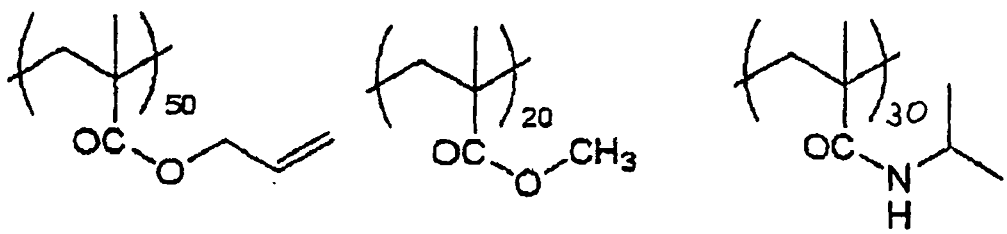

Binder polymer (3):

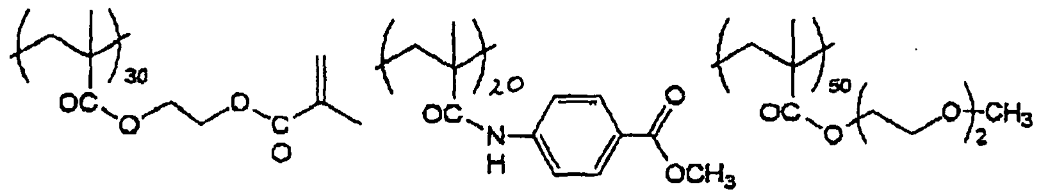

Binder polymer (4):

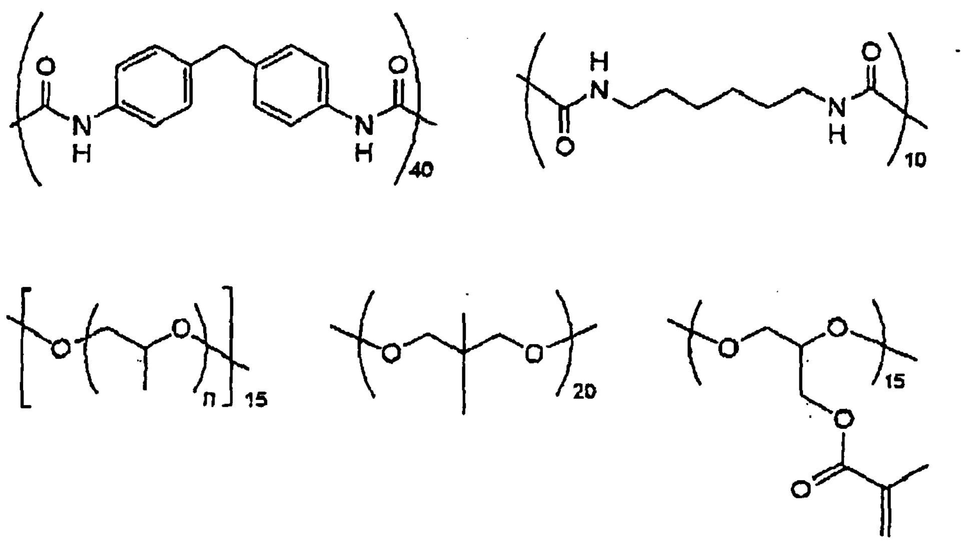

[Preparation of Lithographic Printing Plate Precursor (9)]

Lithographic Printing Plate Precursor (9) was prepared in the same manner as in the preparation of Lithographic Printing Plate Precursor (1) except for changing Chain Transfer Agent (1) in Coating Solution (I) for Photosensitive Layer to Chain Transfer Agent (2) shown below.

Chain Transfer Agent (2):

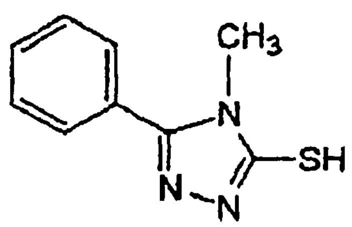

[Preparation of Lithographic Printing Plate Precursor (10)]

Lithographic Printing Plate Precursor (10) was prepared in the same manner as in the preparation of Lithographic Printing Plate Precursor (1) except for changing Coating Solution (1) for Protective Layer to Coating Solution (2) for Protective Layer shown below and coating using a bar to have a dry coating amount of 0.2 g/m$^2$.

<Coating Solution (2) for Protective Layer>

| | |
|---|---|
| Dispersion of Mica (1) shown below | 13.0 g |
| Polyvinyl alcohol (saponification degree: 98% by mole; polymerization degree: 500) | 1.3 g |
| Sodium 2-ethylhexylsulfosuccinate | 0.2 g |
| Vinyl pyrrolidone/vinyl acetate (1/1) copolymer (molecular weight: 70,000) | 0.05 g |
| Surfactant (Emalex 710, produced by Nihon-Emulsion Co., Ltd.) | 0.05 g |
| Water | 133 g |

(Preparation of Dispersion ofMica (1))

In 368 g of water was added 32 g of synthetic mica (SOMASIF ME-100, produced by CO-OP Chemical Co., Ltd.; aspect ratio; 1,000 or more) and dispersed using a homogenizer until the average particle diameter (measured by a laser scattering method) became 0.5 μm to obtain Dispersion of Mica (1).

The oxygen transmission rate of the protective layer was measured in the manner described above and it was found to be 2.0 ml/($m^2$·day·atom).

[Preparation of Lithographic Printing Plate Precursor (11)]

Lithographic Printing Plate Precursor (11) was prepared in the same manner as in the preparation of Lithographic Printing Plate Precursor (1) except for changing Coating Solution (1) for Protective Layer to Coating Solution (3) for Protective Layer shown below and coating using a bar to have a dry coating amount of 1.5 g/$m^2$.

<Coating Solution (3) for Protective Layer>

| | |
|---|---|
| Polyvinyl alcohol (saponification degree: 88% by mole; polymerization degree: 500) | 44 g |
| Polyvinyl pyrrolidone (molecular weight: 50,000) | 1 g |
| Vinyl pyirolidone/vinyl acetate (1/1) copolymer (molecular weight: 70,000) | 0.5 g |
| Surfactant (Emalex 710, produced by Nihon-Emulsion Co., Ltd.) | 0.5 g |
| Surfactant (Pionin D-230, produced by Takemoto Oil & Fat Co., Ltd.) | 0.5 g |
| Water | 950 g |

The oxygen transmission rate of the protective layer was measured in the manner described above and it was found to be 9.2 ml/($m^2$·day·atom).

[Preparation of Lithographic Printing Plate Precursor (12)]

Lithographic Printing Plate Precursor (12) was prepared in the same manner as in the preparation of Lithographic Printing Plate Precursor (1) except for changing Support 1 to Support 2 shown below.

[Preparation of Support 2]

An aluminum plate having a thickness of 0.3 mm was etched by dipping in an aqueous 10% by weight sodium hydroxide solution at 60°C for 25 seconds, washed with running water, neutralized and cleaned with an aqueous 20% by weight nitric acid solution and then washed with water. The aluminum plate was subjected to an electrolytic surface roughening treatment in an aqueous 1 % by weight nitric acid solution using an alternating current with a sinusoidal waveform at an anode time electricity of 300 coulomb/$dm^2$. Subsequently, the aluminum plate was dipped in an aqueous 1% by weight sodium hydroxide solution at 40°C for 5 seconds, dipped in an aqueous 30% by weight sulfuric acid solution at 60°C for 40 seconds to effect a desmut treatment, and then subjected to an anodizing treatment in an aqueous 20% by weight sulfuric acid solution for 2 minutes at a current density of 2 A/$dm^2$ to form an anodic oxide film having a thickness of 2.7 g/$m^2$. The center line average roughness Ra of the surface of the aluminum plate was measured and found to be 0.3 μm.

On the aluminum plate thus-treated was coated Undercoat Solution (2) shown below using a bar to have a dry coating amount of 10 mg/$m^2$, followed by drying at 80°C for 20 seconds, thereby preparing Support 2,

| | |
|---|---|
| <Undercoat Solution (2)> | |
| Sol solution shown below | 100 g |
| Methanol | 900 g |

Sol Solution

| | |
|---|---|
| Phosmer PE (produced by Uni-Chemical Co., Ltd) | 5 g |
| Methanol | 45 g |
| Water | 10 g |
| Phosphoric acid (85% by weight) | 5 g |
| Tetraethoxysilane | 20 g |
| 3-Methacryloxypropyltrimethoxysilane | 15 g |

EXAMPLES 1 TO 12

(1) Exposure, Development and Printing

Each of Lithographic Printing Plate Precursors (1) to (12) was subjected to imagewise exposure using a semiconductor laser of 405 nm having an output of 100 mW while changing energy density.

Then, development processing was performed in an automatic development processor having a structure shown in Fig. 1 using Developer (1) having the composition shown below. The pH of the developer was 5. The automatic development processor was an automatic processor having two rotating brush rollers. As for the rotating brush rollers used, the first brush roller was a brush roller having an outer diameter of 90 mm and being implanted with fiber of polybutylene terephthalate (bristle diameter: 200 μm, bristle length: 17 mm), and the brush roller was rotated at 200 rpm in the same direction as the transporting direction (peripheral velocity at the tip of brush: 0.94 m/sec). The second brush roller was a brush roller having an outer diameter of 60 mm and being implanted with fiber of polybutylene terephthalate (bristle diameter: 200μm, bristle length: 17 mm), and the brush roller was rotated at 200 rpm in the counter direction to the transporting direction (peripheral velocity at the tip of brush: 0.63 m/sec). The transportation of the lithographic printing plate precursor was performed at a transporting speed of 100 cm/min.

The developer was supplied on the surface of the lithographic printing plate precursor by showering from a spray pipe using a circulation pump. The tank volume for the developer was 10 liters.

Developer (1)

| | |
|---|---|
| Water | 100 g |
| Benzyl alcohol | 1 g |
| Polyoxyethylene naphthyl ether (average number of oxyethylene: n = 13) | 1 g |
| Sodium salt of dioctylsulfosuccirnic acid ester | 0.5 g |
| Gum arabic | 1 g |
| Ethylene glycol | 0.5 g |
| Ammonium primary phosphate | 0.45 g |
| Citric acid | 0.05 g |
| Tetrasodium salt of ethylenediaminetetraacetate | 0.05 g |

The lithographic printing plate after development was mounted on a printing machine, SOR-M, produced by Heidelberg, and printing was performed at a printing speed of 6,000 sheets per hour using dampening water (EU-3 (etching solution, produced by Fuji Photo Film Co., Ltd.))/water/isopropyl alcohol = 1/89/10 (by volume ratio)) and TRANS-G(N) black ink (produced by Dai-Nippon Ink & Chemicals, Inc.).

(2) Evaluation

Using the lithographic printing plate precursors prepared above, the sensitivity and safelight aptitude were evaluated in the following manner.

<Sensitivity>

After performing printing of 100 sheets as described above and confirming that a printed material free from ink stain in the non-image area was obtained, 500 sheets were continuously printed. Thus, 600 sheets in total were printed. The exposure amount for causing no unevenness in the ink density of the image area on the 600th printed material was determined and defined as the sensitivity.

<Safelight Aptitude>

The lithographic printing plate precursor prepared was exposed under a yellow lamp (a fluorescent lamp cutting wavelength of 500 nm or shorter; illuminance: 250 lux) for 30 minutes before image exposure and subsequently subjected to the image exposure and development processing in the same manner as described above. After the development processing, the non-image area of the lithographic printing plate was visually observed and the presence or absence of the formation of fog (residue of the photosensitive layer) was evaluated.

TABLE 1

| | Lithographic Printing Plate Precursor | Sensitivity ($mJ/cm^2$) | Safelight Aptitude |
|---|---|---|---|
| Example 1 | 1 | 0.10 | No fog formation |
| Example 2 | 2 | 0.15 | No fog formation |
| Example 3 | 3 | 0.10 | No fog formation |
| Example 4 | 4 | 0.12 | No fog formation |
| Example 5 | 5 | 0.07 | No fog formation |
| Example 6 | 6 | 0.08 | No fog formation |
| Example 7 | 7 | 0.08 | No fog formation |
| Example 8 | 8 | 0.06 | No fog formation |
| Example 9 | 9 | 0.10 | No fog formation |
| Example 10 | 10 | 0.07 | No fog formation |
| Example 11 | 11 | 0.15 | No fog formation |
| Example 12 | 12 | 0.12 | No fog formation |

EXAMPLES 13

The image exposure, development processing and printing were conducted in the same manner as in Example I except for changing the polyoxyethylene naphthyl ether used in Developer (1) to an anionic surfactant having the structure shown below and further adding 0.1 g of a defoaming agent, FS Antifoam DR110N (produced by Dow Coming Corp., silicone-based emulsion). As a result, the evaluation results similar to those in Example I were obtained.

Anionic Surfactant:

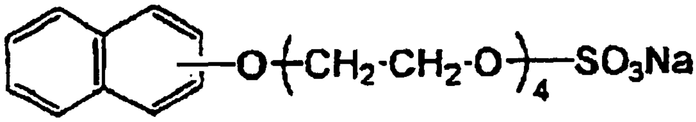

EXAMPLES 14

The image exposure, development processing and printing were conducted in the same manner as in Example 1 except for changing Developer (1) to Developer (2) having the composition shown below. As a result, the evaluation results similar to those in Example 1 were obtained,

Developer (2)

| | |
|---|---|
| Water | 100 g |
| Sodium alkylnaphthalenesulfonate (Pelex NB-L, produced by Kao Corp.) | 5 g |
| Gum arabic | 1 g |
| Ammonium primary phosphate | 0.05 g |
| Citric acid | 0.05 g |
| Tetrasodium salt of ethylenediaminetetraacetate | 0.05 g |

EXAMPLES 15

The image exposure, development processing and printing were conducted in the same manner as in Example 14 except that within 30 seconds after the image exposure, the lithographic printing plate precursor was put in an oven and heated the whole surface of the lithographic printing plate precursor by blowing hot air to maintain at 110°C for 15 seconds and after that the development processing was performed within 30 seconds.

The sensitivity was changed to 0,05 mJ/cm$^2$ by conducting the heat treatment and the safelight aptitude was good without the formation of fog.

EXAMPLES 16

Lithographic Printing Plate Precursor (1) was subjected to image exposure by a violet semiconductor laser plate setter Vx9600 (having InGaN semiconductor laser: 405 nm $\pm$ 10 nm; emission/output: 30 mW, produced by FUJIFTLM Electronic Imaging, Ltd.). As for the image, halftone dots of 35% were drawn using an FM screen (TAFFETA 20, produced by Fuji Photo Film Co., Ltd.) in a plate surface exposure amount of 0.09 mJ/cm$^2$ and at resolution of 2,438 dpi. The exposed lithographic printing plate precursor was subjected to development processing within 30 seconds using an automatic processor (LP1250PLX, produced by Fuji Photo Film Co., Ltd.). The automatic processor was composed of a heating unit, a water-washing unit, a developing unit, a rinsing unit and a finishing unit in this order. The heating condition in the heating unit was 100°C for 10 seconds. In all bathes of the water-washing unit, developing unit, rinsing unit and finishing unit, Developer (2) described above was charged. The temperature of the developer was 28°C and the transportation of the lithographic printing plate precursor was performed at a transporting speed of 110 cm/min.

After the development processing, the non-image area and image area of the resulting lithographic printing plate were visually observed. As a result, it was found that the residue of the photosensitive layer was not present in the non-image area and the uniform halftone dot image free from unevenness was formed. Further, the printing was conducted using the lithographic printing plate under the same conditions as described above. As a result, good printed materials of uniform halftone dot image free from unevenness and without stain in the non-image area were obtained.

## Claims

**1.** A method for preparing a lithographic printing plate comprising:

(i) exposing to laser light having a wavelength of 350-450 nm a lithographic printing plate precursor comprising

a hydrophilic support; a photosensitive layer containing (A) a sensitising dye having a maximum absorption wavelength of 350-450 nm, (B) a hexaarylbiimidazole compound, (C) a polymerizable compound, (D) a hydrophobic binder polymer and (E) a chain transfer agent; and a protective layer in this order; wherein the chain transfer agent (E) is a thiol compound represented by the following formula (I):

(I) 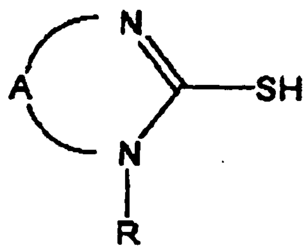

wherein R represents an alkyl group which may have a substituent or an aryl group which may have a substituent, and A represents a group for forming a 5- or 6-membered hetero-ring containing a carbon atom together with the N=C-N linkage, with the proviso that when A is -HC=CH-, R is not a methyl group; and
(ii) rubbing a surface of the exposed lithographic printing plate precursor with a rubbing member in an automatic processor in the presence of a developer having a pH of 2-10 to remove the protective layer and unexposed areas of the photosensitive layer.

2. A method according to Claim 1, wherein the hydrophobic binder polymer (D) is at least one of a (meth)acrylic copolymer having a crosslinkable group in a side-chain and a polyurethane resin having a crosslinkable group in a side-chain.

3. A method according to Claim 1, wherein at least part of the components of the photosensitive layer is encapsulated in a microcapsule.

4. A method according to Claim 1, wherein the rubbing member comprises at least two rotating brush rollers.

5. A method according to Claim 1, wherein the developer has a pH of 3-8.

6. A method according to Claim 1, further comprising a step of heating the exposed lithographic printing plate precursor before rubbing.

7. A method according to any preceding claim, wherein the chain transfer agent (E) is selected from the following compounds:

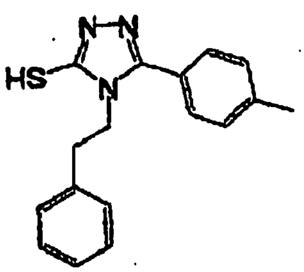

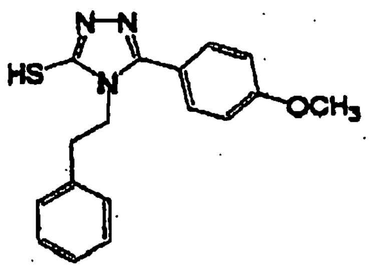

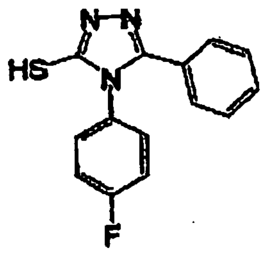

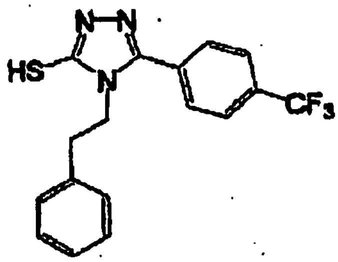

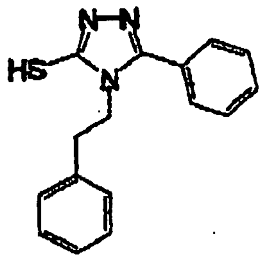

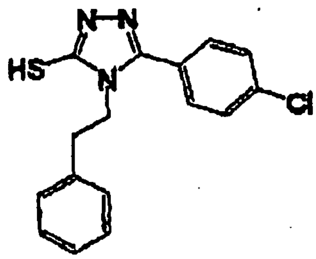

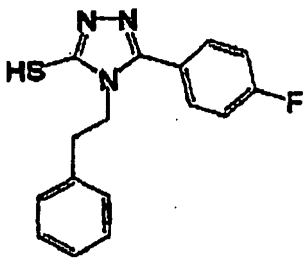

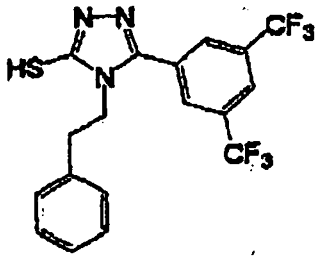

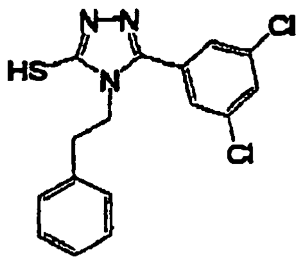

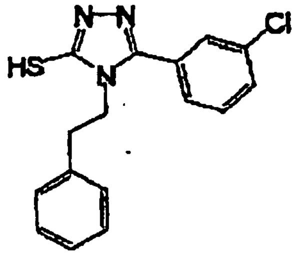

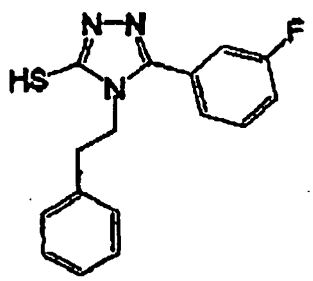

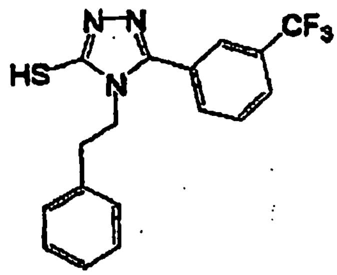

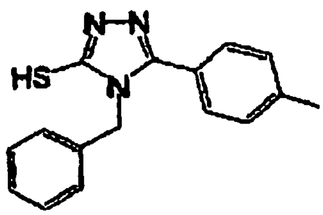

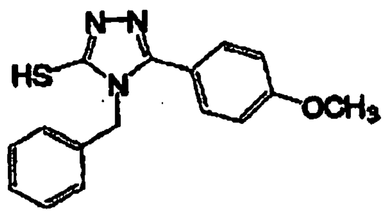

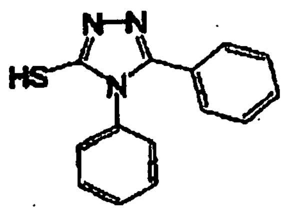

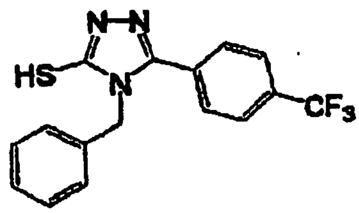

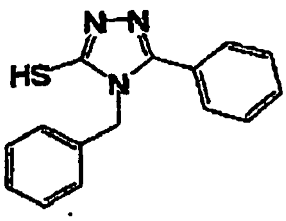

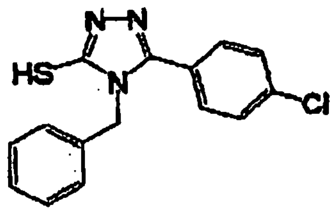

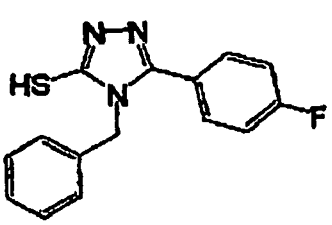

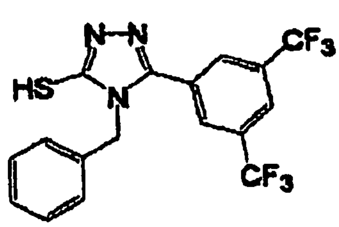

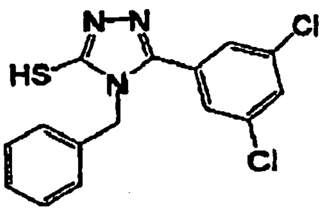
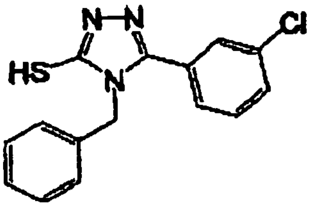

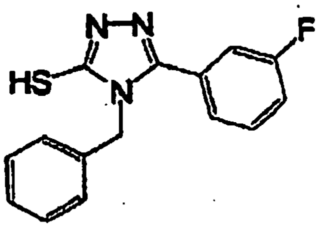
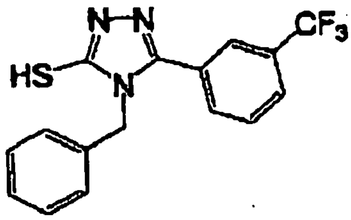

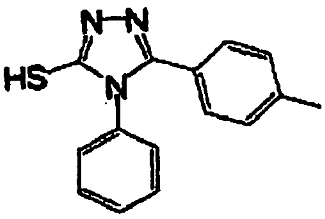
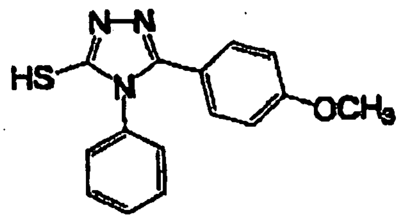

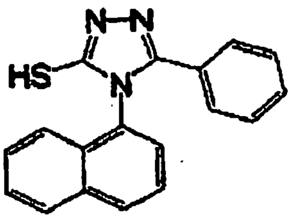
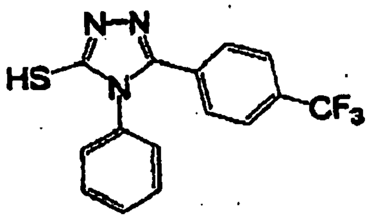

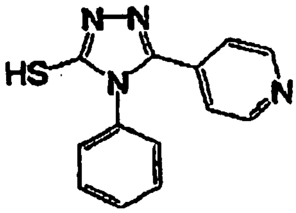
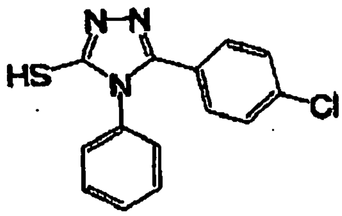

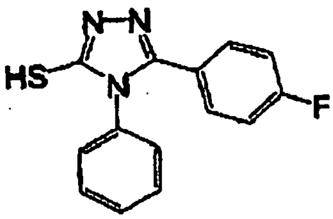

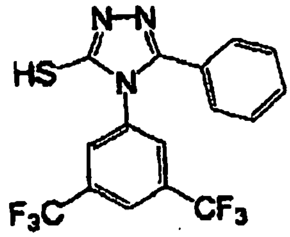

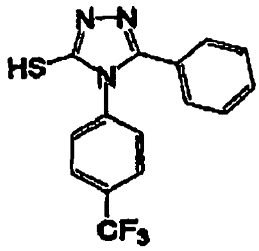

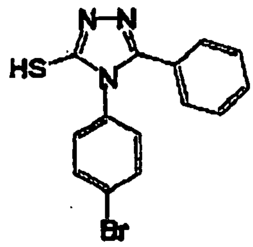

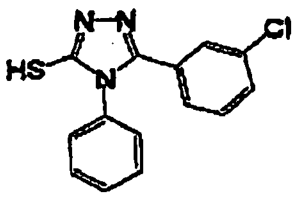

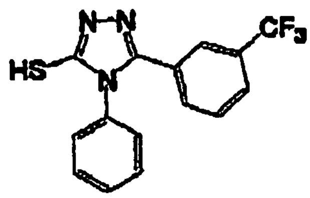

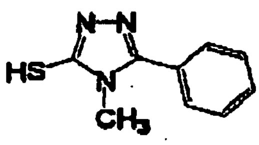

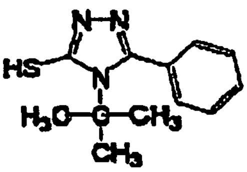

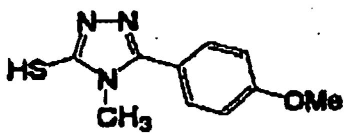

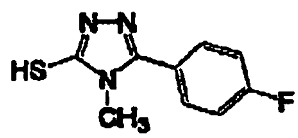

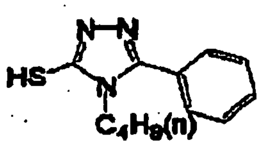 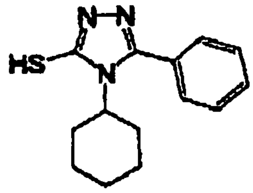

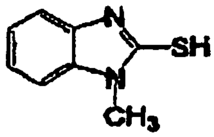 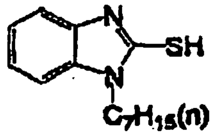

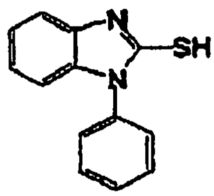 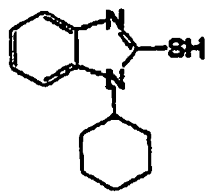

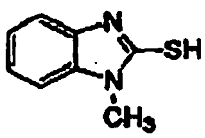 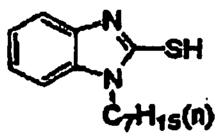

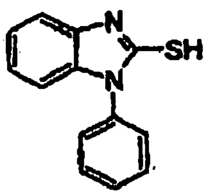 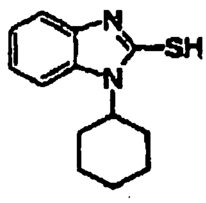

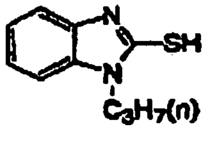 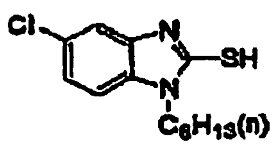

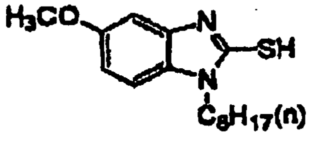 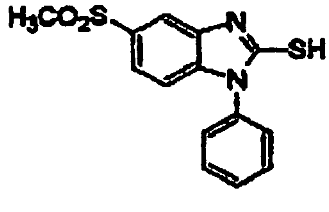

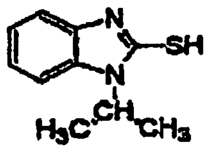

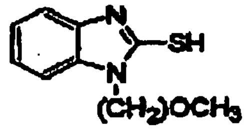

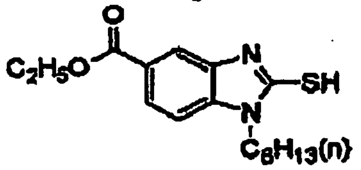

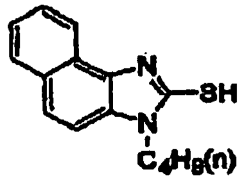

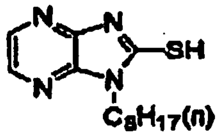

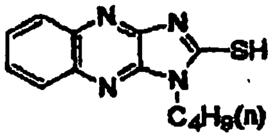

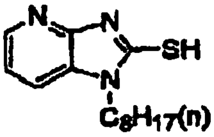

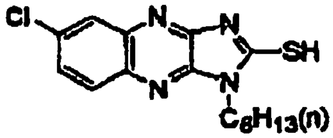

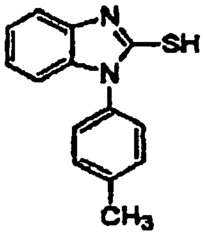

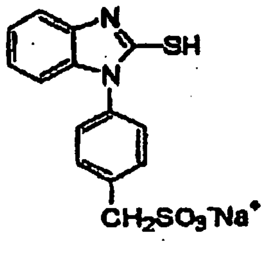

**8.** A lithographic printing plate precursor as defined in the method of Claim 1, wherein the hydrophobic binder polymer (D) has an acid value of 0.3 meq/g or less, and the protective layer and the unexposed area of the photosensitive layer are capable of being removed by exposing the lithographic printing plate precursor to laser light having a wavelength of 350-450 nm and rubbing the surface of the exposed lithographic printing plate precursor with a rubbing member in an automatic processor in the presence of a developer having a pH of 2-10.

## Patentansprüche

**1.** Verfahren zur Herstellung einer Lithografie-Druckplatte, umfassend:

(i) Belichten eines Lithografie-Druckplattenvorläufers mit Laserlicht einer Wellenlänge von 150 bis 450 nm, umfassend in dieser Reihenfolge einen hydrophilen Träger, eine fotoempfindliche Schicht, die (A) einen Sensibilisierungsfarbstoff mit einer Wellenlänge des Absorptionsmaximums von 350 bis 450 nm, (B) eine Hexaarylbiimidazolverbindung, (C) eine polymerisierbare Verbindung, (D) ein hydrophobes Bindemittelpolymer und (E) ein Kettentransfermittel umfasst; und eine Schutzschicht; worin das Kettentransfermittel (E) eine durch die folgende Formel (I) dargestellte Thiolverbindung ist;

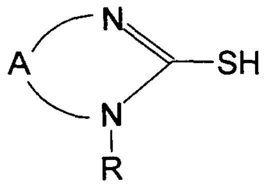 ( 1 )

worin R eine Alkylgruppe, die einen Substituenten aufweisen kann, oder eine Arylgruppe, die einen Substituenten aufweisen kann, darstellt und A eine Gruppe zur Bildung eines 5- oder 6-gliedrigen Heterorings, enthaltend ein Kohlenstoffatom, zusammen mit der N=C-N-Verknüpfung darstellt, vorausgesetzt, dass R keine Methylgruppe ist, wenn A -HC=CH- ist; und

(ii) Reiben einer Oberfläche des belichteten Lithografie-Druckplattenvorläufers mit einem Reibeelement in einer automatischen Verarbeitungsvorrichtung in Gegenwart eines Entwicklers, der einen pH-Wert von 2 bis 10 aufweist, um die Schutzschicht und unbelichtete Bereiche der fotoempfindlichen Schicht zu entfernen.

2. Verfahren gemäss Anspruch 1, worin das hydrophobe Bindemittelpolymer (D) zumindest eines von einem (Meth) acryl-Copolymer, das eine vernetzbare Gruppe in der Seitenkette aufweist, und einem Polyurethanharz, das eine vernetzbare Gruppe in einer Seitenkette aufweist, ist.

3. Verfahren gemäss Anspruch 1, worin zumindest ein Teil der Komponenten der fotoempfindlichen Schicht in einer Mikrokapsel eingekapselt ist.

4. Verfahren gemäss Anspruch 1, worin das Reibeelement zumindest zwei rotierende Bürstenwalzen umfasst.

5. Verfahren gemäss Anspruch 1, worin der Entwickler einen pH-Wert von 3 bis 8 aufweist.

6. Verfahren gemäss Anspruch 1, ferner umfassend einen Schritt zum Erwärmen des belichteten Lithografie-Druckplattenvorläufers vor dem Reiben.

7. Verfahren gemäss irgendeinem vorhergehenden Anspruch, worin das Kettentransfermittel (E) aus den folgenden Verbindungen ausgewählt ist:

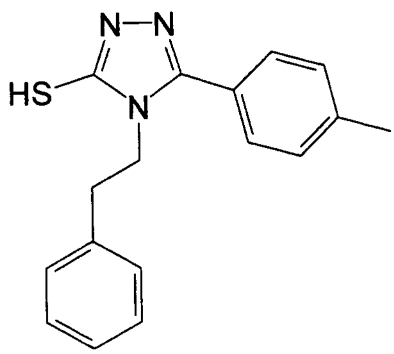

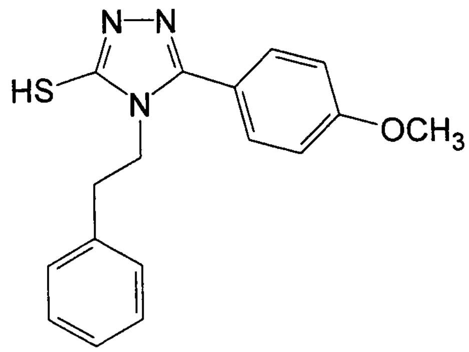

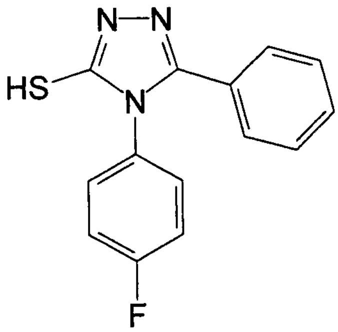

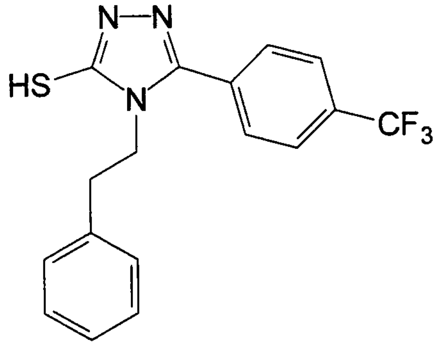

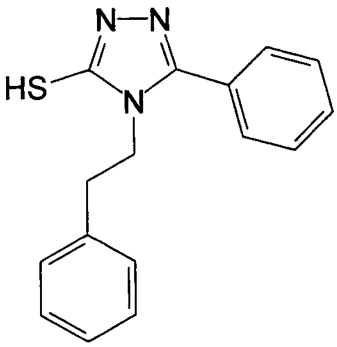

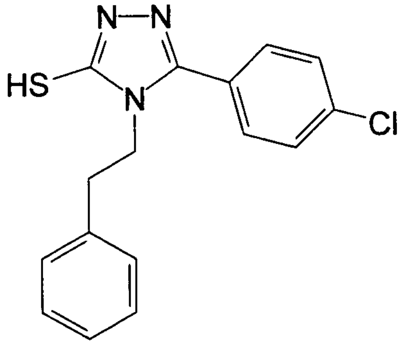

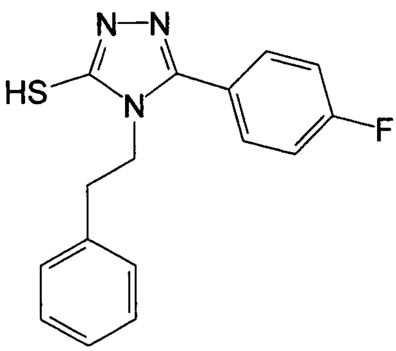

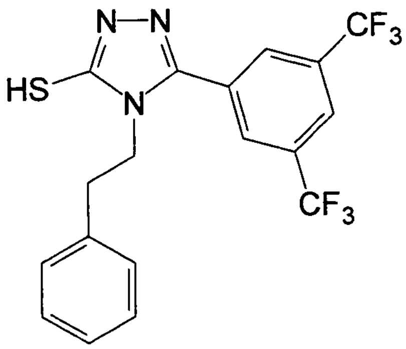

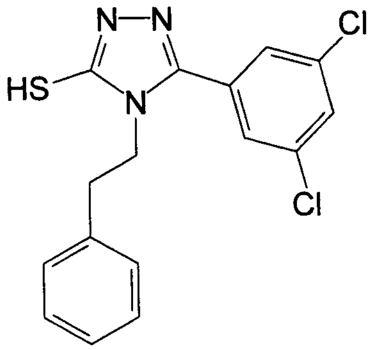

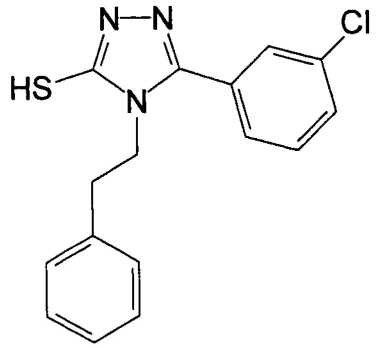

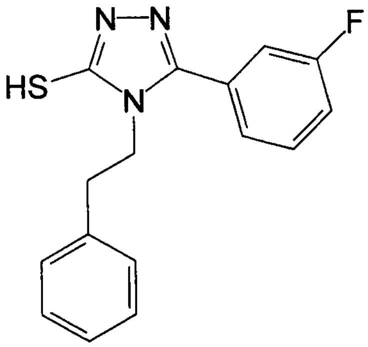

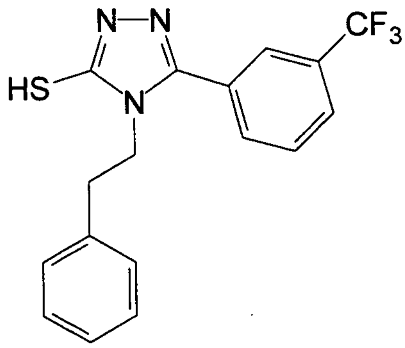

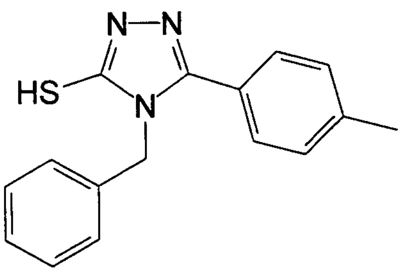

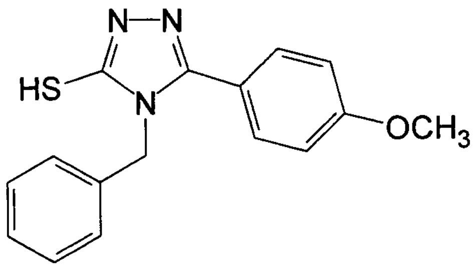

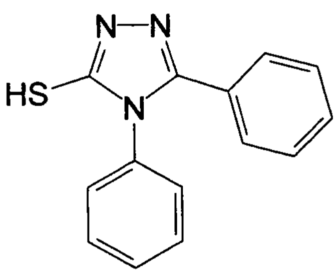

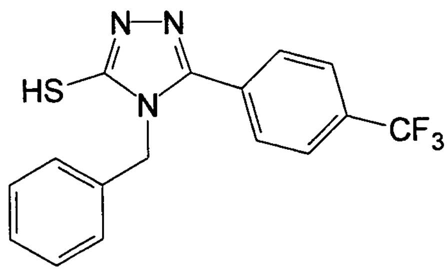

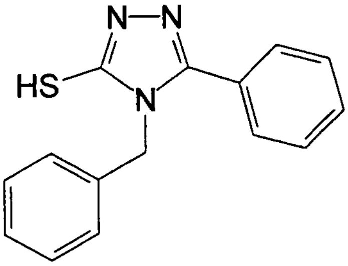
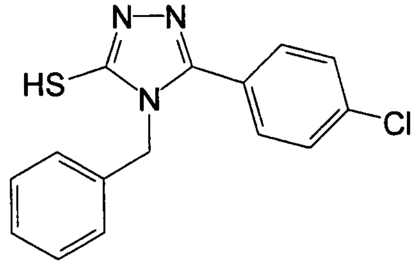
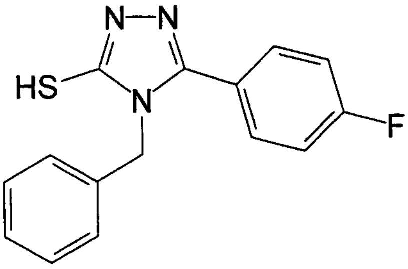
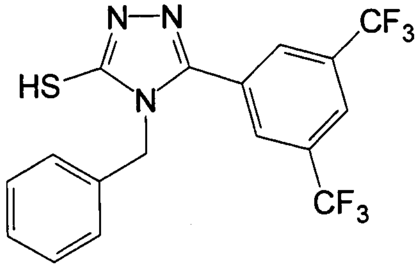
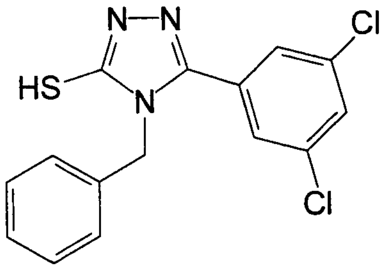
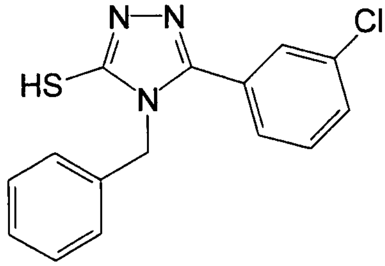
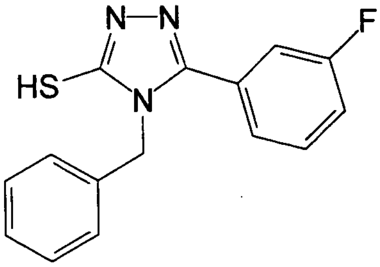
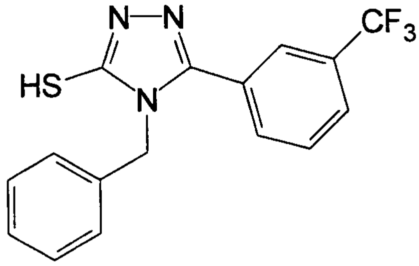

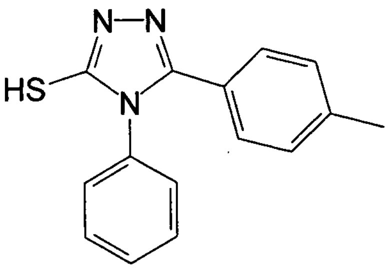

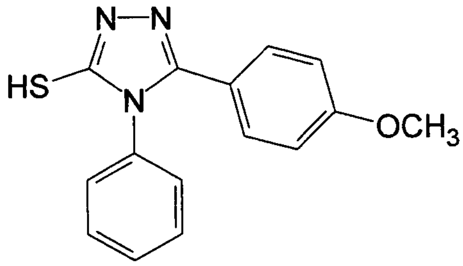

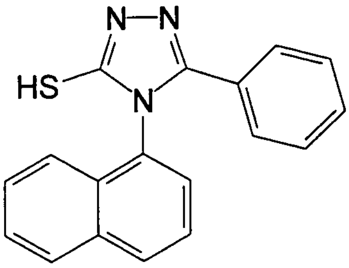

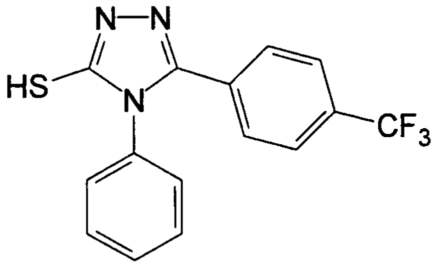

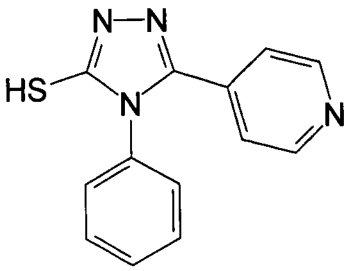

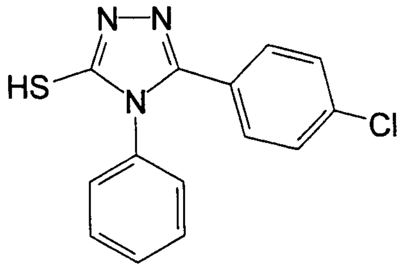

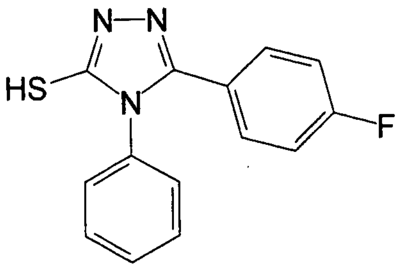

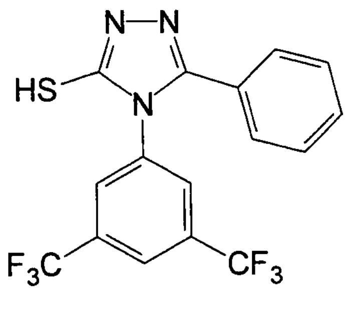

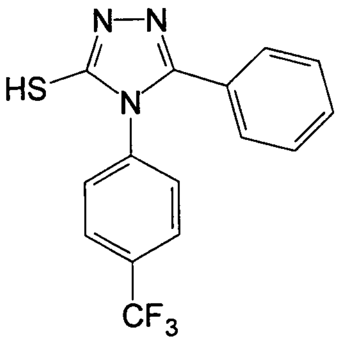

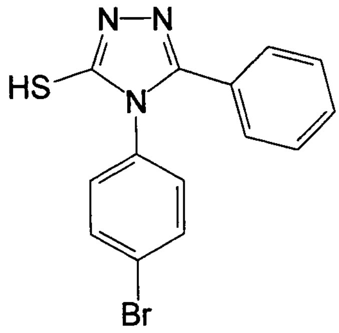

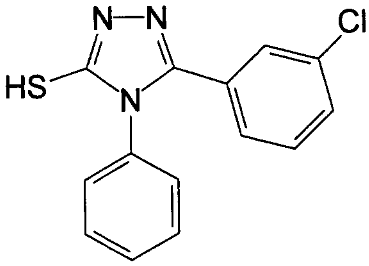

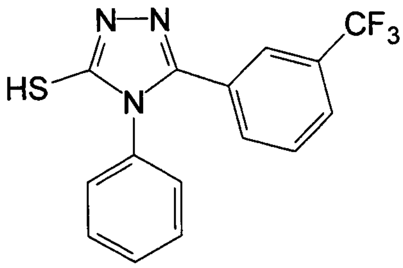

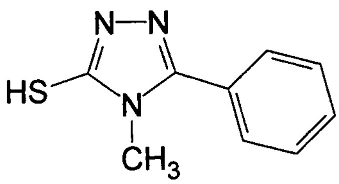

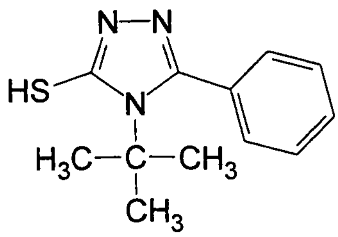

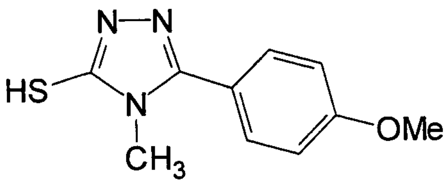

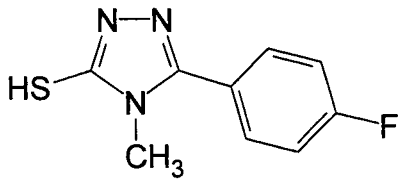

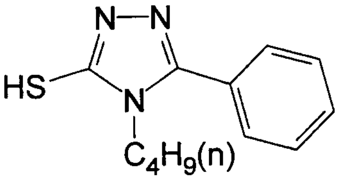

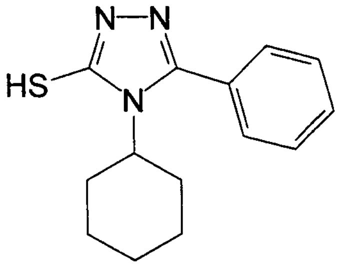

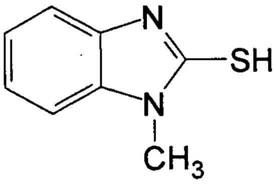

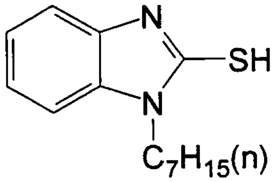

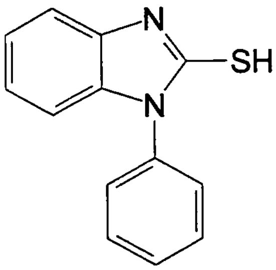

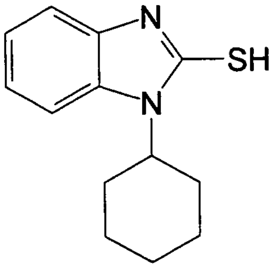

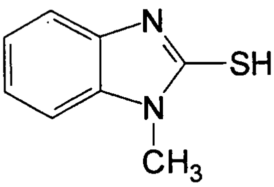

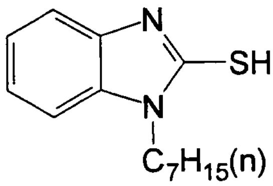

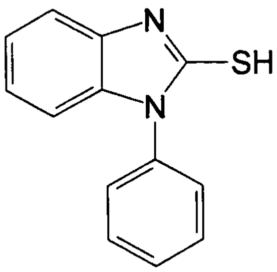

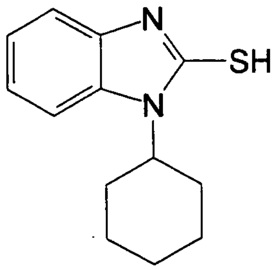

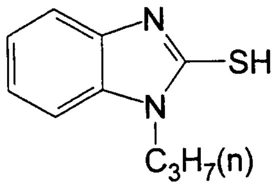

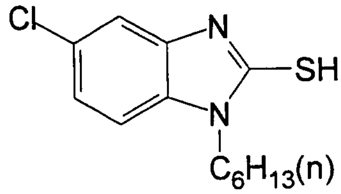

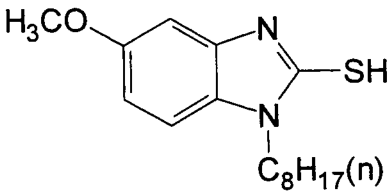

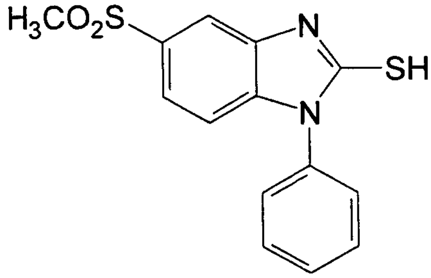

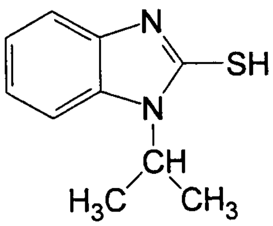

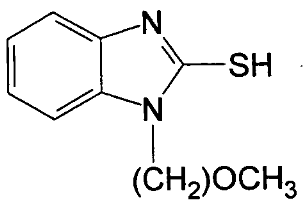

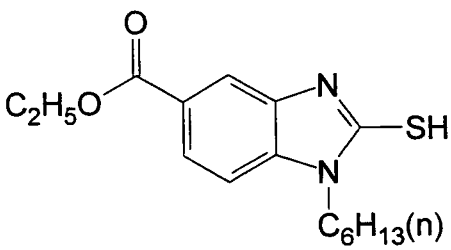

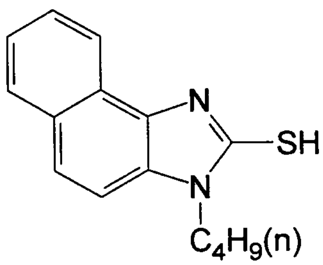

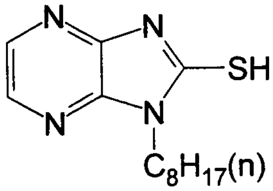

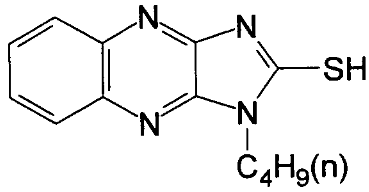

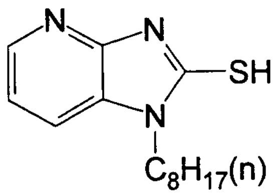

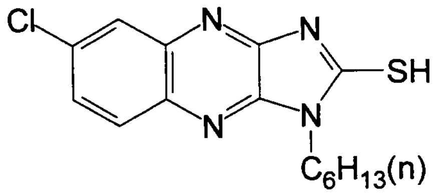

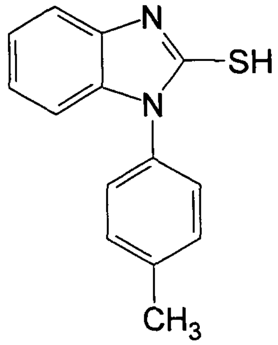

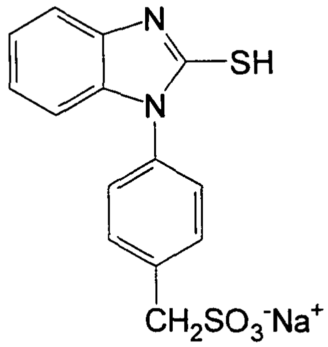

8. Lithografie-Druckplattenvorläufer, wie im Verfahren von Anspruch 1 definiert, worin das hydrophobe Bindemittelpolymer (D) einen Säurewert von 0,3 mäq/g oder kleiner aufweist und die Schutzschicht und der unbelichtete Bereich der fotoempfindlichen Schicht durch Belichten des Lithografie-Druckplattenvorläufers mit Laserlicht einer Wellenlänge von 350 bis 450 nm und Reiben der Oberfläche des belichteten Lithografie-Druckplattenvorläufers mit einem Reibeelement in einer automatischen Verarbeitungsvorrichtung in Gegenwart eines Entwicklers mit einem pH-Wert von 2 bis 10 entfernt werden können.

## Revendications

1. Procédé de préparation d'une plaque d'impression lithographique comprenant:

   (i) exposer à une lumière laser ayant une longueur d'onde de 350 à 450 nm un précurseur de plaque d'impression lithographique comprenant un support hydrophile ; une couche photosensible contenant (A) un colorant de sensibilisation ayant une longueur d'onde d'absorption maximale de 350 à 450 nm, (B) un composé hexaarylbiimidazole, (C) un composé polymérisable, (D) un polymère liant hydrophobe et (E) un agent de transfert de chaîne ; et une couche protectrice, dans cet ordre ; dans lequel l'agent de transfert de chaîne (E) est un composé thiol représenté par la formule (I) suivante :

   (I) 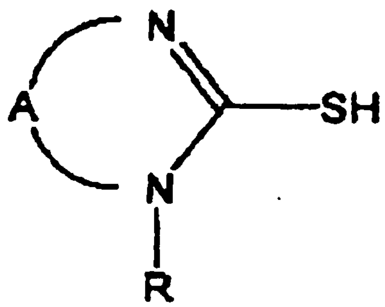

   dans laquelle R représente un groupe alkyle qui peut avoir un substituant ou bien un groupe aryle qui peut avoir

un substituant, et A représente un groupe destiné à former un hétérocycle de 5 ou 6 membres contenant un atome de carbone ensemble avec le chaînon N=C-N, à la condition que lorsque A soit -HC=CH-, R ne soit pas un groupe méthyle ; et

(ii) frotter une surface du précurseur de plaque d'impression lithographique exposé avec un élément de frottage dans un dispositif automatique en présence d'un agent de développement ayant un pH entre 2 et 10 pour éliminer la couche protectrice et les zones non exposées de la couche photosensible.

**2.** Procédé selon la revendication 1, dans lequel le polymère liant hydrophobe (D) est au moins l'un parmi un copolymère (méth)acrylique ayant un groupe réticulable dans une chaîne latérale et une résine de polyuréthane ayant un groupe réticulable dans une chaîne latérale.

**3.** Procédé selon la revendication 1, dans lequel au moins une partie des composants de la couche photosensible est encapsulée dans une microcapsule.

**4.** Procédé selon la revendication 1, dans lequel l'élément de frottage comprend au moins deux brosses rotatives en rouleau.

**5.** Procédé selon la revendication 1, dans lequel l'agent de développement a un pH entre 3 et 8.

**6.** Procédé selon la revendication 1, comprenant en outre une étape de chauffage du précurseur de plaque d'impression lithographique exposé avant le frottement.

**7.** Procédé selon l'une quelconque des revendications précédentes, dans lequel l'agent de transfert de chaîne (E) est choisi parmi les composés suivants :

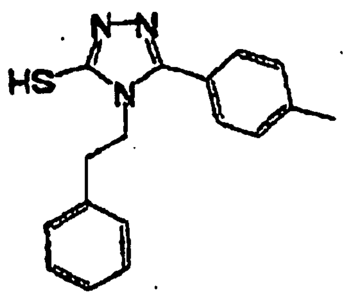

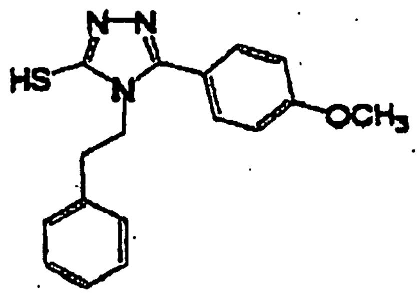

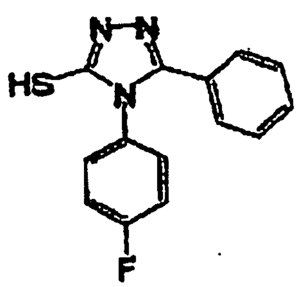

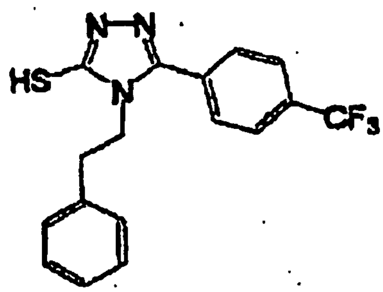

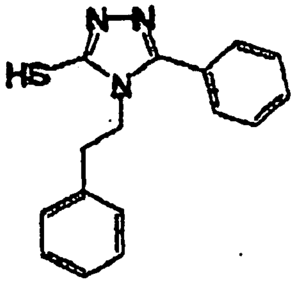

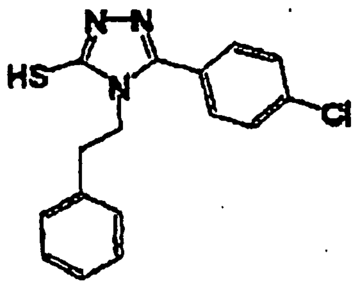

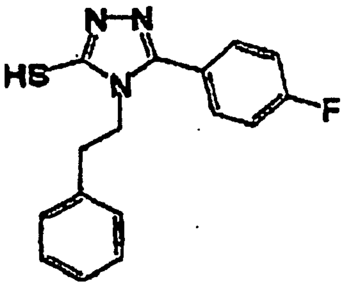

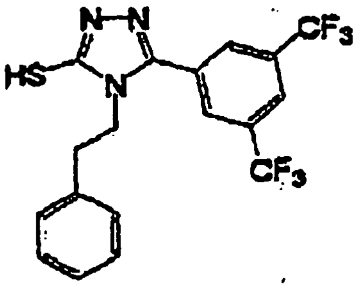

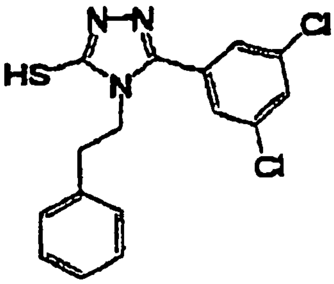

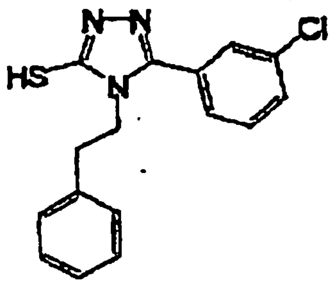

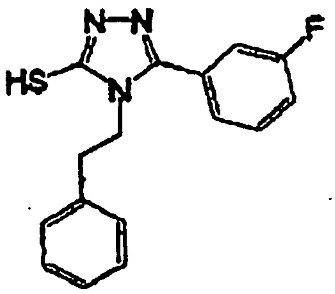

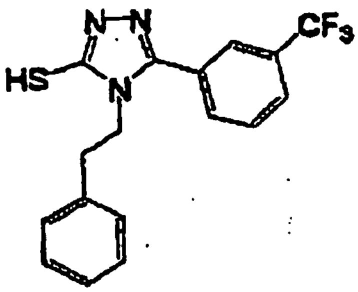

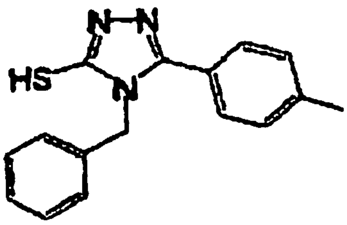
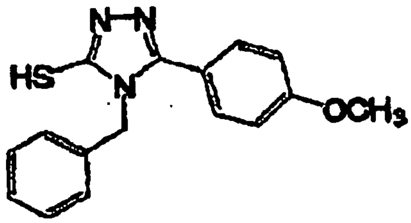
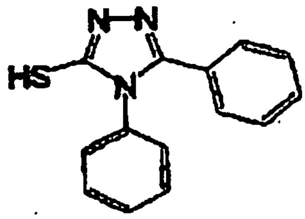
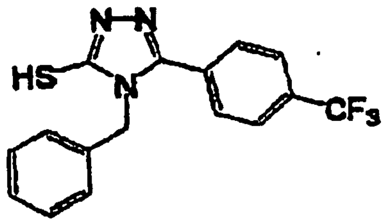
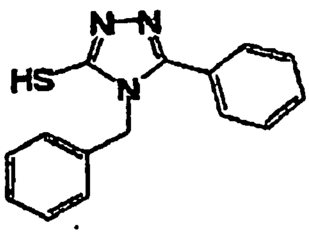
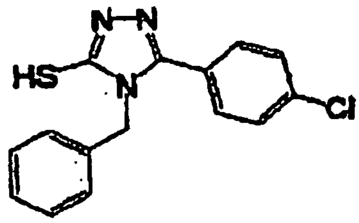
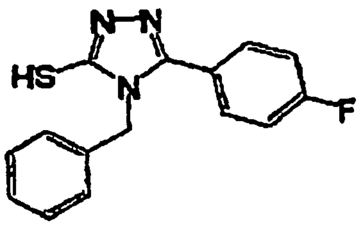
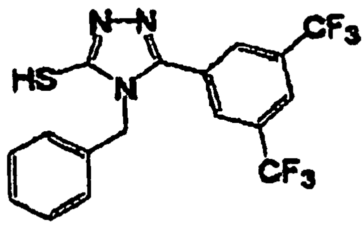
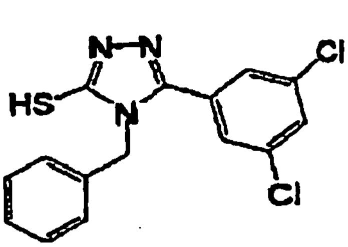
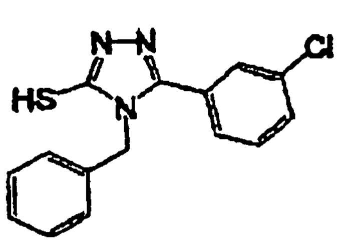

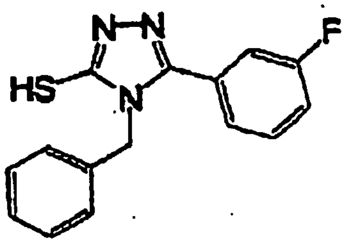

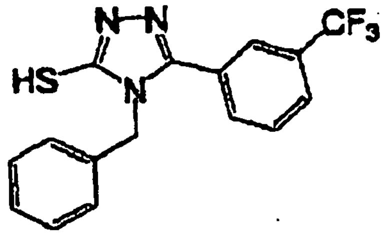

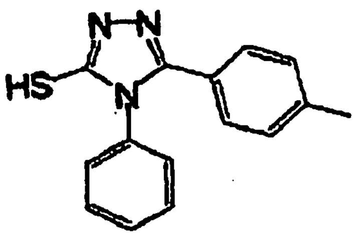

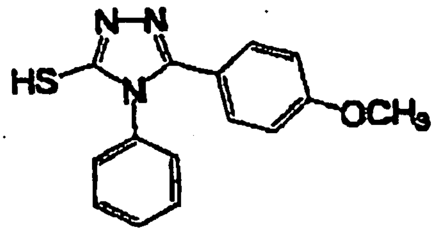

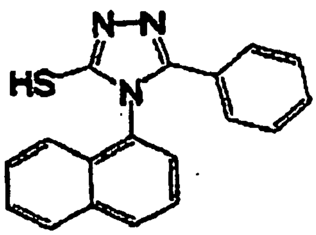

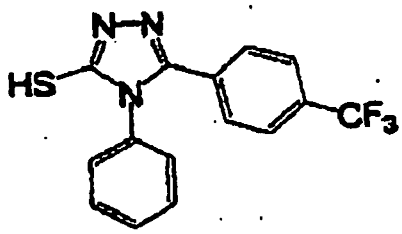

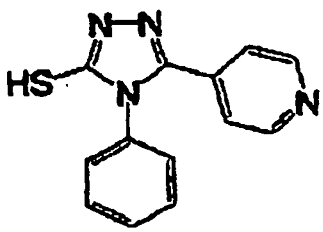

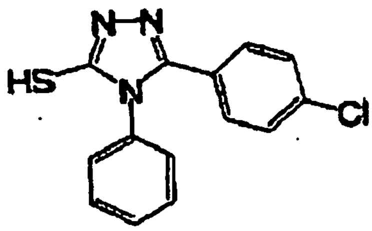

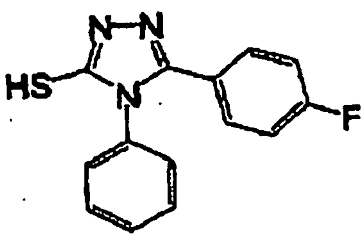

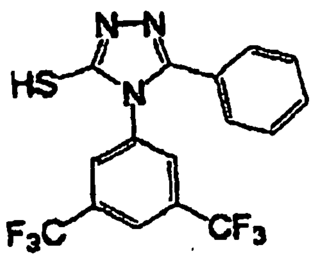

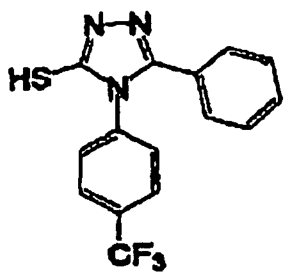
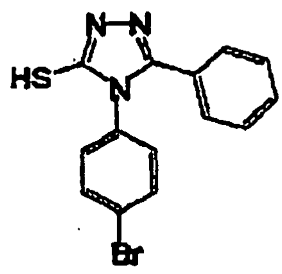
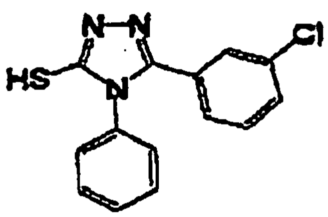
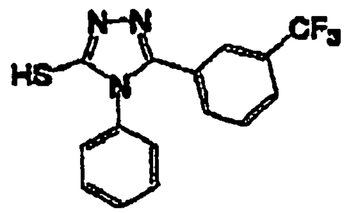
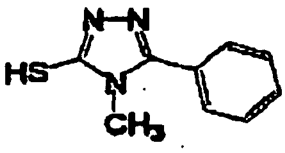
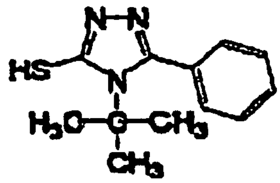
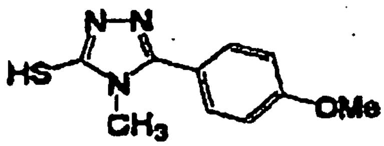
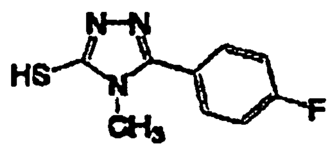
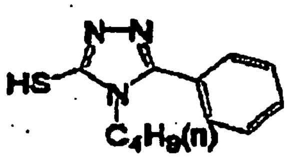
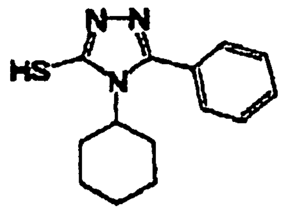
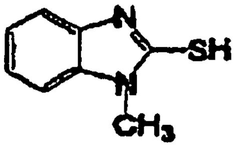
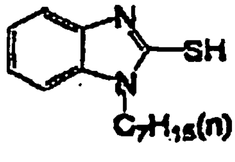

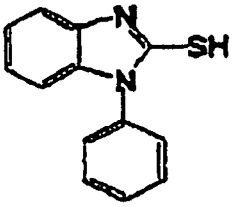
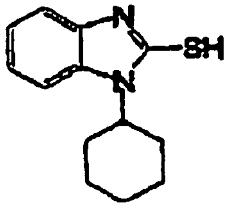
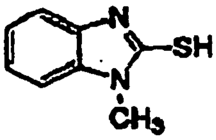
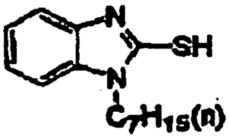
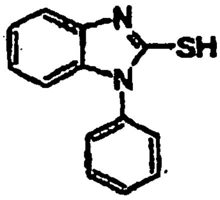
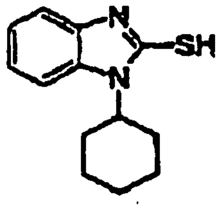
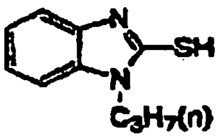
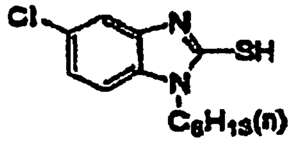
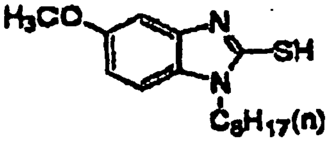
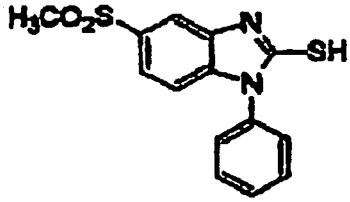
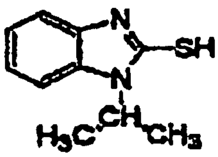
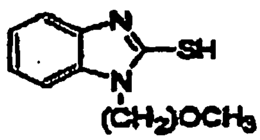
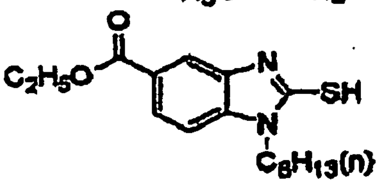
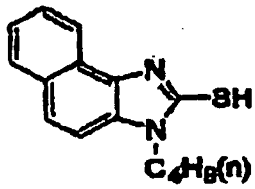

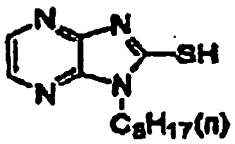

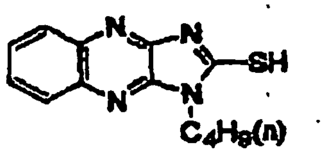

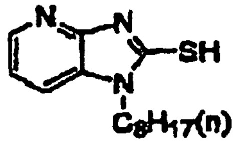

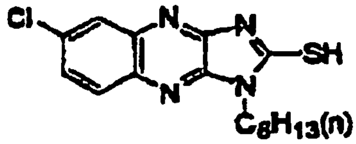

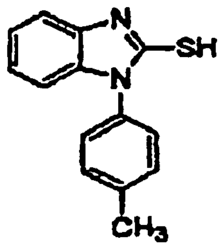

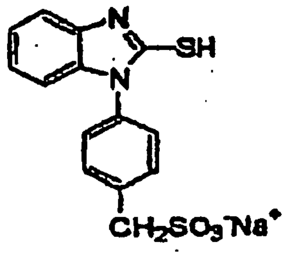

**8.** Précurseur de plaque d'impression lithographique tel que défini dans le procédé de la revendication 1, dans lequel le polymère liant hydrophobe (D) a un indice d'acide de 0,3 meq/g ou moins, et la couche protectrice et la zone non exposée de la couche photosensible sont capables d'être éliminées en exposant le précurseur de plaque d'impression lithographique à une lumière laser ayant une longueur d'onde de 350 à 450 nm et par frottement de la surface du précurseur de plaque d'impression lithographique exposé avec un élément de frottage dans un dispositif automatique en présence d'un agent de développement ayant un pH entre 2 et 10.

Fig.1

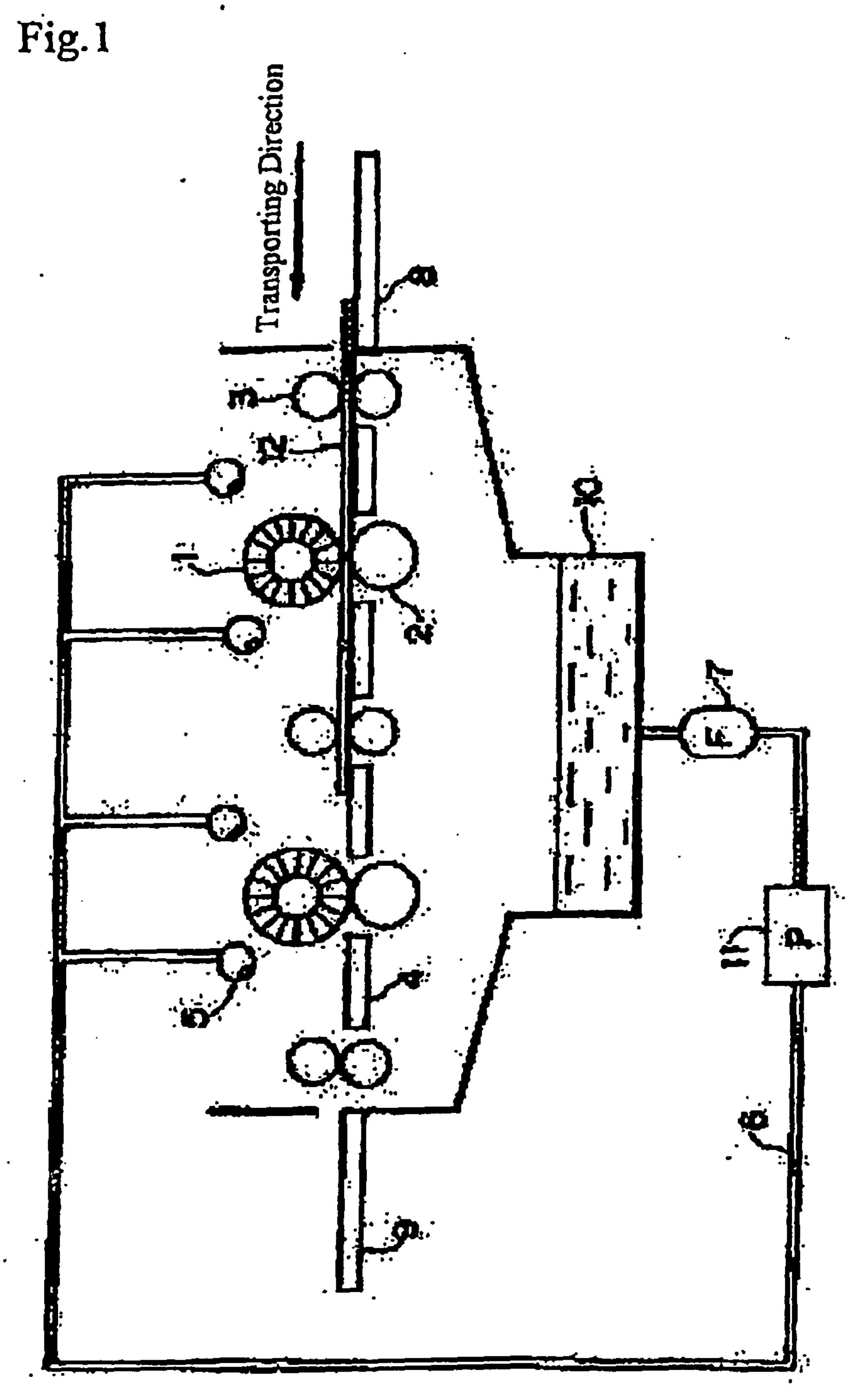

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002365789 A
- US 20040013968 A
- EP 1630618 A
- JP 3296759 A
- JP 59028329 B
- JP 4537377 B
- JP 4486516 B
- JP 58029803 A
- JP 59152396 A
- JP 61151197 A
- JP 51047334 B
- JP 57196231 A
- JP 59005240 A
- JP 59005241 A
- JP 2226149 A
- JP 1165613 A
- JP 54021726 B
- JP 48041708 B
- JP 51037193 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 48064183 A
- JP 49043191 B
- JP 52030490 B
- JP 46043946 B
- JP 1040337 B
- JP 1040336 B
- JP 2025493 A
- JP 61022048 A
- JP 2001277740 A
- JP 2001277742 A
- US 2800457 A
- US 2800458 A
- US 3287154 A
- JP 3819574 B
- JP 42446 B
- US 3418250 A
- US 3660304 A
- US 3796669 A
- US 3914511 A
- US 4025445 A
- JP 369163 B
- JP 51009079 B
- GB 930422 A
- US 3111407 A
- GB 952807 A
- GB 967074 A
- JP 62170950 A
- JP 62226143 A
- JP 60168144 A
- JP 62293247 A
- US 3458311 A
- JP 55049729 B
- US 292501 A
- US 44563 A
- JP 54063902 A
- JP 2001253181 A
- JP 2001322365 A
- US 2714066 A
- US 3181461 A
- US 3280734 A
- US 3902734 A
- JP 3622063 B
- US 3276868 A
- US 4153461 A
- US 4689272 A
- JP 2001199175 A
- JP 2002079772 A
- JP 10282679 A
- JP 2304441 A
- JP 5045885 A
- JP 6034174 A
- JP 2220061 A
- JP 60059351 A
- US 5148746 A
- US 5568768 A
- GB 2297719 A
- JP 58159533 A
- JP 3100554 A


### Non-patent literature cited in the description


- **L.G. BROOKER et al.** *J. Am. Chem. Soc.,* 1951, vol. 73, 5326-5358
- *Nippon Secchaku Kyokaishi,* 1984, vol. 20 (7), 300-308